# EUROPEAN PATENT SPECIFICATION

(11) **EP 1 736 826 B1**
(45) Date of publication and mention of the grant of the patent: **26.03.2008**
(21) Application number: 06009640.1
(22) Date of filing: 10.05.2006
(51) Int. Cl.: G03F 7/033, G03F 7/004, B41C 1/10

(54) **Photosensitive lithographic printing plate**
Lichtempfindliche Lithografiedruckform
Plaque d'impression lithographique photosensible

(30) Priority: 11.05.2005 JP 2005138630; 10.06.2005 JP 2005171056
(43) Date of publication of application: 27.12.2006
(73) Proprietor: FUJIFILM Corporation, Minato-ku Tokyo (JP)
(72) Inventor: Mori, Takanori Fuji Photo Film Co., Ltd., Haibara-gun Shizuoka (JP)
(74) Representative: HOFFMANN EITLE

(56) References cited:
- EP-A- 1 235 106
- US-A1- 2002 055 058

## Description

### Background of the Invention

### 1. Field of the Invention

The present invention relates to a photosensitive lithographic printing plate (lithographic printing plate precursor), more specifically, the present invention relates to a negative photosensitive lithographic printing plate capable of providing a lithographic printing plate assured of excellent inking property and reduced generation of development scum in the developing bath.

### 2. Description of the Related Art

A lithographic printing plate precursor has a structure such that a recording layer comprising an image-forming composition is provided on a support substrate. In a typical production process therefor, an image-forming composition dispersed or dissolved in an organic solvent and, if desired, an upper layer such as protective layer are coated and dried on the surface of a support which is subjected to appropriate surface treatment, undercoating, back coating and the like. Also, in a typical plate-making process, the image-forming composition on the support is caused to undergo imagewise change in its physical properties by the surface exposure of a contact or projection system through an image mask, or by the direct exposure using scanning or modulation of an electromagnetic wave based on image information from a computer. Thereafter, the image-forming composition in the non-image area is removed (developed) and, if desired, a treatment for hydrophilicity, ink-receptivity, formation of a protective film, or the like is performed, thereby obtaining a lithographic printing plate having a non-image area comprising a hydrophilic support surface layer and an image area comprising a hydrophobic composition surface layer. In a typical printing process using the thus-obtained lithographic printing plate, the hydrophilic non-image area and the lipophilic image area receive a fountain solution and an ink, respectively, and an ink image is thereby formed on the surface. The obtained ink image is directly or indirectly transferred to a desired printing medium, whereby a printed matter is obtained.

In the lithographic printing field, a computer-to-plate (CTP) technique of producing a printing plate by directly laser-exposing a lithographic printing plate precursor based on digital data of a computer or the like without intervention of a lith film has been recently developed, and a lithographic printing plate capable of responding to a high-sensitivity laser by using a radical chain polymerization reaction has been created. In the case of using such a recording layer, satisfactory lipophilicity needs to be imparted to the recording layer surface so as to form a good ink image on the surface. Accordingly, enhancement of the inking property at the start of printing is important, because this leads to great increase of the working efficiency at the printing. However, when the surface is rendered lipophilic so as to enhance the inking property, the permeability of developer into the photosensitive layer deteriorates and the developability usually decreases. In order to avoid this problem, a material with good balance between hydrophilicity and lipophilicity is preferably used for imparting developability and inking property, but a material assured of a performance sufficiently satisfying both the hydrophilicity and the lipophilicity is not yet obtained at present.

As for the method of ensuring lipophilicity of the recording layer, for example, a method using a polymer having a phenolic hydroxyl group and a linear, branched or cyclic alkyl group having a carbon number of 4 to 20, such as stearyl group, has been proposed (see, for example, JP-A-2004-117882 (the term "JP-A" as used herein means an "unexamined published Japanese patent application")). However, in the case of using such a lipophilic polymer as the main component of the binder, since the amount of the polymer added is large, a great effect is brought about on other performances such as developability and the manner of use is difficult. On other hand, in the case of using such a lipophilic polymer as an additive in a small amount, the obtained effect of enhancing the inking property is not as high as expected.

Other than this, addition of a fluorine-containing surfactant having a fluoro aliphatic group has been proposed as the method of ensuring lipophilicity of the recording layer (see, for example, JP-A-2002-311577 and JP-A-2004-101893). However, the compound having a functional group containing many fluorine atoms further has properties such as oil repellency, water repellency and alkali development resistance, and if such a compound is blended in a large amount, not only the inking property decreases but also generation of development scum or sludge in the development bath or reduction of developability may occur.

### Summary of the Invention

An object of the present invention is to provide a photosensitive lithographic printing plate ensuring that the inking property of the image area is excellent, a good printed matter is obtained and even when the plate-making process is continuously performed, precipitate (sludge) generation in the developer is suppressed.

As a result of intensive investigations, the present inventors have found that when a polymer compound having a specific copolymerization component is incorporated as an additive (surfactant) into the polymerizable photosensitive layer (hereafter, also referred to simply as photosensitive layer or recording layer), the above-described problems can be overcome. The present invention has been accomplished based on this finding.

That is, the present invention is as follows.
(1) A photosensitive lithographic printing plate comprising:
   a support; and
   a polymerizable photosensitive layer that comprises:
      an addition-polymerizable compound having an ethylenically unsaturated double bond;
      a polymerization initiator; and
      a polymer compound having (a) a monomer represented by formula (I) and (b) a monomer represented by formula (II) as copolymerization components: 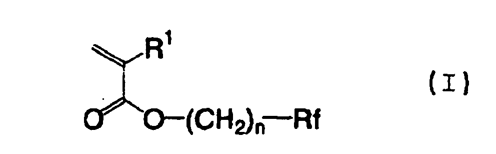
      wherein Rf represents a substituent containing a fluoroalkyl or perfluoroalkyl group having 9 or more fluorine atoms;
   n represents 1 or 2; and
   R¹ represents a hydrogen atom or a methyl group; 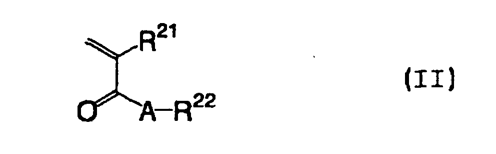 wherein R²¹ represents a hydrogen atom or a methyl group;
   R²² represents a divalent hydrocarbon group having a carbon number of 3 to 30 and having an aliphatic cyclic structure;
   A represents an oxygen atom or -NR²³-; and
   R²³ represents a hydrogen atom or a monovalent hydrocarbon group having a carbon number of 1 to 10.
(2) The photosensitive lithographic printing plate as described in (1) above,
   wherein the polymerizable photosensitive layer further comprises a sensitizing dye having an absorption maximum wavelength in a range of from 330 to 430 nm.
(3) The photosensitive lithographic printing plate as described in (2) above,
   wherein the sensitizing dye is a compound represented by formula (4): 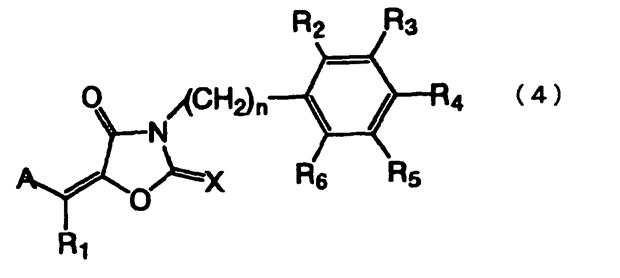 wherein A represents an aromatic or heterocyclic ring which may have a substituent;
   X represents an oxygen atom, a sulfur atom or NR₇;
   R₁, R₂, R₃, R₄, R₅, R₆ and R₇ each independently represents a hydrogen atom or a monovalent nonmetallic atom group, provided that at least one of R₂, R₃, R₄, R₅ and R₆ represents a substituent represented by -OR₈, wherein each R₈ independently represents a monovalent nonmetallic atom group; and
   n represents an integer of 1 to 6.
(4) The photosensitive lithographic printing plate as described in (3) above,
   wherein the compound represented by formula (4) is a compound represented by formula (5): 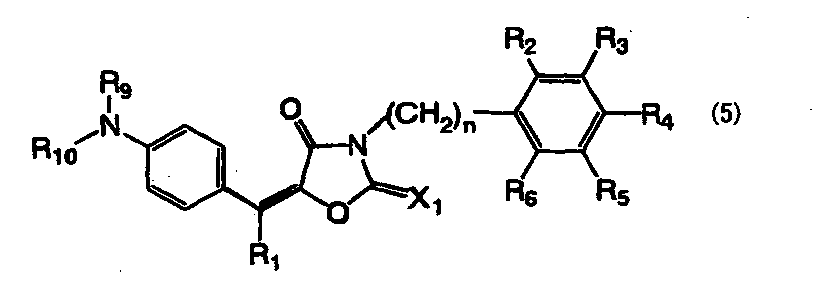 wherein X₁ represents an oxygen atom or a sulfur atom;
   R₁, R₂, R₃, R₄, R₅ and R₆ each independently represents a hydrogen atom or a monovalent nonmetallic atom group;
   R₉ and R₁₀ each independently represents a monovalent nonmetallic atom group, provided that at least one of R₂, R₃, R₄, R₅ and R₆ represents a substituent represented by -OR₈, wherein each R₈ independently represents a monovalent nonmetallic atom group; and
   n represents an integer of 1 to 6.
(5) The photosensitive lithographic printing plate as described in (1) above,
   wherein the polymerizable photosensitive layer further comprises an infrared absorbent having an absorption maximum wavelength in a range of from 750 to 1,400 nm.
(6) The photosensitive lithographic printing plate as described in (5) above,
   wherein the infrared absorbent is a cyanine dye represented by formula (i): Formula (i): 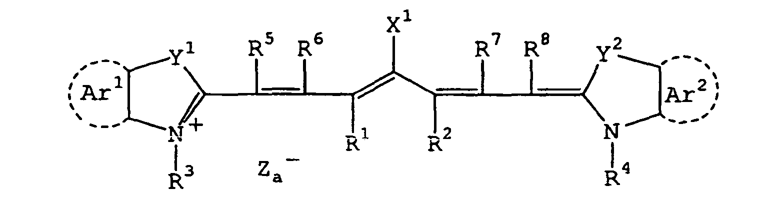 wherein X¹ represents a hydrogen atom, a halogen atom, -NPh₂, X²-L¹ or a group shown below, wherein X² represents an oxygen atom, a nitrogen atom or a sulfur atom, L¹ represents a hydrocarbon group having from 1 to 12 carbon atoms, an aromatic ring having a heteroatom, or a hydrocarbon group having from 1 to 12 carbon atoms and containing a heteroatom; 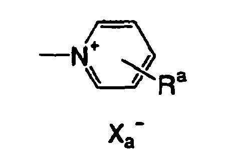
   Xₐ⁻ has the same definition as Zₐ⁻ described below;
   R^{a} represents a substituent selected from a hydrogen atom, an alkyl group, an aryl group, a substituted or unsubstituted amino group and a halogen atom;
   R¹ and R² each independently represents a hydrocarbon group having from 1 to 12 carbon atoms;
   Ar¹ and Ar² each independently represents an aromatic hydrocarbon group which may have a substituent;
   Y¹ and Y² each independently represents a sulfur atom or a dialkylmethylene group having 12 or less carbon atoms;
   R³ and R⁴ each independently represents a hydrocarbon group having 20 or less carbon atoms, which may have a substituent;
   R⁵, R⁶, R⁷ and R⁸ each independently represents a hydrogen atom or a hydrocarbon group having 12 or less carbon atoms; and
   Zₐ⁻ represents a counter anion but when a cyanine dye represented by formula (i) has an anionic substituent in its structure and a neutralization of electric charge is not necessary, Zₐ⁻ is not present.
(7) The photosensitive lithographic printing plate as described in any of (1) to (6) above,
   wherein Rf in formula (I) represents a substituent containing a fluoroalkyl or perfluoroalkyl group having 13 to 25 fluorine atoms.
(8) The photosensitive lithographic printing plate as described in any of (1) to (7) above,
   wherein the polymerizable photosensitive layer further comprises a binder polymer having a crosslinking group represented by any one of formulae (1) to (3): 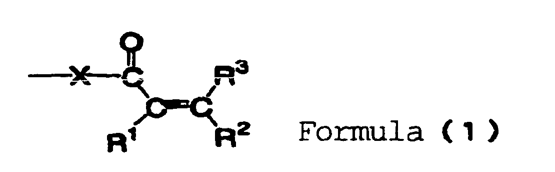 wherein in formula (1), R¹ to R³ each independently represents a hydrogen atom or a monovalent organic group;
   X represents an oxygen atom, a sulfur atom or -N(R¹²)-; and
   R¹² represents a hydrogen atom or a monovalent organic group; 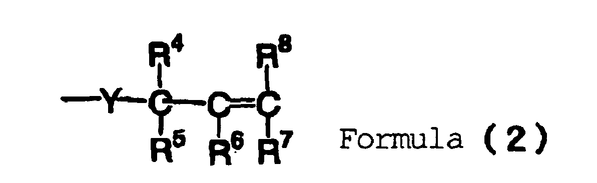 wherein in formula (2), R⁴ to R⁸ each independently represents a monovalent organic group;
   Y represents an oxygen atom, a sulfur atom or N(R¹²)-; and
   R¹² has the same meaning as R¹² in formula (1); 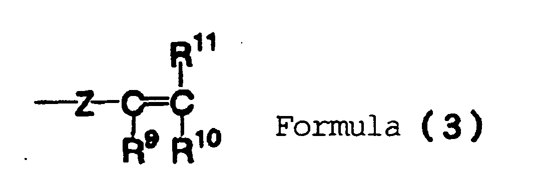 wherein in formula (3), R⁹ represents a hydrogen atom or an alkyl group which may have a substituent;
   R¹⁰ and R¹¹ each independently represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent;
   Z represents an oxygen atom, a sulfur atom, -N(R¹³)- or a phenylene group which may have a substituent; and
   R¹³ represents an alkyl group which may have a substituent.
(9) The photosensitive lithographic printing plate as described in any of (1) to (8) above,
   wherein Rf in formula (I) represents one of following fluoroalkyl (meth)acrylates:

   CH₂=CRCO₂(CH₂)ₘCₙF2ₙ₊₁

   wherein m represents 1 or 2, n represents an integer of 4 to 12, and R represents an alkyl group having a carbon number of I to 4; and

   CH₂=CRCO₂(CH₂)ₘ(CF₂)ₙH

   wherein m represents 1 or 2, n represents an integer of 4 to 12, and R represents an alkyl group having a carbon number of 1 to 4.
(10) The photosensitive lithographic printing plate as described in any of (2) to (4) and (7) to (9) above,
   wherein the polymerization initiator is a hexaarylbiimidazole.
(11) The photosensitive lithographic printing plate as described in any of (5) to (9) above,
wherein the polymerization initiator is an onium salt.

The operation mechanism of the present invention is not elucidated but is presumed as follows.

The polymer compound contained as a surfactant in the photosensitive layer of the photosensitive lithographic printing plate of the present invention comprises (b) a copolymerization component represented by formula (II) having an aliphatic cyclic structure in the vicinity of a carboxylic acid group (-COOH) and by the effect of the function of (a) a fluorine-containing monomer represented by formula (I), the polymer compound tends to localize on the surface. At the printing, the structure (b) represented by formula (II) contributes to shielding the hydrophilic carboxylic acid group by the aliphatic cyclic structure in the vicinity thereof and allowing for less expression of hydrophilicity, and the photosensitive layer surface can be assured of good inking property. In the developer, excellent dissolution/dispersibility by virtue of the carboxylic acid group is expressed on dipping in an excess alkali developer, but due to introduction of the aliphatic cyclic structure into the vicinity of an acid group, the vicinity of an acid group comes to have high bulkiness and this makes it difficult for acid groups to interact with each other. In turn, aggregation of photosensitive layer components, particularly, polymer compounds, resulting from diffusion of the polymer in the developer less occurs, so that the generation of sludge difficult to treat and readily attachable to a plate material can be suppressed and both the excellent surface lipophilicity (inking property) and the effect of preventing the generation of development scum or sludge in the developer can be attained.

### Detailed Description of the Invention

The present invention is described in detail below.

The photosensitive layer comprised in the photosensitive lithographic printing plate of the present invention is formed by coating a photosensitive composition (it can be said as polymerizable composition because it is polymerizable.) comprising an addition-polymerizable compound having an ethylenically unsaturated double bond, a polymerization initiator, and a polymer compound having (a) a monomer represented by the formula (I) above and (b) a monomer represented by the formula (II) above as copolymerization components, after an undercoat layer is coated directly or for its necessity on a support.

### [Polymer compound having (a) a monomer represented by formula (I) and (b) a monomer represented by formula (II) as copolymerization components]

The fluorine-containing monomer (a) represented by formula (I) and the monomer (b) represented by formula (II) having an aliphatic cyclic structure in the vicinity of a carboxylic acid, which are copolymerization components giving preferred properties to the specific copolymer of the present invention, are described in detail.

In the present invention, the fluorine-containing monomer used as the copolymerization component (a) is represented by the following formula (I):

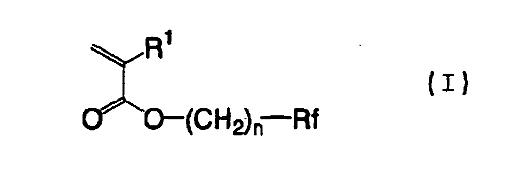

In formula (I), Rf represents a substituent containing a fluoroalkyl or perfluoroalkyl group having 9 or more fluorine atoms, n represents 1 or 2, and R¹ represents a hydrogen atom or a methyl group.

Specific examples of the fluorine-containing substituent of Rf include the following fluoroalkyl (meth)acrylates:

CH₂=CRCO₂(CH₂)ₘCₙF₂ₙ₊₁

(wherein m represents 1 or 2, n represents an integer of 4 to 12, and R represents an alkyl group having a carbon number of 1 to 4), and

CH₂=CRCO₂(CH₂)ₘ(CF₂)ₙH

(wherein m represents 1 or 2, n represents an integer of 4 to 12, and R represents an alkyl group having a carbon number of 1 to 4).

Here, by virtue of using a fluoroalkyl or perfluoroalkyl group having 9 or more fluorine atoms as Rf, a recording layer (photosensitive layer) having a fluorine atom concentration distribution in the film thickness direction is formed. As for this concentration distribution, there arises a phenomenon that the fluorine concentration in the vicinity of the recording layer surface is high and the fluorine concentration decreases in the depth direction of the recording layer. In particular, the number of fluorine atoms per the monomer unit is preferably from 9 to 30, more preferably from 13 to 25. Within this range, the effect of orienting the specific copolymer on the surface is successfully exerted and excellent inking property is obtained. If the number of fluorine atoms contained in one unit is excessively large, the inking property may deteriorate due to oil repellency of the fluorine atom.

In view of balance between the inking property and the effect of enhancing the surface orientation of the specific copolymer and increasing the development resistance, the fluorine atom content in the specific copolymer is preferably from 5 to 30 mmol/g, more preferably from 8 to 25 mmol/g. If the number of fluorine atoms contained in the copolymer is excessively large, this may also cause reduction in the inking property due to oil repellency of the fluorine atom.

In the present invention, the carboxyl group-containing monomer used as the copolymerization component (b) is represented by the following formula (II):

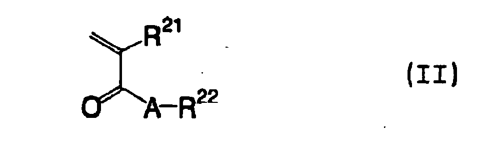

In formula (II), R²¹ represents a hydrogen atom or a methyl group, R²² represents a divalent hydrocarbon group having a carbon number of 3 to 30 and having an aliphatic cyclic structure, A represents an oxygen atom or -NR²³-, and R²³ represents a hydrogen atom or a monovalent hydrocarbon group having a carbon number of 1 to 10.

R²¹ in formula (II) represents a hydrogen atom or a methyl group, preferably a methyl group.

Examples of the divalent hydrocarbon group as R²² in formula (II), having a carbon number of 3 to 30 and having an aliphatic cyclic structure, include those where a divalent hydrocarbon group is formed by eliminating two hydrogen atoms on arbitrary carbon atoms constituting an aliphatic cyclic structure-containing compound such as cyclopropane, cyclopentane, cyclohexane, cycloheptane, cyclooctane, cyclodecane, dicyclohexyl, tercyclohexyl, norbornane, decahydronaphthalene, perhydrofluorene, tricyclo[5.2.1.02.6]decane, adamantane, quadricyclane, congressane, cubane, spiro[4.4]octane, cyclopentene, cyclohexene, cycloheptene, cyclooctene, cyclodecene, cyclohexadiene, cycloheptadiene, cyclooctadiene, cycloheptatriene, cyclodecatriene, cyclooctatetraene, norbornylene, octahydronaphthalene, bicyclo[2.2.1]heptadiene, bicyclo[4.3.0]nonadiene, dicyclopentadiene, hexahydroanthracene and spiro[4.5]decadiene, which compounds each may be substituted by one or more arbitrary substituent. R²² preferably has a carbon number of 3 to 30 including the substituent.

In the monomer (b) represented by formula (II), the aliphatic cyclic structure as R²² and the carboxyl group bonded thereto bring about excellent inking property of the specific polymer of the present invention. More specifically, the hydrophilic carboxyl group is sterically protected by the aliphatic cyclic structure, whereby the surface hydrophilicity of the film comprising the specific copolymer is decreased and the film surface is hydrophobed and in turn enhanced in the inking property. Here, the aliphatic cyclic structure takes a steric structure as compared with the aromatic cyclic structure and this seems to contribute to more reducing the distance between the carboxyl group and the ring structure and bringing out an effective shielding fimction.

The substituent which can be introduced into the divalent hydrocarbon group having an aliphatic cyclic structure represented by R²² includes a monovalent nonmetallic atom group excluding hydrogen, and examples thereof include a halogen atom (e.g., -F, -Br, -Cl, -I), a hydroxyl group, an alkoxy group, an aryloxy group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, an aryl group, an alkenyl group and an alkynyl group.

A hydrophobic substituent such as halogen atom, hydrocarbon group (e.g., alkyl, aryl, alkenyl, alkynyl), alkoxy group and aryloxy group is preferred because the press life tends to be enhanced. These substituents may, if possible, combine with each other to form a ring, or the substituent may combine with the hydrocarbon group to which the substituent is substituted, to form a ring. The substituent may be further substituted.

In the case where A in formula (II) is NR²³-, R²³ represents a hydrogen atom or a monovalent hydrocarbon group having a carbon number of 1 to 10. Examples of the monovalent hydrocarbon group having a carbon number of 1 to 10 represented by R²³ include an alkyl group, an aryl group, an alkenyl group and an alkynyl group.

Specific examples of the alkyl group include a linear, branched or cyclic alkyl group having a carbon number of 1 to 10, such as methyl group, ethyl group, propyl group, butyl group, pentyl group, hexyl group, heptyl group, octyl group, nonyl group, decyl group, isopropyl group, isobutyl group, sec-butyl group, tert-butyl group, isopentyl group, neopentyl group, 1-methylbutyl group, isohexyl group, 2-ethylhexyl group, 2-methylhexyl group, cyclopentyl group, cyclohexyl group, 1-adamantyl group and 2-norbornyl group.

Specific examples of the aryl group include an aryl group having a carbon number of 1 to 10, such as phenyl group, naphthyl group and indenyl group, and a heteroaryl group having a carbon number of 1 to 10 and containing one heteroatom selected from the group consisting of a nitrogen atom, an oxygen atom and a sulfur atom, such as furyl group, thienyl group, pyrrolyl group, pyridyl group and quinolyl group.

Specific examples of the alkenyl group include a linear, branched or cyclic alkenyl group having a carbon number of 1 to 10, such as vinyl group, 1-propenyl group, 1-butenyl group, 1-methyl-1-propenyl group, 1-cyclopentenyl group and 1-cyclohexenyl group.

Specific examples of the alkynyl group include an alkynyl group having a carbon number of 1 to 10, such as ethynyl group, 1-propynyl group, 1-butynyl group and 1-octynyl group. Examples of the substituent which R²³ may have are the same as those of the substituent which can introduced into R²². Here, the carbon number of R²³ is from 1 to 10 including the carbon number of the substituent.

A in formula (II) is preferably an oxygen atom or -NH-, because the synthesis is easy.

Specific preferred examples of the repeating unit derived from the monomer represented by formula (II) are set forth below, but the present invention is not limited thereto.

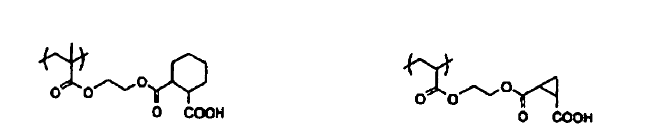

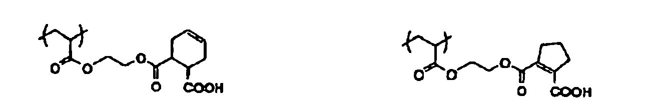

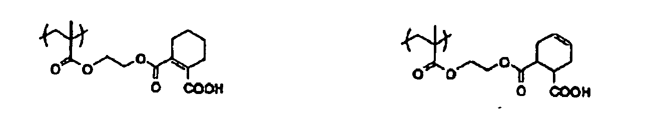

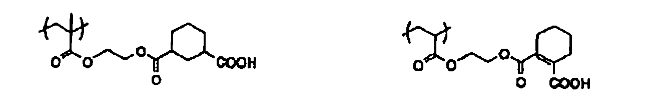

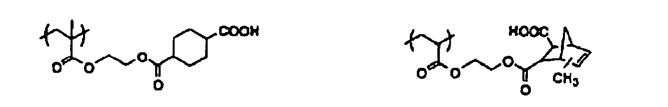

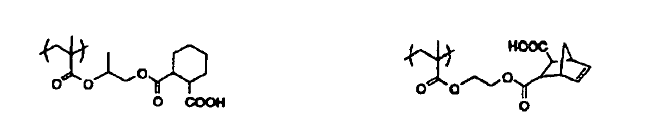

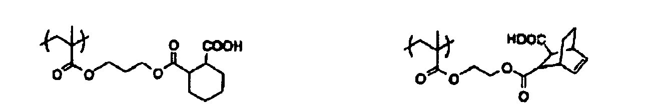

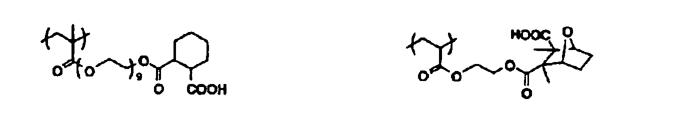

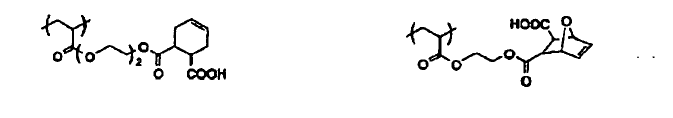

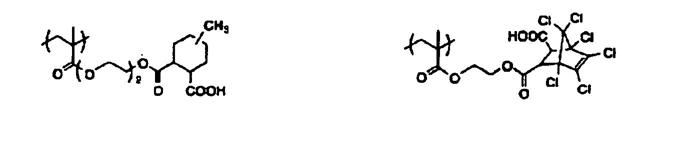

In the specific copolymer, one repeating unit derived from the monomer represented by formula (II) may be contained or two or more kinds of the repeating units may be contained. The total content of the repeating units derived from the monomer represented by formula (II) in the specific copolymer of the present invention may be appropriately determined according to the structure of the repeating unit, the design of the photosensitive layer, and the like, but the total content is preferably from 0.1 to 99 mol%, more preferably from 1 to 80 mol%, still more preferably from 5 to 60 mol%, based on the total molar amount of the components constituting the specific copolymer.

If the proportion of the carboxyl group in the polymer is too small, sludge is generated in the developer, whereas if the proportion is excessively large, desired excellent inking property is not obtained. Therefore, in view of inking property and sensitivity, the acid value per the polymer is preferably from 0.01 to 3.0 mmol/g, more preferably from 0.1 to 2.5 mmol/g, still more preferably from 0.2 to 2.0 mmol/g.

In the polymer compound of the present invention, in addition to the structural units derived from those two monomers (a) and (b), other monomer may be copolymerized for various purposes such as enhancement of coatability, within the range of not impairing the effects of the present invention.

Examples of the other monomer which can be used in combination include known monomers such as acrylic acid esters, methacrylic acid esters, acrylamides, methacrylamides, vinyl esters, styrenes, acrylonitrile, maleic anhydride and malic acid imide.

Examples of the acrylic acid esters include methyl acrylate, ethyl acrylate, (n- or i-)propyl acrylate, (n-, i-, sec- or tert-)butyl acrylate, amyl acrylate, 2-ethylhexyl acrylate, dodecyl acrylate, chloroethyl acrylate, 2-hydroxyethyl acrylate, 2-hydroxypropyl acrylate, 5-hydroxypentyl acrylate, cyclohexyl acrylate, allyl acrylate, trimethylolpropane monoacrylate, pentaerythritol monoacrylate, glycidyl acrylate, benzyl acrylate, methoxybenzyl acrylate, chlorobenzyl acrylate, 2-(p-hydroxyphenyl)ethyl acrylate, furfuryl acrylate, tetrahydrofurfuryl acrylate, phenyl acrylate, chlorophenyl acrylate and sulfamoylphenyl acrylate.

Examples of the methacrylic acid esters include methyl methacrylate, ethyl methacrylate, (nor i-)propyl methacrylate, (n-, i-, sec- or tert-)butyl methacrylate, amyl methacrylate, 2-ethylhexyl methacrylate, dodecyl methacrylate, chloroethyl methacrylate, 2-hydroxyethyl methacrylate, 2-hydroxypropyl methacrylate, 5-hydroxypentyl methacrylate, cyclohexyl methacrylate, allyl methacrylate, trimethylolpropane monomethacrylate, pentaerythritol monomethacrylate, glycidyl methacrylate, methoxybenzyl methacrylate, chlorobenzyl methacrylate, 2-(p-hydroxyphenyl)ethyl methacrylate, furfuryl methacrylate, tetrahydrofurfuryl methacrylate, phenyl methacrylate, chlorophenyl methacrylate and sulfamoylphenyl methacrylate.

Examples of the acrylamides include acrylamide, N-methylacrylamide, N-ethylacrylamide, N-propylacrylamide, N-butylacrylamide, N-benzylacrylamide, N-hydroxyethylacrylamide, N-phenylacrylamide, N-tolylacrylamide, N-(p-hydroxyphenyl)acrylamide, N-(sulfamoylphenyl)acrylamide, N-(phenylsulfonyl)acrylamide, N-(tolylsulfonyl)acrylamide, N,N-dimethylacrylamide, N-methyl-N-phenylacrylamide and N-hydroxyethyl-N-methylacrylamide.

Examples of the methacrylamides include methacrylamide, N-methylmethacrylamide, N-ethylmethacrylamide, N-propylmethacrylamide, N-butylmethacrylamide, N-benzylmethacrylamide, N-hydroxyethylmethacrylamide, N-phenylmethacrylamide, N-tolylmethacrylamide, N-(p-hydroxyphenyl)methacrylamide, N-(sulfamoylphenyl)methacrylamide, N-(phenylsulfonyl)methacrylamide, N-(tolylsulfonyl)methacrylamide, N,N-dimethylmethacrylamide, N-methyl-N-phenylmethacrylamide and N-hydroxyethyl-N-methylmethacrylamide.

Examples of the vinyl esters include vinyl acetate, vinyl butyrate and vinyl benzoate.

Examples of the styrenes include styrene, methylstyrene, dimethylstyrene, trimethylstyrene, ethylstyrene, propylstyrene, cyclohexylstyrene, chloromethylstyrene, trifluoromethylstyrene, ethoxymethylstyrene, acetoxymethylstyrene, methoxystyrene, dimethoxystyrene, chlorostyrene, dichlorostyrene, bromostyrene, iodostyrene, fluorostyrene and carboxystyrene.

Among these monomers, preferred are acrylic acid esters having a carbon number of 20 or less, methacrylic acid esters, vinyl esters, styrenes and acrylonitrile.

The photosensitive layer of the photosensitive lithographic printing plate of the present invention may contain only one specific copolymer or may contain a mixture of two or more kinds of specific copolymers. Also, as long as the effects of the present invention are not impaired, the specific copolymer of the present invention may be used as a mixture by using one or more fluorine-containing polymer compound out of the scope of the present invention in combination.

The content of the fluorine-containing polymer compound used in combination is from 0.01 to 300 wt%, preferably from 0.1 to 250 wt%, more preferably from 1 to 200 wt%, based on the total weight of the specific copolymer of the present invention. As for the fluorine-containing polymer compound which can be used in combination, commercially available products may be used without limitation and, specifically, fluorine-containing surfactants often used in this industry and fluorine-based polymers described in JP-A-2002-311577, JP-A-2002-72474 and JP-A-2004-101893 may be preferably used.

The mass average molecular weight of the specific copolymer for use in the present invention is appropriately determined in view of inking property, developability and suppression of precipitate generation in the developer. Usually, when the molecular weight is high, this tends to cause deterioration of developability or increase of precipitate or aggregate generation in the developer, though excellent inking property may be obtained. On the contrary, when the molecular weight is low, the developability and the precipitate or aggregate generation in the developer may be suppressed, but the inking property deteriorates. From the standpoint of balancing the film characteristics and inking property-enhancing effect with the handleability, solvent solubility and uniformity at the coating, the molecular weight is preferably from 1,000 to 1,000,000, more preferably from 2,000 to 500,000, still more preferably from 3,000 to 300,000.

The specific copolymer for use in the present invention may be linear or branched or may have a block structure.

The structures of polymer compounds [(P-1) to (P-21)] suitably used in the present invention are set forth below together with the mass average molecular weight (Mw), but the present invention is not limited thereto. In the follosing polymer compounds, ratio of repeating units is molar ratio.

| Mw (ten-thousands) | | |
|---|---|---|
| P-1 | 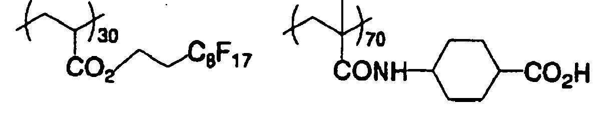 | 3.6 |
| P-2 | 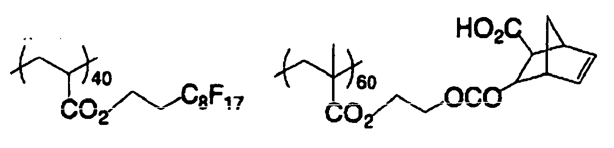 | 5.2 |
| P-3 | 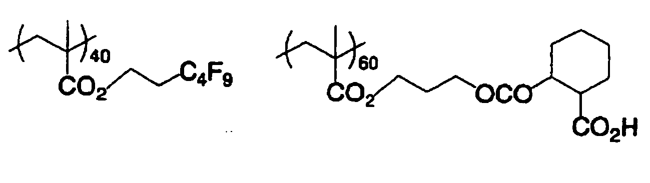 | 2.8 |
| P-4 | 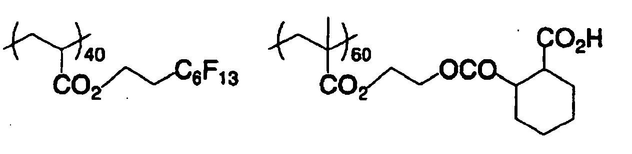 | 2.6 |
| P-5 | 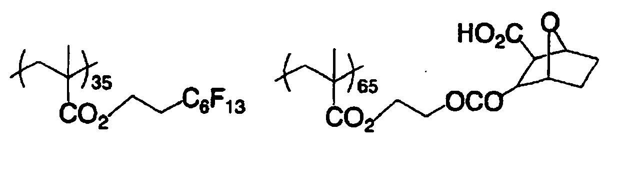 | 3.5 |
| P-6 | 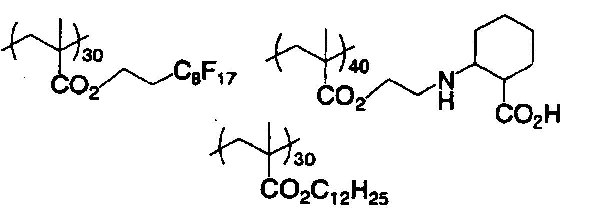 | 4.1 |
| P-7 | 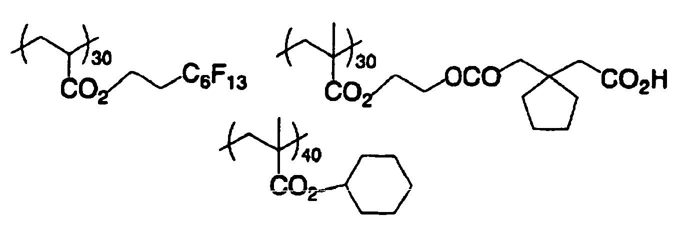 | 5.2 |
| P-8 | 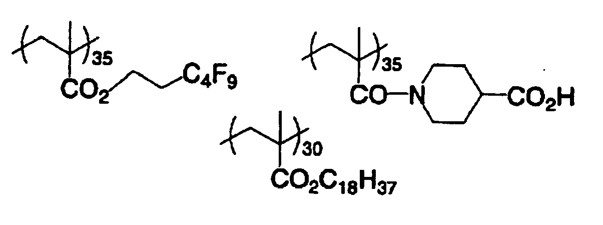 | 2.6 |
| P-9 | 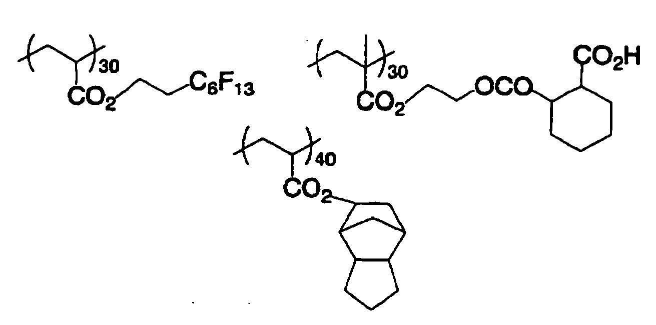 | 1.5 |
| P-10 | 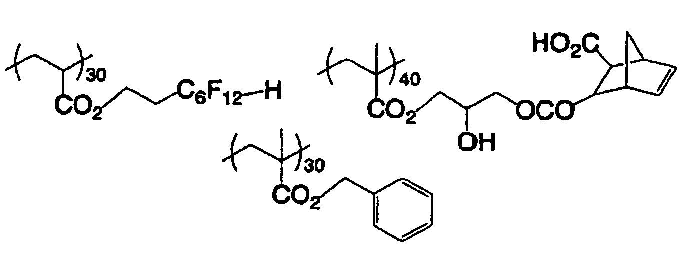 | 3.8 |
| P-11 | 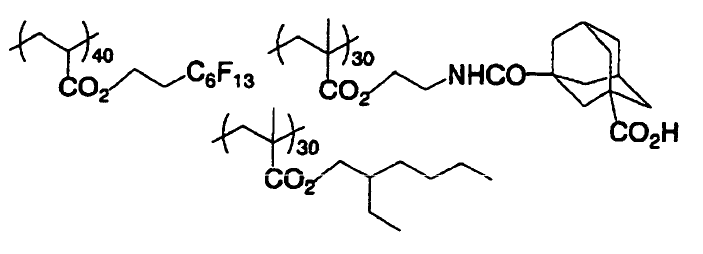 | 4.2 |
| P-12 | 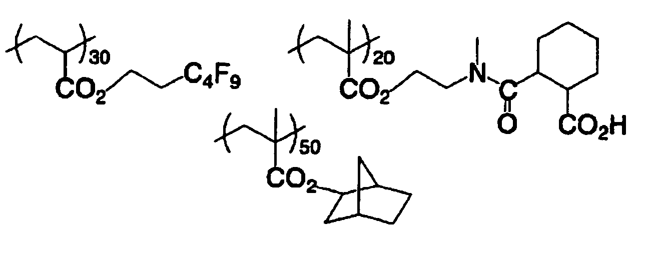 | 5.1 |
| P-13 | 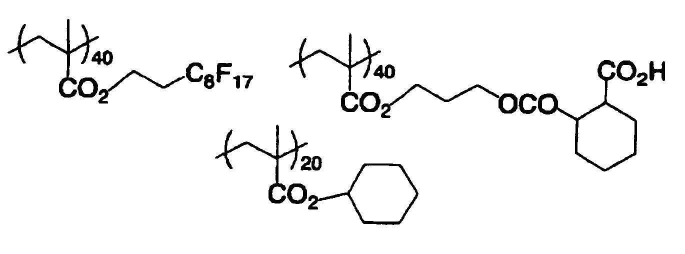 | 3.0 |
| P-14 | 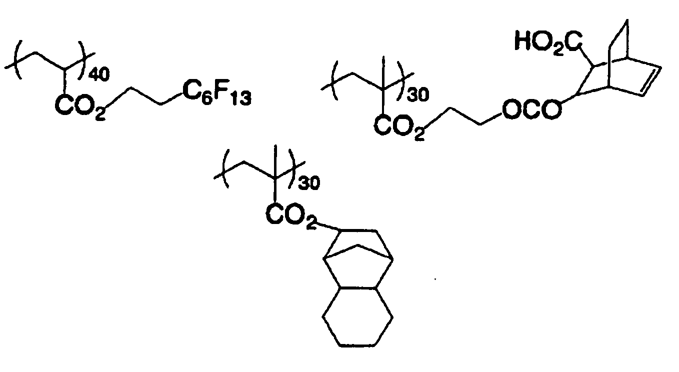 | 2.5 |
| P-15 | 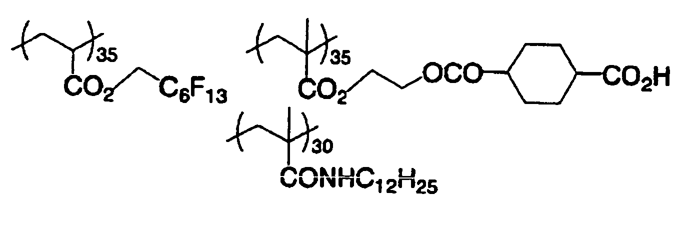 | 1.9 |
| P-16 | 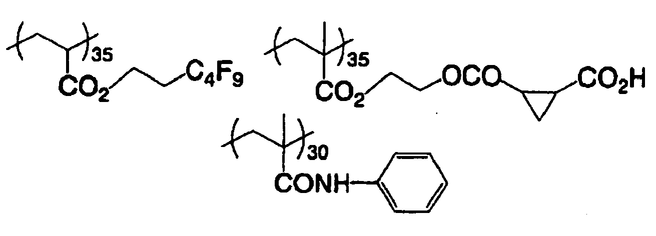 | 1.2 |
| P-17 | 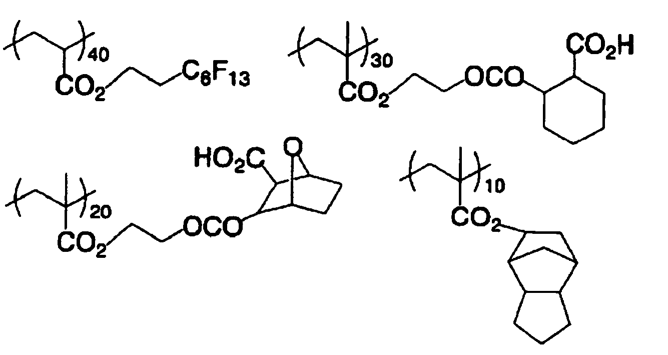 | 1.8 |
| P-18 | 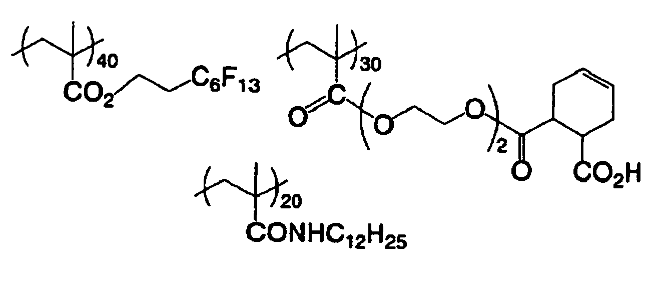 | 3.1 |

The content of the specific copolymer according to the present invention in the photosensitive layer may be appropriately determined, but usually, the content is preferably from 0.0001 to 20 mass%, more preferably from 0.001 to 15 mass%, still more preferably from 0.01 to 10 mass%. (In this specification, mass ratio is equal to weight ratio.)

### [Addition-Polymerizable Compound Having Ethylenically Unsaturated Bond]

The addition-polymerizable compound having an ethylenically unsaturated bond is a compound having an ethylenically unsaturated bond capable of undergoing addition polymerization when the photopolymerizable composition is irradiated with actinic rays and thereby effecting crosslinking or curing. The addition-polymerizable compound containing an ethylenically unsaturated bond can be arbitrarily selected from the compounds having at least one, preferably two or more, terminal ethylenically unsaturated bond(s). These are, for example, a compound having a chemical mode such as monomer, prepolymer (that is, dimer, trimer or oligomer) or a mixture or copolymer thereof.

Examples of the monomer and a copolymer thereof include an ester of an unsaturated carboxylic acid (e.g., acrylic acid, methacrylic acid, itaconic acid, crotonic acid, isocrotonic acid, maleic acid) with an aliphatic polyhydric alcohol compound, and an amide of the unsaturated carboxylic acid with an aliphatic polyvalent amine compound. Specific examples of the ester monomer of an aliphatic polyhydric alcohol compound with an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate and polyester acrylate oligomer.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)phenyl]dimethylmethane.

Examples of the itaconic acid ester include ethylene glycol diitaconate, propylene glycol diitaconate, 1,5-butanediol diitaconate, 1,4-butanediol diitaconate, tetramethylene glycol diitaconate, pentaerythritol diitaconate and sorbitol tetraitaconate. Examples of the crotonic acid ester include ethylene glycol dicrotonate, tetramethylene glycol dicrotonate, pentaerythritol dicrotonate and sorbitol tetradicrotonate. Examples of the isocrotonic acid ester include ethylene glycol diisocrotonate, pentaerythritol diisocrotonate and sorbitol tetraisocrotonate.

Examples of the maleic acid ester include ethylene glycol dimaleate, triethylene glycol dimaleate, pentaerythritol dimaleate and sorbitol tetramaleate. Furthermore, a mixture of these ester monomers may also be used. Specific examples of the amide monomer of an aliphatic polyvalent amine compound with an unsaturated carboxylic acid include methylenebisacrylamide, methylenebis-methacrylamide, 1,6-hexamethylenebisacrylamide, 1,6-hexamethylenebismethacrylamide, diethylenetriaminetrisacrylamide, xylylenebisacrylamide and xylylenebismethacrylamide.

Other examples include a vinyl urethane compound having two or more polymerizable vinyl groups within one molecule described in JP-B-48-41708, which is obtained by adding a vinyl monomer having a hydroxyl group represented by the following formula (A) to a polyisocyanate compound having two or more isocyanate groups within one molecule.

CH₂=C(R)COOCH₂CH(R')OH (A)

(wherein R and R' each represents H or CH₃).

Also, a polyfunctional acrylate or methacrylate such as urethane acrylates described in JP-A-51-37193 and JP-B-2-32293, polyester acrylates described in JP-A-48-64183, JP-B-49-43191 and JP-B-52-30490, and epoxy acrylates obtained by reacting an epoxy resin with a (meth)acrylic acid may be used. Furthermore, those described as a photocurable monomer or oligomer in Adhesion, Vol. 20, No. 7, pp. 300-308 (1984) may also be used. Such an ethylenically unsaturated bond-containing compound is usually used in an amount of 5 to 80 mass%, preferably from 20 to 70 mass%, based on the entire mass of the photosensitive layer.

### [Polymerization Initiator]

The polymerization initiator contained in the photosensitive layer of the photosensitive lithographic printing plate of the present invention may be appropriately selected from various photopolymerization initiators or a combination system of two or more kinds of photopolymerization initiators (photo-initiation system) known in patents, publications and the like, according to the wavelength of the light source used.

This polymerization initiator (initiation system) is described below.

In the case of using visible light of 400 nm or more, an Ar laser, second harmonic of a semiconductor laser, or an SHG-YAG laser as the light source, various photo-initiation systems have been proposed. Examples thereof include a certain kind of photo-reducing dyes described in U.S. Patent 2,850,445, Rose Bengal, eosin, erythrosine and a combination system of a dye and an initiator, such as a composite initiation system of a dye and an amine (see, JP-B-44-20189), a combination system of a hexaarylbiimidazole, a radical generator and a dye (see, JP-B-45-37377), a system of a hexaarylbiimidazole and a p-dialkylaminobenzylidene ketone (see, JP-B-47-2528 and JP-A-54-155292), a system of a cyclic cis-α-dicarbonyl compound and a dye (see, JP-A-48-84183), a system of a cyclic triazine and a merocyanine dye (see, JP-A-54-151024), a system of a 3-ketocoumarin and an activator (see, JP-A-52-112681 and JP-A-58-15503), a system of a biimidazole, a styrene derivative and a thiol (see, JP-A-59-140203), a system of an organic peroxide and a coloring matter (see, JP-A-59-1504, JP-A-59-140203, JP-A-59-189340, JP-A-62-174203, JP-B-62-1641 and U.S. Patent 4,766,055), a system of a dye and an active halogen compound (see, JP-A-63-258903 and JP-A-2-63054), a system of a dye and a borate compound (see, JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), a system of a rhodanine ring-containing coloring matter and a radical generator (see, JP-A-2-179643 and JP-A-2-244050), a system of a titanocene and a 3-ketocoumarin dye (see, JP-A-63-221110), a combination system of a titanocene, a xanthene dye and an addition-polymerizable ethylenically unsaturated bond-containing compound having an amino group or a urethane group (see, JP-A-4-221958 and JP-A-4-219756), a system of a titanocene and a specific merocyanine dye (see, JP-A-6-295061), and a system of a titanocene and a benzopyran ring-containing coloring matter (JP-A-8-334897).

In particular, a system using a titanocene compound or a hexaarylbiimidazole is preferred.

Furthermore, with development of a laser at a wavelength of 400 to 410 nm (violet laser), a photo-initiation system responding thereto and showing high sensitivity to light at a wavelength of 450 nm or less has been created, and examples thereof include a photo-initiation system such as cationic dye/borate system (see, JP-A-11-84647), merocyanine dye/titanocene system (see, JP-A-2000-147763), and carbazole-type coloring matter/titanocene system (see, JP-A-2001-42524). In particular, a system using a titanocene compound is excellent in view of sensitivity and is preferred.

As for the titanocene compound, various titanocene compounds may be used, but an appropriate titanocene compound may be selected from those described in JP-A-59-152396 and JP-A-61-151197. Specific examples thereof include dicyclopentadienyl-Ti-dichloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-fluorophen-1-yl, dimethylcyclopentadienyl-Ti-bis-2,3,4,5,6-tetrafluorophen-1-yl, dimethylcyclopentadienyl-Ti-bis-2,6-difluorophen-1-yl and dicyclopentadienyl-Ti-bis-2,6'-difluoro-3-(pyr-1-lyl)-phen-1-yl.

Such a polymerization initiator is usually added in an amount of 0.05 to 100 parts by mass, preferably from 0.1 to 70 parts by mass, more preferably from 0.2 to 50 parts by mass, per 100 parts by mass of the ethylenically unsaturated bond-containing compound.

### <Sensitizing Dye>

The photo-initiation system of the present invention preferably contains a sensitizing dye in addition to the polymerization initiator.

The sensitizing dye is known in a large number of patents and documents and may be appropriately selected from coloring matters sensitive to a light source such as ultraviolet ray, visible light, Ar ion laser, FD-YAG laser and short-wavelength semiconductor laser. Examples thereof include a photo-reducing dye described in U.S. Patent 2,850,445, a dialkylaminobenzylidene ketone dye described in JP-B-47-2528, a merocyanine dye described in JP-A-54-151024, a 3-ketocoumarin dye described in JP-A-58-15503, a cyanine dye and a merocyanine dye described in JP-A-59-140203, JP-A-62-174203 and JP-A-2-63054, a dye having a rhodanine skeleton described in JP-A-2-244050, a xanthene-based coloring matter described in JP-A-4-219756, a merocyanine-based coloring matter described in JP-A-6-295061, a coloring matter having a benzopyran system described in JP-A-8-334897, and sensitizing dyes described in B.M. Monroe, "General Remarks" of Chemical Review, Vol. 93, pp. 435-448 (1993), and D.F. Eaton, Advance in Photochemistry, Vol. 13, pp. 427-480 (1986). In particular, a coloring matter having high sensitivity to light at 350 to 450 nm is useful as the sensitizing dye, such as a merocyanine dye described in JP-A-2000-147763, a carbazole-type coloring matter described in JP-A-2001-42524, a merocyanine dye described in JP-A-2003-21895, and a dye having an oxazolidinone skeleton described in Japanese Patent Application Nos. 11-290204 and 2002-021723.

Similarly to the addition-polymerizable compound above, the use method of the sensitizing dye can be arbitrarily set according to the performance design of the photosensitive material. For example, the compatibility to the photosensitive layer can be elevated by using two or more kinds of sensitizing dyes in combination. In the selection of a sensitizing dye, not only the photosensitivity but also the molar extinction coefficient at the emission wavelength of a light source used are important factors. The amount of the coloring matter added can be made relatively small by using a coloring matter having a large molar extinction coefficient, and this is profitable and advantageous also in view of film physical properties of the photosensitive layer. The absorbance at the light source wavelength greatly affects the photosensitivity of photosensitive layer, the resolution and the physical properties of exposed film and therefore, the amount of the sensitizing dye added is appropriately selected by taking account of these properties. For example, the sensitivity lowers in the low-absorbance region of 0.1 or less. Also, the resolution decreases by the effect of halation. However, for example, for the purpose of curing a thick film of 5 µm or more, such a low absorbance sometimes rather brings about high curing degree. On the other hand, in a high-absorbance region of 3 or more, the majority of light is absorbed on the surface of the photosensitive layer, giving rise to inhibition of curing in the inner portion, and for example, when used as a printing plate, the film strength and adhesion to the substrate becomes insufficient. In the case of a lithographic printing plate having a relatively small film thickness, the amount of the sensitizing dye added is preferably set such that the absorbance of the image recording layer falls within the range from 0.1 to 3.0, preferably from 0.25 to 1.5. In use as a lithographic printing plate, the amount of the sensitizing dye added is usually from 0.05 to 30 parts by mass, preferably from 0.1 to 20 parts by mass, more preferably from 0.2 to 10 parts by mass, per 100 parts by mass of the components constituting the image recording layer.

As for the sensitizing dye used in the present invention, a laser light-absorbing coloring matter (sensitizing dye) having an absorption maximum wavelength in the range from 330 to 430 nm is preferred.

For example, in the case of using a light source emitting light in the vicinity of 400 nm, benzyl, benzoin ether, Michler's ketone, anthraquinone, thioxanthone, acridine, phenazine, benzophenone and the like may be used.

Also, in the case of using a ray of 330 nm or more, an Ar laser, second harmonic of a semiconductor laser, or a YAG laser as the light source, various photo-initiation systems have been proposed. Examples thereof include a certain kind of photo-reducing dyes such as Rose Bengal, eosin and erythrosine described in U.S. Patent 2,850,445, and a combination system of a dye and a photo-initiator, such as a composite initiation system of a dye and an amine (see, JP-B-44-20189), a combination system of a hexaarylbiimidazole, a radical generator and a dye (see, JP-B-45-37377), a system of a hexaarylbiimidazole and a p-dialkylaminobenzylidene ketone (see, JP-B-47-2528 and JP-A-54-155292), a system of a cyclic cis-α-dicarbonyl compound and a dye (see, JP-A-48-84183), a system of a cyclic triazine and a merocyanine dye (see, JP-A-54-151024), a system of a 3-ketocoumarin and an activator (see, JP-A-52-112681 and JP-A-58-15503), a system of a biimidazole, a styrene derivative and a thiol (see, JP-A-59-140203), a system of an organic peroxide and a coloring matter (see, JP-A-59-1504, JP-A-59-140203, JP-A-59-189340, JP-A-62-174203, JP-B-62-1641 and U.S. Patent 4,766,055), a system of a dye and an active halogen compound (see, JP-A-63-178105, JP-A-63-258903 and JP-A-2-63054), a system of a dye and a borate compound (see, JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), a system of a rhodanine ring-containing coloring matter and a radical generator (see, JP-A-2-179643 and JP-A-2-244050), a system of a titanocene and a 3-ketocoumarin dye (see, JP-A-63-221110), a combination system of a titanocene, a xanthene dye and an addition-polymerizable ethylenically unsaturated compound having an amino group or a urethane group (see, JP-A-4-221958 and JP-A-4-219756), a system of a titanocene and a specific merocyanine dye (see, JP-A-6-295061), and a system of a titanocene and a benzopyran ring-containing coloring matter (JP-A-8-334897).

As for the laser light-absorbing coloring matter (sensitizing dye), a coloring matter having an absorption wavelength in the short-wavelength region of 330 to 430 nm is preferably used.

As for the laser light-absorbing coloring matter used in the present invention, those conventionally known as a sensitizing dye for laser exposure may be used, and examples thereof include a triaryl-based sensitizing dye described in JP-A-2003-221517.

The sensitizing dye which is preferably used in the present invention is a compound represented by the following formula (4): 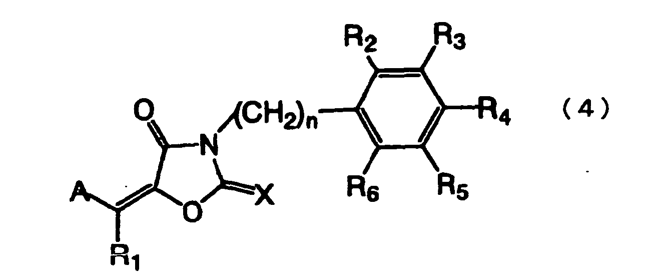 (wherein A represents an aromatic or heterocyclic ring which may have a substituent; X represents an oxygen atom, a sulfur atom or =NR₇; R₁, R₂, R₃, R₄, R₅, R₆ and R₇ each independently represents a hydrogen atom or a monovalent nonmetallic atom group, provided that at least one of R₂, R₃, R₄, R₅ and R₆ represents a substituent represented by -OR₈, wherein each R₈ independently represents a monovalent nonmetallic atom group; and n represents an integer of 1 to 6).

Formula (4) is described in detail below.

The monovalent nonmetallic atom group represented by R₁, R₂, R₃, R₄, R₅, R₆, R₇ and R₈ (hereinafter sometimes simply referred to as "R₁ to R₈") is preferably a substituted or unsubstituted alkyl group, a substituted or unsubstituted alkenyl group, a substituted or unsubstituted aryl group, a substituted or unsubstituted aromatic heterocyclic group, a substituted or unsubstituted alkynyl group, a substituted or unsubstituted alkoxy group, a substituted or unsubstituted alkylthio group, a hydroxyl group, an acyl group or a halogen atom.

Preferred examples of R₁ to R₈ are specifically described below.

Preferred examples of the alkyl group include a linear, branched or cyclic alkyl group having from 1 to 20 carbon atoms, and specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among these, a linear alkyl group having from 1 to 12 carbon atoms, a branched alkyl group having from 3 to 12 carbon atoms, and a cyclic alkyl group having from 5 to 10 carbon atoms are more preferred.

As for the substituent of the substituted alkyl group, a monovalent nonmetallic atom group excluding hydrogen is used, and preferred examples thereof include a halogen atom (e.g., -F, -Br, -Cl, -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugate base group thereof (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-allcylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and a conjugate base group thereof (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof (hereinafter referred to as an "alkylphosphonato group"), a monoarylphosphono group (-PO₃H(aryl)) and a conjugate base group thereof (hereinafter referred to as an "arylphosphonato group"), a phosphonoxy group (-OPO₃H₂) and a conjugate base group thereof (hereinafter referred to as a "phosphonatoxy group"), a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof (hereinafter referred to as an "alkylphosphonatoxy group"), a monoarylphosphonoxy group (-OPO₃H(aryl)) and a conjugate base group thereof (hereinafter referred to as an "arylphosphonatoxy group"), a cyano group, a nitro group, an aryl group, a heteroaryl group, an alkenyl group and an alkynyl group.

In these substituents, specific examples of the alkyl group include the above-described alkyl groups, and specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group and a phosphonatophenyl group.

As for the aromatic heterocyclic group preferred as R₁ to R₈, a monocyclic or polycyclic aromatic ring containing at least one of a nitrogen atom, an oxygen atom and a sulfur atom is used. Preferred examples of the aromatic heterocyclic group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthyridine, quinazoline, cinnoline, pteridine, carbazole, carboline, phenanthrine, acridine, perimidine, phenanthroline, phthalazine, phenarsazine, phenoxazine, furazan and phenoxazine. These rings each may be further benzo-condensed or may have a substituent.

Examples of the alkenyl group preferred as R₁ to R₈ include a vinyl group, a 1-propenyl group, a 1-butenyl group, a cinnamyl group and a 2-chloro-1-ethenyl group, and examples of the alkynyl group include an ethynyl group, a 1-propynyl group, a 1-butynyl group and a trimethylsilylethynyl group. Examples of G1 in the acyl group (G1CO-) include hydrogen and the above-described alkyl and aryl groups.

Among these substituents, more preferred are a halogen atom (e.g., -F, -Br, -Cl, -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonoxy group, a phosphonatoxy group, an aryl group and an alkenyl group.

Examples of the alkylene group in the substituted alkyl group include a divalent organic residue resulting from the elimination of any one hydrogen atom on the above-described alkyl group having a carbon number of 1 to 20, and a linear alkylene group having from 1 to 12 carbon atoms, a branched alkylene group having from 3 to 12 carbon atoms and a cyclic alkylene group having from 5 to 10 carbon atoms are preferred.

Specific examples of the substituted alkyl group preferred as R₁ to R₈, which is obtained by combining the above-described substituent and alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonoxypropyl group, a phosphonatoxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Examples of the aryl group preferred as R₁ to R₈ include a condensed ring formed from 1 to 3 benzene rings, and a condensed ring formed by a benzene ring and a 5-membered unsaturated ring, and specific examples thereof include a phenyl group, a naphthyl group, an anthryl group, a phenanthryl group, an indenyl group, an acenaphthenyl group and a fluorenyl group. Among these, a phenyl group and a naphthyl group are more preferred.

Specific examples of the substituted aryl group preferred as R₁ to R₈ include those having a monovalent nonmetallic atom group (excluding hydrogen atom) as a substituent on the ring-forming carbon atom of the above-described aryl groups.

Preferred examples of the substituent include the above-described alkyl groups, substituted alkyl groups and substituents for the substituted alkyl group. Specific preferred examples of the substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylphenyl group, a 2-propenylphenyl group, a 2-butynylphenyl group and a 3-butynylphenyl group.

R₂, R₃, R₄, R₅ and R₆ each is more preferably a hydrogen atom or a substituted or unsubstituted alkyl group, and R₈ is more preferably a substituted or unsubstituted alkyl group, still more preferably an ethyl group or a methyl group.

n is preferably from 2 to 5, more preferably 2 or 3.

Next, A in formula (4) is described below. A represents an aromatic or hetero ring which may have a substituent. Specific examples of the aromatic or hetero ring which may have a substituent are the same as those described for R₁ to R₈ in formula (4).

Among these sensitizing dyes represented by formula (4), a sensitizing dye having a structure represented by the following formula (5) is preferred, because this dye has high sensitizing ability and moreover, gives a photosensitive composition with excellent storage stability. 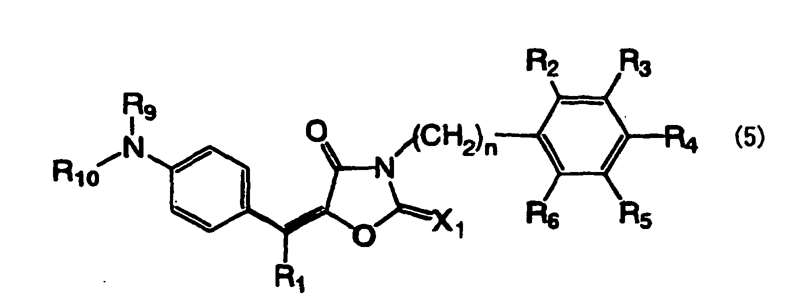 (wherein X₁ represents an oxygen atom or a sulfur atom, R₁, R₂, R₃, R₄, R₅ and R₆ each independently represents a hydrogen atom or a monovalent nonmetallic atom group, R₉ and R₁₀ each independently represents a monovalent nonmetallic atom group, provided that at least one of R₂, R₃, R₄, R₅ and R₆ represents a substituent represented by -OR₈ (wherein each R₈ independently represents a monovalent nonmetallic atom group), and n represents an integer of 1 to 6).

In formula (5), R₁, R₂, R₃, R₄, R₅, R₆ and R₈ have the same meanings as in formula (4), R₉ and R₁₀ each independently represents a monovalent nonmetallic atom group, and specific preferred examples thereof include the groups described above for R₂, R₃, R₄, R₅ and R₆. R₉ and R₁₀ each is more preferably an aryl or heterocyclic group which may have a substituent.

The sensitizing dyes represented by formulae (4) and (5) of the present invention are obtained by a condensation reaction of the above-described acidic nucleus or an active methylene group-containing acidic nucleus with a substituted or unsubstituted aromatic or hetero ring, and the synthesis thereof may be performed by referring to JP-B-59-28329.

Specific preferred examples (D1) to (D32) of the compound represented by formula (4) are set forth below, but the present invention is not limited thereto. Also, isomers by a double bond connecting an acidic nucleus and a basic nucleus are not clarified, and the present invention is not limited to any isomer.

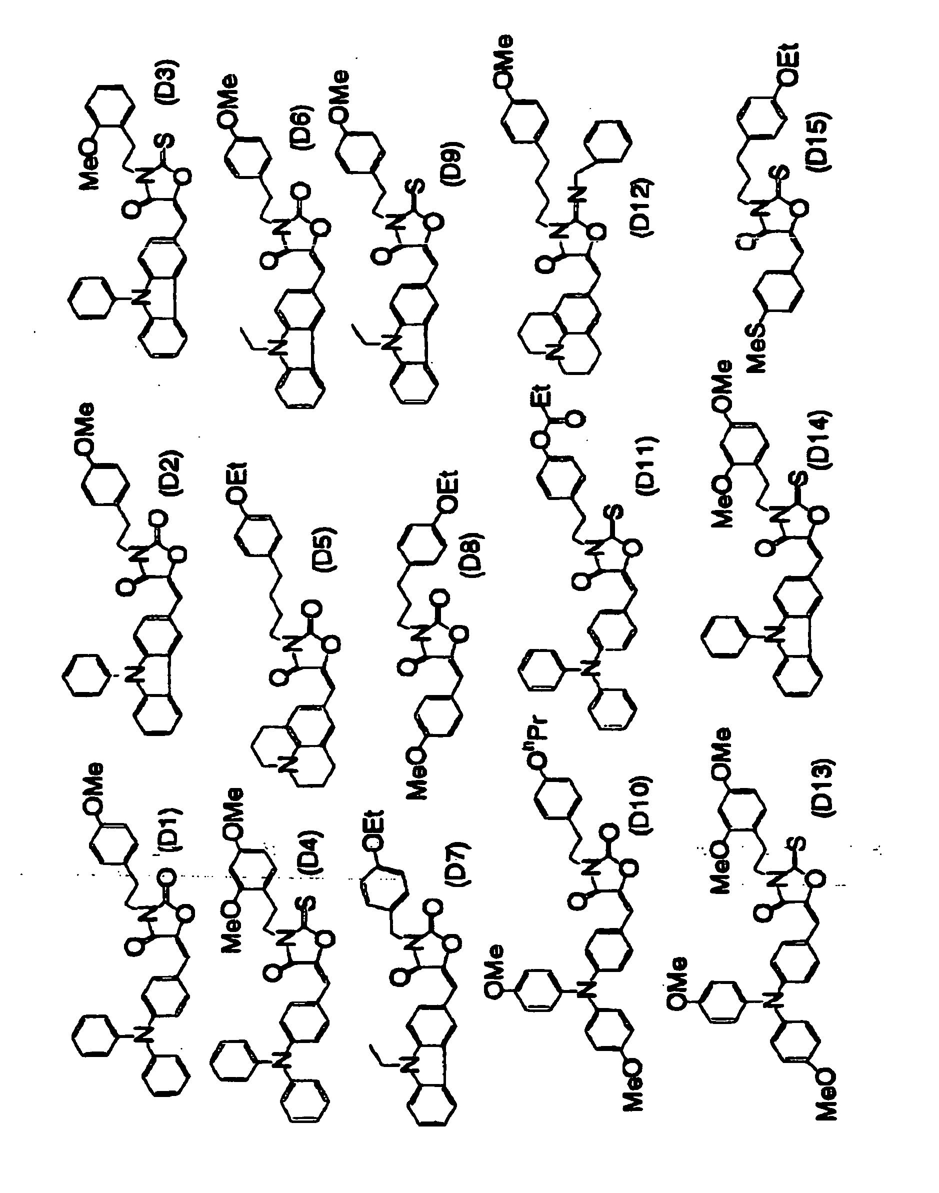

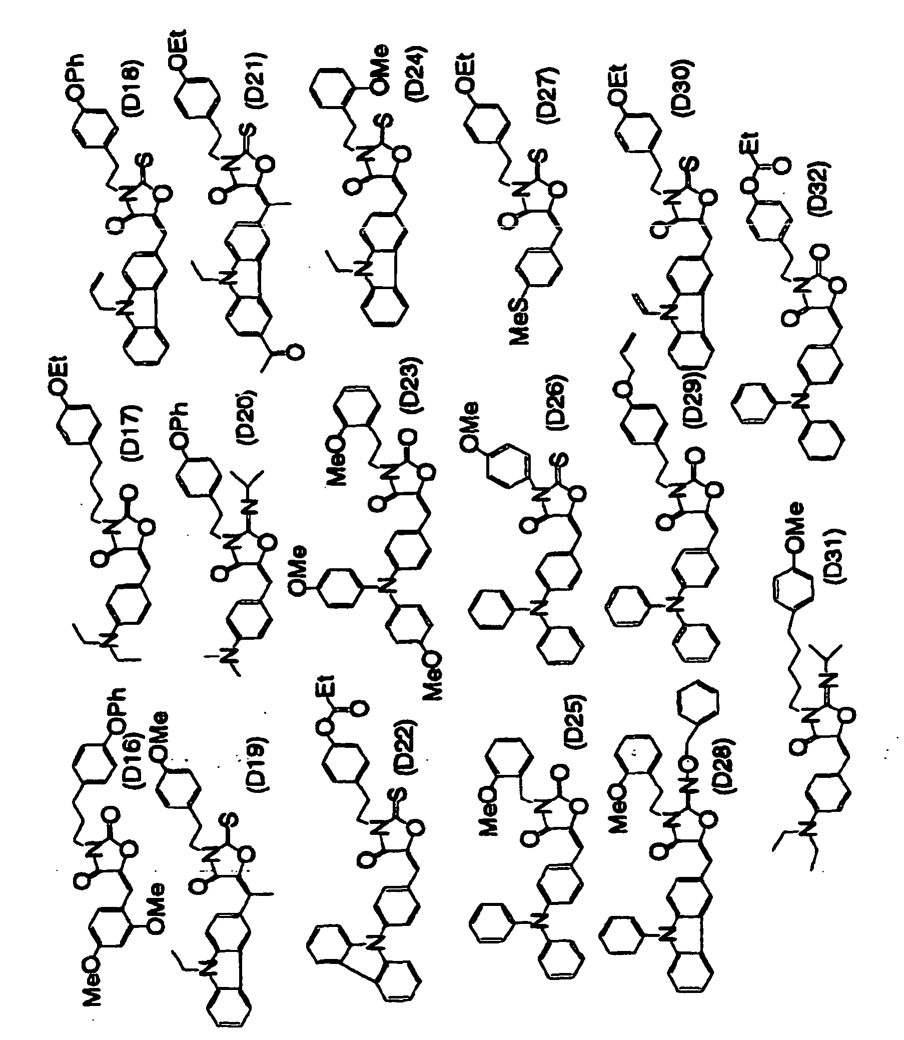

The sensitizing dye for use in the present invention may be subjected to various chemical modifications for improving the properties of the photosensitive layer. For example, when the sensitizing dye is bonded to an addition-polymerizable compound structure (e.g., acryloyl group, methacryloyl group) by a method such as covalent bonding, ion bonding and hydrogen bonding, this makes it possible to increase the strength of the exposed film or suppress unnecessary deposition of the coloring matter from the film after exposure. Also, by bonding the sensitizing dye to a radical, acid or base generating part of an activator compound described later, the sensitivity particularly when the initiation system is in the low concentration state can be remarkably enhanced. Furthermore, in order to elevate the suitability for processing in an (alkaline) aqueous developer, which is a preferred use embodiment of the photosensitive layer of the present invention, introduction of a hydrophilic moiety (an acid group or a polar group, such as a carboxyl group and its ester, a sulfonic group and its ester, and an ethylene oxide group) is effective. Particularly, an ester-type hydrophilic group ensures that in the photosensitive layer, excellent compatibility is exhibited by virtue of its relatively hydrophobic structure and in the developer, the hydrophilicity is increased by producing an acid group upon hydrolysis. Furthermore, for example, in order to enhance the compatibility in the photosensitive layer or suppress the crystal deposition, an appropriate substituent may be introduced. For example, in a certain photosensitive system, an unsaturated bond such as aryl group and allyl group is sometimes very effective for the enhancement of compatibility. Also, when a steric hindrance between dye π planes is introduced by a method such as introduction of a branched alkyl structure, the crystal deposition can be remarkably suppressed. In addition, the adhesion to an inorganic material such as metal and metal oxide can be enhanced by introducing a phosphonic acid group, an epoxy group, a trialkoxysilyl group or the like. Other than these, a method such as polymer formation of the sensitizing dye may also be utilized according to the purpose.

Details of the manner of using these sensitizing dyes, such as what structure is used, whether sole sensitizing dye is used or two or more sensitizing dyes are used in combination and in what amount the sensitizing dye is added, can be appropriately selected according to the performance design of the final photosensitive material. For example, the compatibility to the photosensitive layer can be enhanced by using two or more kinds of sensitizing dyes in combination. In the selection of sensitizing dye, the molar extinction coefficient at the emission wavelength of a light source used is also an important factor, in addition to the photosensitivity. The amount of the coloring matter added can be made relatively small by using a coloring matter having a large molar extinction coefficient, and this is profitable and advantageous also in view of film physical properties of the photosensitive layer. The absorbance at the light source wavelength greatly affects the photosensitivity of image recording layer, the resolution and the physical properties of exposed film and therefore, the amount of the sensitizing dye added is appropriately selected by taking account of these properties. In use as a lithographic printing plate having a relatively small film thickness, the amount of the sensitizing dye added is preferably set such that the absorbance of the photosensitive layer falls within the range from 0.1 to 1.5, preferably from 0.25 to 1.

In the present invention, the amount of the sensitizing dye added is preferably from 0.1 to 30 mass%, more preferably from 0.3 to 15 mass%, still more preferably from 0.5 to 10 mass%, based on all components of the photosensitive layer. Also, in the case of use as a lithographic printing plate, the amount of the sensitizing dye added is usually from 0.05 to 30 parts by mass, preferably from 0.1 to 20 parts by mass, more preferably from 0.2 to 10 parts by mass, per 100 parts by mass of the components constituting the photosensitive layer.

In the thermal system which is exposed by an infrared laser, a polymerization initiator (T) and an infrared absorbent, which are described below, are preferably added.

### [Polymerization Initiator (T)]

As long as a radical is generated when an energy is supplied, the polymerization initiator (T) may be any compound such as a thermal decomposition-type radical generator having a function of initiating a curing reaction of the above-described ethylenically unsaturated compound as a polymerizable compound, causing the reaction to proceed and generating a radical by the effect of heat; an electron transfer-type radical generator capable of generating a radical by receiving an excited electron; and an electron transfer-type radical generator capable of undergoing electron transfer to an excited infrared absorbent and generating a radical. Examples thereof include an onium salt, an active halogen compound, an oxime ester compound and a borate compound. Two or more of these compounds may be used in combination. In the present invention, an onium salt is preferred, and a sulfonium salt is more preferred.

Examples of the sulfonium salt polymerization initiator which is suitably used in the present invention include an onium salt represented by the following formula (b-1):

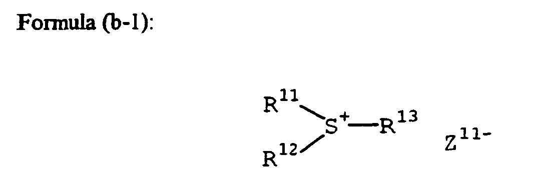

In formula (b-1), R¹¹, R¹² and R¹³, which may be the same or different, each represents a hydrocarbon group having 20 or less carbon atoms, which may have a substituent. Preferred examples of the substituent include a halogen atom, a nitro group, an alkyl group having 12 or less carbon atoms, an alkoxy group having 12 or less carbon atoms, and an aryloxy group having 12 or less carbon atoms. (Z¹¹) represents a counter ion selected from the group consisting of halogen ion, perchlorate ion, tetrafluoroborate ion, hexafluorophosphate ion, carboxylate ion and sulfonate ion, and this is preferably perchlorate ion, hexafluorophosphate ion, carboxylate ion or arylsulfonate ion.

Specific examples of the onium salt represented by formula (b-1) ([OS-1] to [OS-12]) are set forth below, but the present invention is not limited thereto.

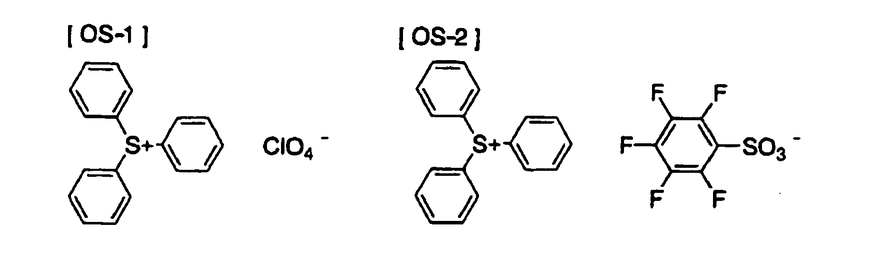

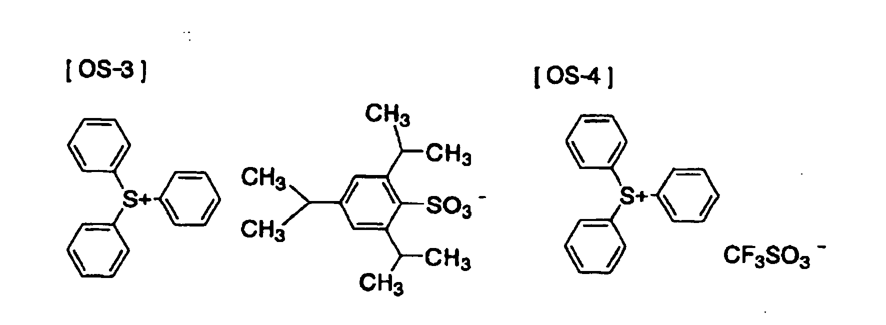

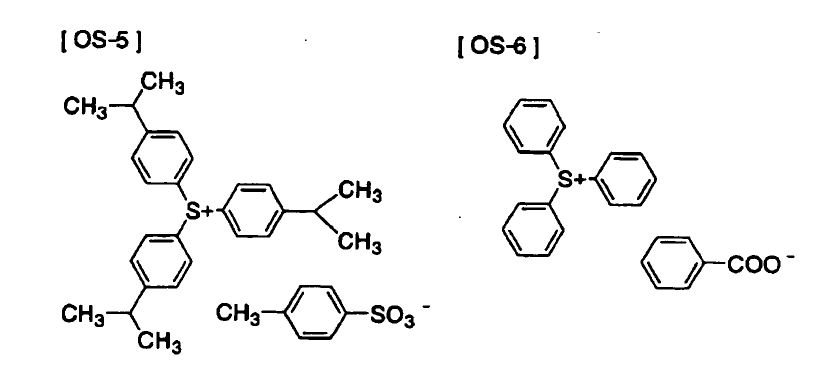

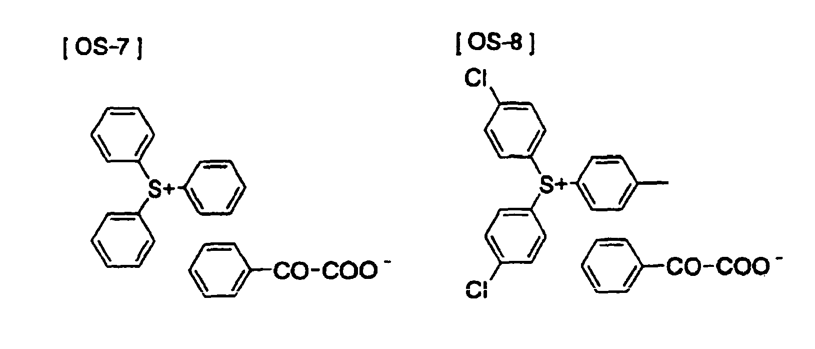

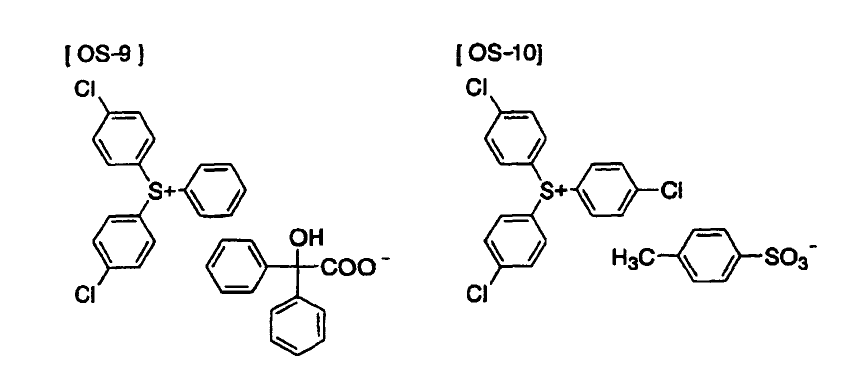

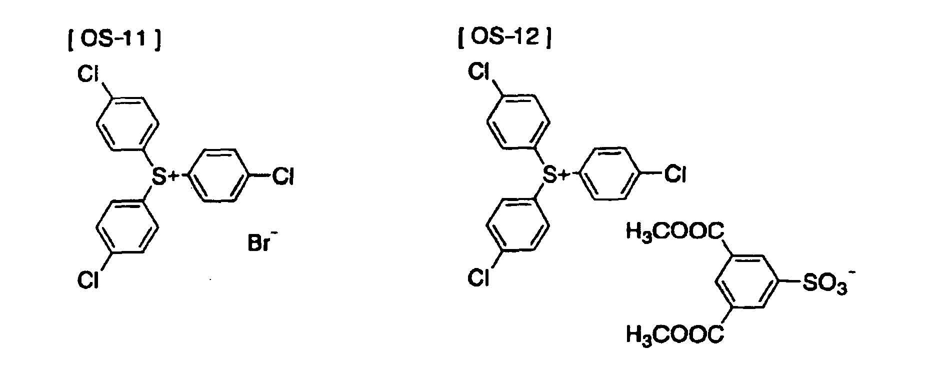

Other than those described above, specific aromatic sulfonium salts described in JP-A-2002-148790, JP-A-2002-148790, JP-A-2002-350207 and JP-A-2002-6482 are also suitably used.

In the present invention, a polymerization initiator (other radical generator) other than the sulfonium salt polymerization initiator may be used. Examples of the other radical generator include an onium salt except for the sulfonium salt, a triazine compound having a trihalomethyl group, a peroxide, an azo-type polymerization initiator, an azide compound, a quinonediazide, an active halogen compound, an oxime ester compound and a triaryl monoalkyl borate compound. Among these, an onium salt is preferred because of its high sensitivity. Also, such a polymerization initiator (radical generator) may be used in combination with the sulfonium salt polymerization initiator which is used as the main component.

The other onium salt which can be suitably used in the present invention includes an iodonium salt and a diazonium salt. Such an onium salt functions not as an acid generator but as a radical polymerization initiator.

Examples of the other onium salt for use in the present invention include onium salts represented by the following formulae (b-2) and (b-3):

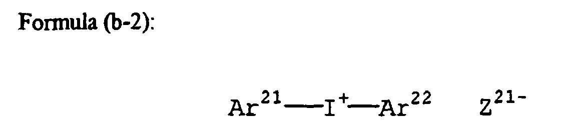

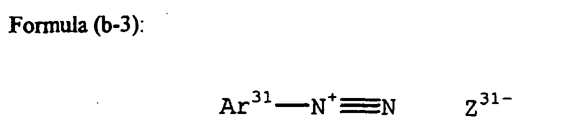

In formula (b-2), Ar²¹ and Ar²² each independently represents an aryl group having 20 or less carbon atoms, which may have a substituent. When the aryl group has a substituent, preferred examples of the substituent include a halogen atom, a nitro group, an alkyl group having 12 or less carbon atoms, an alkoxy group having 12 or less carbon atoms, and an aryloxy group having 12 or less carbon atoms. (Z²¹)⁻ represents a counter ion having the same meaning as (Z¹¹)⁻.

In formula (b-3), Ar³¹ represents an aryl group having 20 or less carbon atoms, which may have a substituent. Preferred examples of the substituent include a halogen atom, a nitro group, an alkyl group having 12 or less carbon atoms, an alkoxy group having 12 or less carbon atoms, an aryloxy group having 12 or less carbon atoms, an alkylamino group having 12 or less carbon atoms, a dialkylamino group having 12 or less carbon atoms, an arylamino group having 12 or less carbon atoms, and a diarylamino group having 12 or less carbon atoms. (Z³¹)⁻ represents a counter ion having the same meanings as (Z¹¹)⁻.

Specific examples of the onium salt represented by formula (b-2) ([OI-1] to [OI-10]) and the onium salt represented by formula (b-3) ([ON-1] to [ON-5]), which can be suitably used in the present invention, are set forth below, but the present invention is not limited thereto.

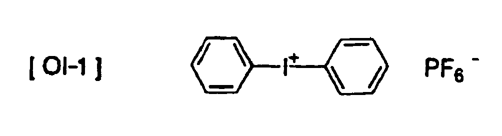

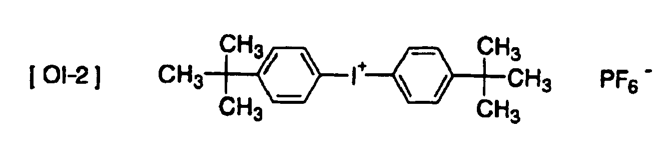

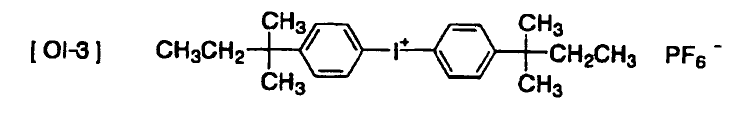

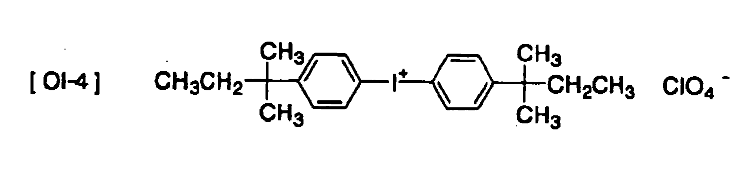

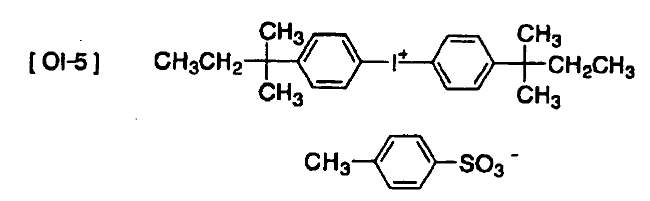

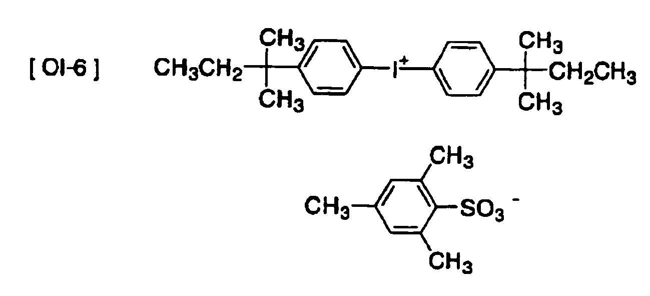

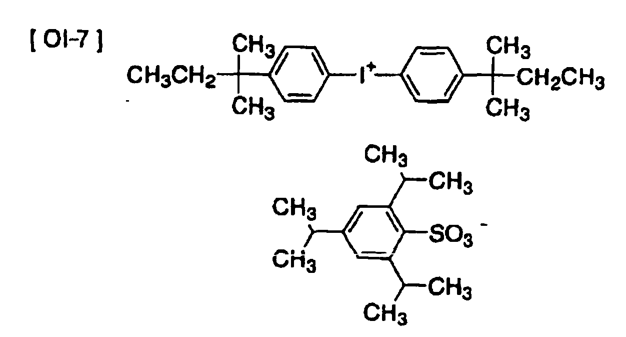

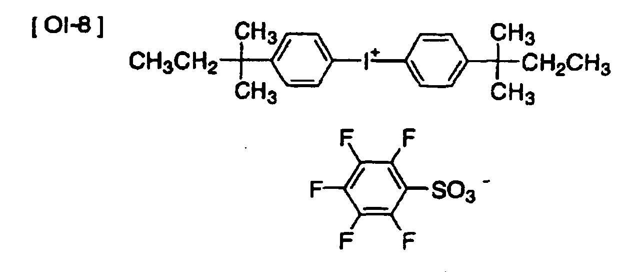

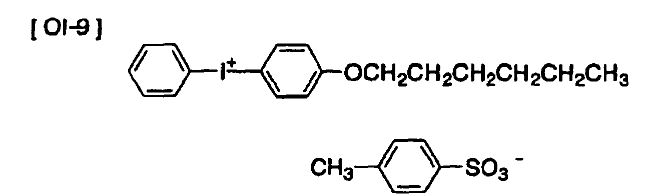

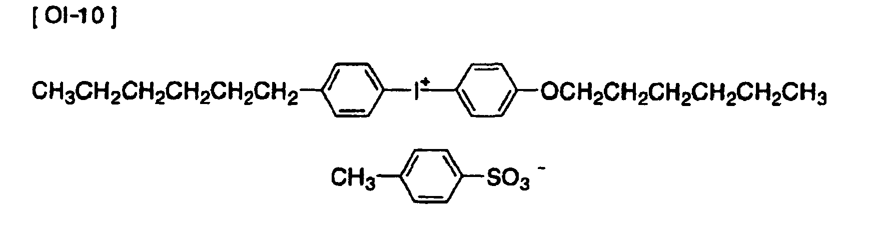

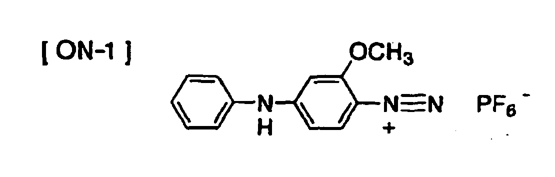

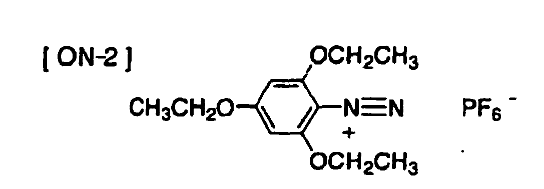

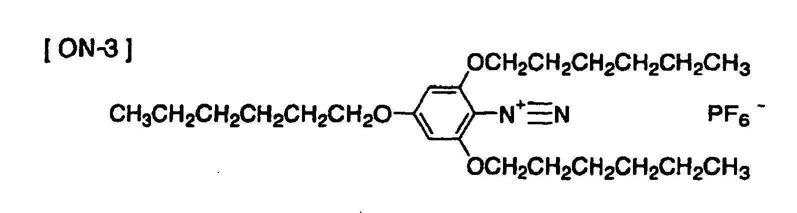

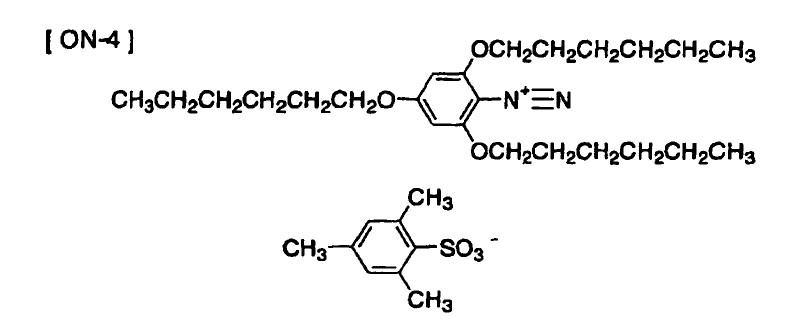

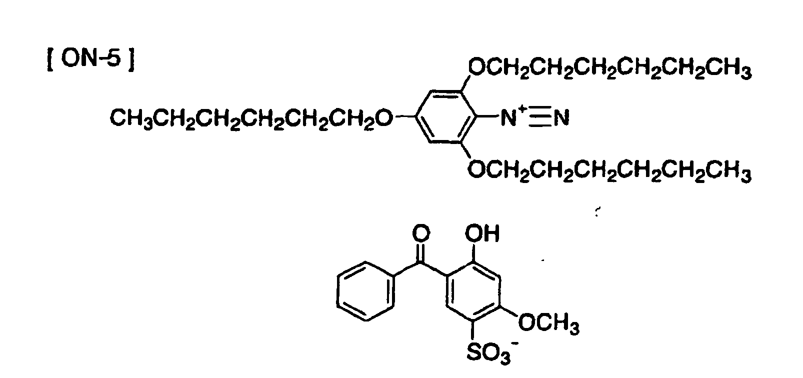

Specific examples of the onium salt which can be suitably used as the polymerization initiator (T) (radical generator) in the present invention include those described in JP-A-2001-133969.

The polymerization initiator (T) (radical generator) for use in the present invention preferably has a maximum absorption wavelength of 400 nm or less, more preferably 360 nm or less. By specifying the absorption wavelength in this way to the ultraviolet region, the lithographic printing plate precursor can be handled under white light.

In the present invention, from the standpoint of sensitivity and generation of staining in the non-image area at printing, the total content of the polymerization initiator (T) is from 0.1 to 50 mass%, preferably from 0.5 to 30 mass%, more preferably from 1 to 20 mass%, based on all solid contents constituting the photosensitive layer.

With respect to the polymerization initiator (T) for use in the present invention, one polymerization initiator may be used alone, or two or more polymerization initiators may be used in combination. In the case of using two or more polymerization initiators in combination, a plurality of only suitably usable sulfonium salt polymerization initiators may be used, or a sulfonium salt polymerization initiator and another polymerization initiator may be used in combination.

In the case of using a sulfonium salt polymerization initiator and another polymerization initiator in combination, the content ratio (by mass) thereof is preferably from 100/1 to 100/50, more preferably from 100/5 to 100/25.

Also, the polymerization initiator (T) may be added together with other components in the same layer or may be added in a layer separately provided.

In the case where a high-sensitivity sulfonium salt polymerization initiator preferred as the polymerization initiator (T) is used in the photosensitive layer of the present invention, a radical polymerization reaction effectively proceeds, and the formed image area can have very high strength. Accordingly, combined with the high oxygen-blocking function of the protective layer described later, a lithographic printing plate having a high image area strength can be produced. As a result, the press life is more enhanced. The sulfonium salt polymerization initiator itself has excellent aging stability and this is advantageous in that even when the produced lithographic printing plate precursor is stored, occurrence of an undesired polymerization reaction can be effectively suppressed.

### [Infrared Absorbent]

In the thermal system of the present invention, the photosensitive composition contains an infrared absorbent so that an energy transfer function (electron transfer), a light-to-heat converting function or the like can be exerted.

The infrared absorbent brings about an electron excited state with high sensitive upon irradiation (exposure) by an infrared laser and this is useful in that electron transfer, energy transfer, heat generation (light-to-heat converting function) and the like promoted in such an electron excited state acts on a polymerization initiator and the polymerization initiator is caused to undergo chemical change with high sensitivity and generate a radical.

The infrared absorbent for use in the present invention is preferably a dye or pigment having absorption maximum in the wavelength range from 750 to 1,400 nm.

As for the dye, commercially available dyes and known dyes, for example, those described in publications such as Senryo Binran (Handbook of Dyes), compiled by The Society of Synthetic Organic Chemistry, Japan (1970) may be used. Specific examples thereof include a dye such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Preferred examples of the dye include cyanine dyes described in JP-A-58-125246, JP-A-59-84356 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 may also be preferably used. Other preferred examples of the dye include near infrared absorbing dyes represented by formulae (I) and (II) of U.S. Patent 4,756,993.

Also, other preferred examples of the infrared absorbing coloring matter for use in the present invention include specific indolenine cyanine dyes described in Japanese Patent Application Nos. 2001-6326 and 2001-237840, such as those shown below.

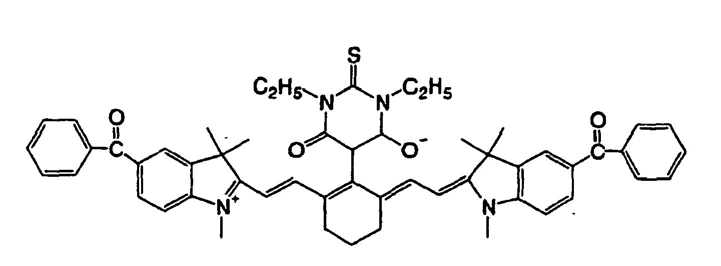

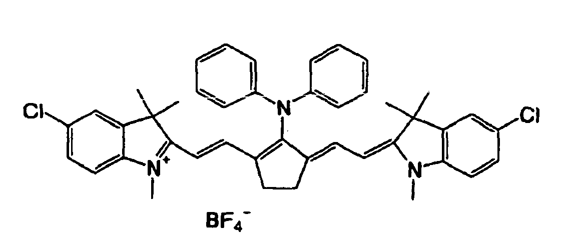

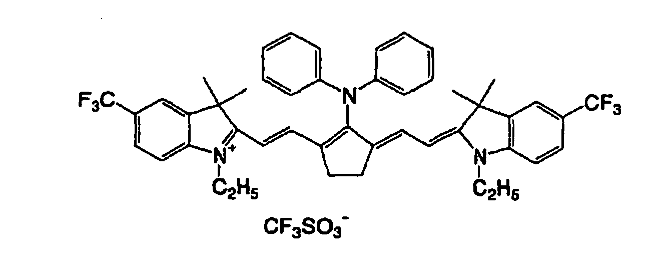

Among these dyes, preferred are a cyanine dye, a squarylium dye, a pyrylium salt, a nickel thiolate complex and an indolenine cyanine dye, more preferred are a cyanine dye and an indolenine cyanine dye, and still more preferred is a cyanine dye represented by the following formula (i):

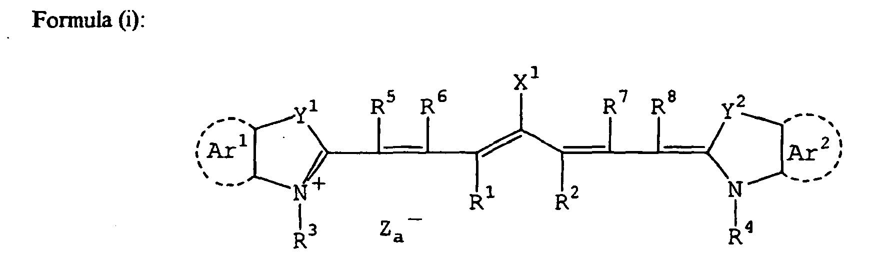

In formula (i), X¹ represents a hydrogen atom, a halogen atom, -NPh₂, X²-L¹ or a group shown below (wherein X² represents an oxygen atom, a nitrogen atom or a sulfur atom, L¹ represents a hydrocarbon group having from 1 to 12 carbon atoms, an aromatic ring having a heteroatom, or a hydrocarbon group having from 1 to 12 carbon atoms and containing a heteroatom (the heteroatom as used herein indicates N, S, O, a halogen atom or Se), Xₐ⁻ has the same definition as Zₐ⁻ described later, and R^{a} represents a substituent selected from a hydrogen atom, an alkyl group, an aryl group, a substituted or unsubstituted amino group and a halogen atom).

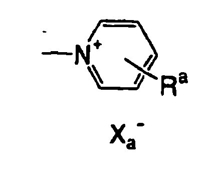

R¹ and R² each independently represents a hydrocarbon group having from 1 to 12 carbon atoms. In view of storage stability of the coating solution for the photosensitive layer, R¹ and R² each is preferably a hydrocarbon group having 2 or more carbon atoms, and R¹ and R² are more preferably combined with each other to form a 5- or 6-membered ring.

Ar¹ and Ar², which may be the same or different, each represents an aromatic hydrocarbon group which may have a substituent. Preferred examples of the aromatic hydrocarbon group include a benzene ring and a naphthalene ring. Preferred examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent, and preferred examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms and in view of availability of the raw material, preferably a hydrogen atom. Zₐ⁻ represents a counter anion but when the cyanine dye represented by formula (i) has an anionic substituent in its structure and the neutralization of electric charge is not necessary, Zₐ⁻ is not present. In view of storage stability of the coating solution for the photosensitive layer, Zₐ⁻ is preferably halogen ion, perchlorate ion, tetrafluoroborate ion, hexafluorophosphate ion or sulfonate ion, more preferably perchlorate ion, hexafluorophosphate ion or arylsulfonate ion.

Specific examples of the cyanine dye represented by formula (i), which can be suitably used in the present invention, include those described in paragraphs [0017] to [0019] of JP-A-2001-133969.

Other preferred examples include specific indolenine cyanine dyes described in Japanese Patent Application Nos. 2001-6326 and 2001-237840 *supra.*

However, a cyanine dye not containing halogen ion as the counter ion is preferred.

As for the pigment used in the present invention, commercially available pigments and pigments described in Color Index (C.I.) Binran (C.I. Handbook), Saishin Ganryo Binran (Handbook of Latest Pigments), compiled by Nippon Ganryo Gijutsu Kyokai (1977), Saishin Ganryo Oyo Gijutsu (Latest Pigment Application Technology), CMC Shuppan (1986), and Insatsu Ink Gijutsu (Printing Ink Technology), CMC Shuppan (1984) can be used.

The kind of the pigment includes a black pigment, a yellow pigment, an orange pigment, a brown pigment, a red pigment, a violet pigment, a blue pigment, a green pigment, a fluorescent pigment, a metal powder pigment and a polymer bond coloring matter. Specific examples of the pigment which can be used include an insoluble azo pigment, an azo lake pigment, a condensed azo pigment, a chelate azo pigment, a phthalocyanine-based pigment, an anthraquinone-based pigment, a perylene- or perynone-based pigment, a thioindigo-based pigment, a quinacridone-based pigment, a dioxazine-based pigment, an isoindolinone-based pigment, a quinophthalone-based pigment, a dyed lake pigment, an azine pigment, a nitroso pigment, a nitro pigment, a natural pigment, a fluorescent pigment, an inorganic pigment and carbon black. Among these pigments, carbon black is preferred.

Such a pigment may or may not be surface-treated before use. Examples of the method for surface treatment include a method of coating the surface with resin or wax, a method of attaching a surfactant, and a method of binding a reactive substance (for example, a silane coupling agent, an epoxy compound or an isocyanate) to the pigment surface. These surface-treating methods are described in Kinzoku Sekken no Seishitsu to Oyo (Properties and Application of Metal Soap), Saiwai-Shobo, Insatsu Ink Gijutsu (Printing Ink Technology), CMC Shuppan (1984), and Saishin Ganryo Oyo Gijutsu (Latest Pigment Application Technology), CMC Shuppan (1986).

The particle diameter of the pigment is preferably from 0.01 to 10 µm, more preferably from 0.05 to 1 µm, still more preferably from 0.1 to 1 µm. Within this preferred particle diameter range, excellent dispersion stability of the pigment in the photosensitive layer can be obtained and a uniform photosensitive layer can be formed.

As for the method of dispersing the pigment, a known dispersion technique employed in the production of ink or toner may be used. Examples of the disperser include an ultrasonic disperser, a sand mill, an attritor, a pearl mill, a super-mill, a ball mill, an impeller, a disperser, a KD mill, a colloid mill, a dynatron, a three-roll mill and a pressure kneader. These are described in detail in Saishin Ganryo Oyo Gijutsu (Latest Pigment Application Technology), CMC Shuppan (1986).

In the case of using such an infrared absorbent to the photosensitive layer according to the present invention, the infrared absorbent may be added together with other components in the same layer or may be added to a layer provided separately.

In view of uniformity in the photosensitive layer or durability of the photosensitive layer, the infrared absorbent may be added in a proportion of 0.01 to 50 mass%, preferably from 0.1 to 10 mass%, based on all solid contents constituting the photosensitive layer. The proportion of the infrared absorbent added is more preferably from 0.5 to 10 mass% in the case of a dye and from 0.1 to 10 mass% in the case of a pigment.

### [Binder Polymer]

In the present invention, a binder polymer is preferably used for enhancing the film properties or developability of the photosensitive layer.

The binder polymer for use in the present invention includes an alkali-soluble or swelling binder. The alkali-soluble or swelling binder is required not only to function as a film-forming agent of the composition but also to dissolve in an alkali developer and therefore, an organic high-molecular polymer soluble in or swellable with an alkali developer is used. For example, when a water-soluble organic high-molecular polymer is used as the organic high-molecular polymer, water development becomes possible. Examples of such an organic high-molecular polymer include an addition polymer having a carboxylic acid group in the side chain, such as those described in JP-A-59-44615, JP-B-54-34327, JP-B-58-12577, JP-B-54-25957, JP-A-54-92723, JP-A-59-53836 and JP-A-59-71048, that is, a methacrylic acid copolymer, an acrylic acid copolymer, an itaconic acid copolymer, a crotonic acid copolymer, a maleic acid copolymer and a partially esterified maleic acid copolymer.

Also, an acidic cellulose derivative similarly having a carboxyl group in the side chain may be used. In addition, for example, those obtained by adding a cyclic acid anhydride to a hydroxyl group-containing addition polymer are useful.

Among these, a [benzyl (meth)acrylate/(meth)acrylic acid/if desired, another addition-polymerizable vinyl monomer] copolymer and an [allyl (meth)acrylate/(meth)acrylic acid/if desired, another addition-polymerizable vinyl monomer] copolymer are preferred.

Other than these, polyvinylpyrrolidone, polyethylene oxide and the like are useful as the water-soluble high-molecular polymer. Also, for the purpose of elevating the strength of cured film, an alcohol-soluble polyamide and a polyether of 2,2-bis(4-hydroxyphenyl)propane and epichlorohydrin are useful. Furthermore, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful for the usage of the present invention.

In particular, a polymer having a (meth)acrylic or urethane structural unit is preferred.

In the organic high-molecular polymer, when a radical reactive group (crosslinking group) is introduced into the side chain, the strength of cured film can be enhanced. Examples of the functional group capable of undergoing an addition polymerization reaction include an ethylenically unsaturated bond group, an amino group and an epoxy group; examples of the functional group capable of becoming a radical upon irradiation with light include a mercapto group, a thiol group, a halogen atom, a triazine structure and an onium salt structure; and examples of the polar group include a carboxyl group and an imido group. The functional group capable of undergoing an addition polymerization reaction is preferably an ethylenically unsaturated bond group such as acrylic group, methacrylic group, allyl group and styryl group, but a functional group selected from an amino group, a hydroxy group, a phosphonic acid group, a phosphoric acid group, a carbamoyl group, an isocyanate group, a ureido group, a ureylene group, a sulfonic acid group and an ammonio group is also useful.

A polymer having a (meth)acrylic or urethane structural unit and having a crosslinking group in the side chain is preferred.

The binder polymer for use in the present invention preferably has crosslinking property so as to enhance the film strength of the image area. The crosslinking property may be imparted to the binder polymer by introducing a crosslinking functional group such as ethylenically unsaturated bond into the main or side chain of the polymer. The crosslinking functional group may be introduced by copolymerization or by a polymer reaction.

The crosslinking group as used herein means a group capable of crosslinking a polymer binder in the process of a radical polymerization reaction occurring in the photosensitive layer when the lithographic printing plate precursor is exposed. The crosslinking group is not particularly limited as long as it has such a function, but examples of the functional group capable of undergoing an addition-polymerization reaction include an ethylenically unsaturated bond group, an amino group and an epoxy group. The crosslinking group may also be a functional group which can be converted into a radical upon irradiation with light, and examples of such a crosslinking group include a thiol group, a halogen group and an onium salt group. Among these, an ethylenically unsaturated bond group is preferred, and a functional group represented by any one of the following formulae (1) to (3) is more preferred.

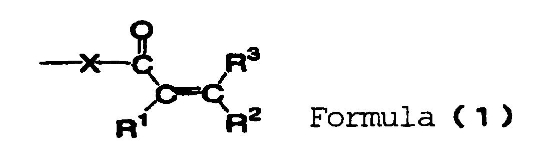

In formula (1), R¹ to R³ each independently represents a hydrogen atom or a monovalent organic group. R¹ is preferably, for example, a hydrogen atom or an alkyl group which may have a substituent, and because of high radical reactivity, more preferably a hydrogen atom or a methyl group. R² and R³ each is independently, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and because of high radical reactivity, preferably a hydrogen atom, a carboxyl group, an alkoxycarbonyl group, an alkyl group which may have a substituent, or an aryl group which may have a substituent.

X represents an oxygen atom, a sulfur atom or -N(R¹²)-, and R¹² represents a hydrogen atom or a monovalent organic group. R¹² is, for example, an alkyl group which may have a substituent, and because of high radical reactivity, preferably a hydrogen atom, a methyl group, an ethyl group or an isopropyl group.

Examples of the substituent which can be introduced here include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

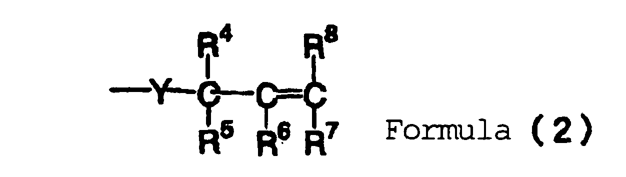

In formula (2), R⁴ to R⁸ each independently represents a monovalent organic group. R⁴ to R⁸ each is preferably, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, preferably a hydrogen atom, a carboxyl group, an alkoxycarbonyl group, an alkyl group which may have a substituent, or an aryl group which may have a substituent.

Examples of the substituent which can be introduced are the same as those in formula (1). Y represents an oxygen atom, a sulfur atom or N(R¹²)-. R¹² has the same meaning as R¹² in formula (1), and preferred examples thereof are also the same.

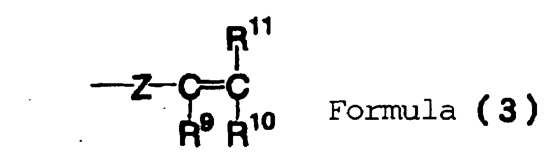

In formula (3), R⁹ is preferably, for example, a hydrogen atom or an alkyl group which may have a substituent, and because of high radical reactivity, more preferably a hydrogen atom or a methyl group. R¹⁰ and R¹¹ each is independently, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and because of high radical reactivity, preferably a hydrogen atom, a carboxyl group, an alkoxycarbonyl group, an alkyl group which may have a substituent, or an aryl group which may have a substituent.

Examples of the substituent which can be introduced here are the same as those in formula (1). Z represents an oxygen atom, a sulfur atom, -N(R¹³)- or a phenylene group which may have a substituent. R¹³ is, for example, an alkyl group which may have a substituent, and because of high radical reactivity, preferably a methyl group, an ethyl group or an isopropyl group.

The polymer binder having a crosslinking group in the side chain for use in the present invention is required not only to function as a film-forming agent of the photosensitive layer but also to dissolve in a developer, preferably in an alkali developer, and therefore, an organic high-molecular polymer soluble in or swellable with an alkali developer is preferred. In this meaning, the polymer binder for use in the present invention preferably contains an alkali-soluble group such as carboxyl group in the side chain, in addition to the crosslinking group.

When the polymer binder having a crosslinking group in the side chain is a water-soluble organic high-molecular polymer, water development can be performed.

Examples of the polymer binder for use in the present invention include those described in JP-A-59-53836 and JP-A-59-71048, that is, a (meth)acrylic acid copolymer, an itaconic acid copolymer, a crotonic acid copolymer, a maleic acid copolymer and a partially esterified maleic acid copolymer each having a crosslinking group such as allyl group and (meth)acryloyl group in the side chain.

Also, for example, a polyurethane or acidic cellulose derivative having the above-described crosslinking group and a carboxyl group in the side chain, and a polymer resulting from addition of a cyclic acid anhydride to a hydroxyl group-containing addition polymer are useful as the polymer binder for use in the present invention.

Among these, a (meth)acrylic acid copolymer and a polyurethane are preferred, and a polyurethane resin is more preferred because even when the acid value of the photosensitive layer is low, the exposed area can be reduced in the development damage without decreasing the developability of the unexposed area, and both good anti-staining property and high press life can be obtained.

The polyurethane resin having a crosslinking group in the side chain is described in detail below.

The polyurethane resin having a crosslinking group in the side chain, which is preferably used in the present invention, may be obtained through a polyaddition reaction of (i) a diisocyanate compound, (ii) a diol compound having a carboxyl group, (iii) a diisocyanate compound having a crosslinking group and if desired, (iv) a diol compound having no carboxyl group.

The diisocyanate compound and the diol compound as raw materials of the polyurethane resin are described below.

### (i) Diisocyanate Compound

Examples of the diisocyanate compound include a diisocyanate compound represented by formula (4):

OCN-L-NCO (4)

wherein L represents a divalent aliphatic or aromatic hydrocarbon group which may have a substituent. If desired, L may contain another functional group which does not react with the isocyanate group, such as carbonyl group, ester group, urethane group, amido group and ureido group. More specifically, L represents a single bond or a divalent aliphatic or aromatic hydrocarbon group which may have a substituent (preferably, for example, an alkyl group, an aralkyl group, an aryl group, an alkoxy group or a halogeno group), preferably an alkylene group having a carbon number of 1 to 20 or an allylene group having a carbon number of 6 to 15, more preferably an alkylene group having a carbon number of 1 to 8. Also, if desired, L may contain another functional group which does not react with the isocyanate group, such as carbonyl group, ester group, urethane group, amido group, ureido group and ether group.

Specific examples of the diisocyanate compound include the followings: an aromatic diisocyanate compound such as 2,4-tolylene diisocyanate, dimerized 2,4-tolylene diisocyanate, 2,6-tolylene diisocyanate, p-xylylene diisocyanate, m-xylylene diisocyanate, 4,4'-diphenylmethane diisocyanate, 1,5-naphthylene diisocyanate and 3,3'-dimethylbiphenyl-4,4'-diisocyanate; an aliphatic diisocyanate compound such as hexamethylene diisocyanate, trimethylhexamethylene diisocyanate, lysine diisocyanate and dimeric acid diisocyanate; an alicyclic diisocyanate compound such as isophorone diisocyanate, 4,4'-methylenebis(cyclohexylisocyanate), methylcyclohexane-2,4(or 2,6)-diisocyanate and 1,3-(isocyanatomethyl)cyclohexane; and a diisocyanate compound which is a reaction product of a diol with a diisocyanate, such as an adduct of 1,3-butylene glycol (1 mol) and tolylene diisocyanate (2 mol).

One of these diisocyanate compounds may be used alone or two or more thereof may be used in combination. In view of balance between press life and anti-staining property, two or more kinds of diisocyanate compound are preferably used in combination, and it is preferred to use at least one aromatic diisocyanate compound (L is an aromatic group) and at least one aliphatic diisocyanate compound (L is an aliphatic group).

The amount of diisocyanate used is, in terms of the molar ratio to the diol compound, preferably from 0.8 to 1.2, more preferably from 0.9 to 1.1. In the case where a diisocyanate compound is used in excess with respect to the diol compound and an isocyanate group remains at the polymer terminal, the urethane after the completion of reaction is preferably treated with alcohols, amines or the like so as to finally allow for no remaining of an isocyanate group.

### (ii) Diol compound having at least one carboxyl group

Examples of the diol compound having at least one carboxyl group include diol compounds represented by formulae (5), (6) and (7) and/or a compound obtained by ring-opening a tetracarboxylic acid dianhydride with a diol compound. A diol compound used for ring-opening a tetracarboxylic acid dianhydride may be used. 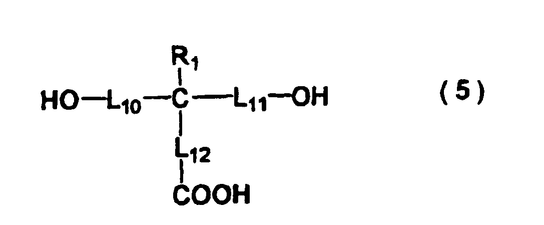 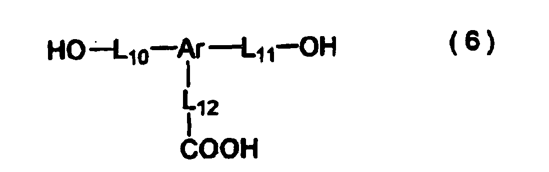 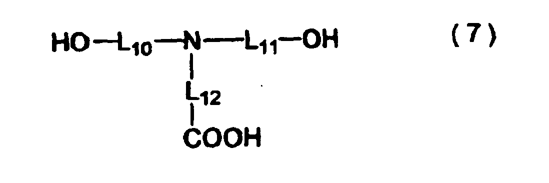 wherein R₁ represents a hydrogen atom or an alkyl, aralkyl, aryl, alkoxy or aryloxy group which may have a substituent (examples of the substituent include a cyano group, a nitro group, a halogen atom (e.g., -F, -Cl, -Br, -I), -CONH₂, -COOR₁₁₃, -OR₁₁₃, -NHCONHR₁₁₃, -NHCOOR₁₁₃, -NHCOR₁₁₃ and -OCONHR₁₁₃ (wherein R₁₁₃ represents an alkyl group having a carbon number of 1 to 10 or an aralkyl group having a carbon number of 7 to 15)), preferably a hydrogen atom, an alkyl group having a carbon number of 1 to 8 or an aryl group having a carbon number of 6 to 15; L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogeno group), preferably an alkylene group having a carbon number of 1 to 20 or an arylene group having a carbon number of 6 to 15, more preferably an alkylene group having a carbon number of 1 to 8, and if desired, L₁₀, L₁₁ and L₁₂ each may contain another functional group which does not react with the isocyanate group, such as carbonyl group, ester group, urethane group, amido group, ureido group and ether group, provided that two or three members out of R₁, L₁₀, L₁₁ and L₁₂ may form a ring together; and Ar represents a trivalent aromatic hydrocarbon group which may have a substituent, preferably an aromatic group having a carbon number of 6 to 15.

Specific examples of the diol compound having a carboxyl group, represented by formula (5), (6) or (7) include:

3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis(hydroxymethyl)butyric acid, 4,4-bis(4-hydroxyphenyl)-pentanoic acid, tartaric acid, N,N-dihydroxyethylglycine and N,N-bis(2-hydroxyethyl)-3-carboxy-propionamide.

Preferred examples of the tetracarboxylic acid dianhydride used for the synthesis of at least one diol compound having at least one carboxyl group include compounds represented by formulae (8), (9) and (10). 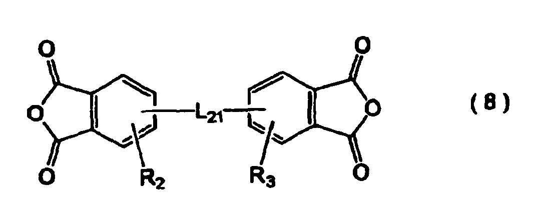 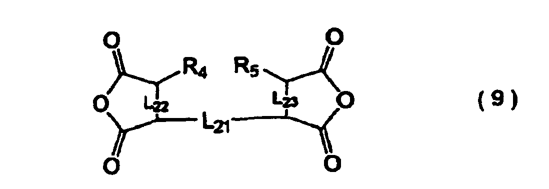 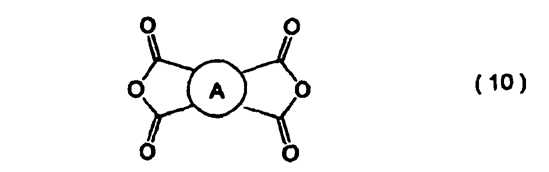 wherein L₂₁ represents a single bond, a divalent aliphatic or aromatic hydrocarbon group which may have a substituent (preferred examples of the substituent include an alkyl group, an aralkyl group, an aryl group, an alkoxy group, a halogeno group, an ester group and an amido group), -CO-, -SO-, -SO₂-, -O- or -S-, preferably a single bond, a divalent aliphatic hydrocarbon group having a carbon number of 1 to 15, -CO-, -SO₂-, -O- or -S-; R₂ and R₃, which may be the same or different, each represents a hydrogen atom, an alkyl group, an aralkyl group, an aryl group, an alkoxy group or a halogeno group, preferably a hydrogen atom, an alkyl group having a carbon number of 1 to 8, an aryl group having a carbon number of 6 to 15, an alkoxy group having a carbon number of 1 to 8 or a halogeno group; two members out of L₂₁, R₂ and R₃ may combine to form a ring; R₄ and R₅, which may be the same or different, each represents a hydrogen atom, an alkyl group, an aralkyl group, an aryl group or a halogeno group, preferably a hydrogen atom, an alkyl group having a carbon number of 1 to 8 or an aryl group having a carbon number of 6 to 15; two members out of L₂₁, R₄ and R₅ may combine to form a ring; L₂₂ and L₂₃, which may be the same or different, each represents a single bond, a double bond or a divalent aliphatic hydrocarbon group, preferably a single bond, a double bond or a methylene group; and A represents a mononuclear or polynuclear aromatic ring, preferably an aromatic ring having a carbon number of 6 to 18.

Specific examples of the compound represented by formula (8), (9) or (10) include the followings:

an aromatic tetracarboxylic dianhydride such as pyromellitic dianhydride, 3,3',4,4'-benzophenonetetracarboxylic dianhydride, 3,3',4,4'-diphenyltetracarboxylic dianhydride, 2,3,6,7-naphthalenetetracarboxylic dianhydride, 1,4,5,8-naphthalenetetracarboxylic dianhydride, 4,4'-sulfonyldiphthalic dianhydride, 2,2-bis(3,4-dicarboxyphenyl)propane dianhydride, bis(3,4-dicarboxyphenyl)ether dianhydride, 4,4'-[3,3'-(alkylphosphoryldiphenylene)-bis-(iminocarbonyl)]diphthalic dianhydride, an adduct of hydroquinone diacetate and trimellitic anhydride, and an adduct of diacetyldiamine and trimellitic anhydride; an alicyclic tetracarboxylic dianhydride such as 5-(2,5-dioxotetrahydrofuryl)-3-methyl-3-cyclobexene-1,2-dicarboxylic anhydride (Epiclon B-4400, produced by Dainippon Ink & Chemicals, Ind.), 1,2,3,4-cyclopentanetetracarboxylic dianhydride, 1,2,4,5-cyclohexanetetracarboxylic dianhydride and tetrahydrofurantetracarboxylic dianhydride; and an aliphatic tetracarboxylic dianhydride such as 1,2,3,4-butanetetracarboxylic dianhydride and 1,2,4,5-pentanetetracarboxylic dianhydride.

Such a tetracarboxylic acid dianhydride is ring-opened with a diol compound, whereby at least one diol compound (ii) having at least one carboxyl group can be synthesized. However, the polyurethane resin for use in the present invention may also be synthesized by first reacting a diol compound and (i) a diisocyanate compound and then reacting this reaction product with the above-described tetracarboxylic acid dianhydride, and this method is included in the aspect of the present invention. That is, the method for introducing a structural unit derived from a tetracarboxylic acid dianhydride and a diol compound, into a polyurethane resin include the following methods:
(a) a method of reacting a diisocyanate compound with an alcohol-terminated compound obtained by ring-opening a tetracarboxylic acid dianhydride with a diol compound, and
(b) a method of reacting a tetracarboxylic acid dianhydride with an alcohol-terminated urethane compound obtained by reacting a diisocyanate compound under a diol compound-excess condition.

The compound represented by formula (5) as at least one diol compound having at least one carboxyl group is preferably highly soluble in a solvent and easy to synthesize. Also, at least one diol compound having at least one carboxyl group is introduced into the polyurethane resin binder such that the polyurethane resin binder contains the carboxyl group in an amount of 0.2 to 4.0 meq/g, preferably from 0.3 to 3.0 meq/g, more preferably from 0.4 to 2.0 meq/g, still more preferably from 0.5 to 1.5 meq/g, and most preferably from 0.6 to 1.2 meq/g. Accordingly, the content of the structure derived from the at least one diol compound having at least one carboxyl group in the polyurethane resin binder is appropriately selected according to the acid value or molecular weight of the polyurethane resin binder obtained, the composition or pH of the developer, or the like, but the content is, for example, from 5 to 45 mol%, preferably from 10 to 40 mol%, more preferably from 15 to 35 mol%.

### (iii) Diisocyanate compound having a crosslinking group

Examples of the diisocyanate compound having a crosslinking group include a reaction product obtained by addition-reacting a triisocyanate compound with one equivalent of a monofunctional alcohol or monofunctional amine compound having a crosslinking group.

Examples of the triisocyanate compound include, but are not limited to, those set forth below.

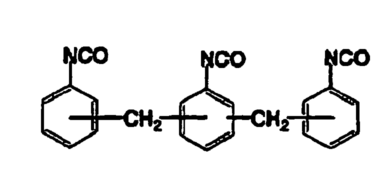

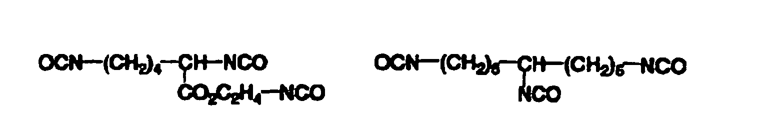

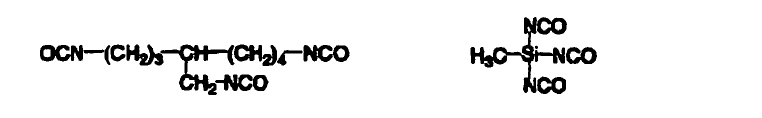

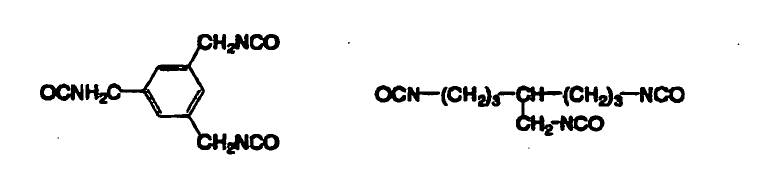

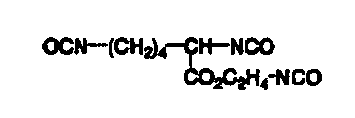

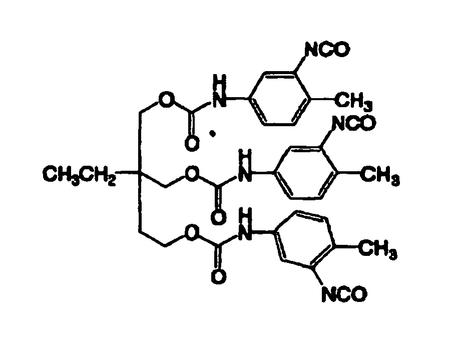

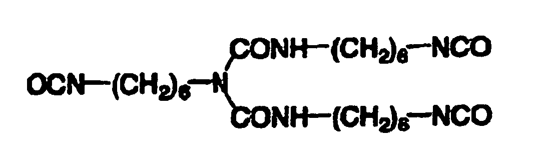

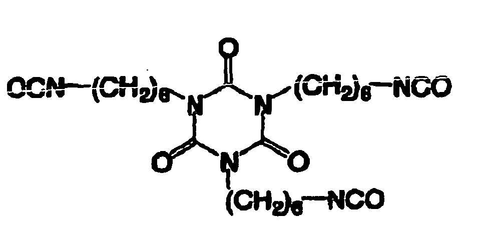

Examples of the monofunctional alcohol or monofunctional amine compound having a crosslinking group include, but are not limited to, those set forth below.

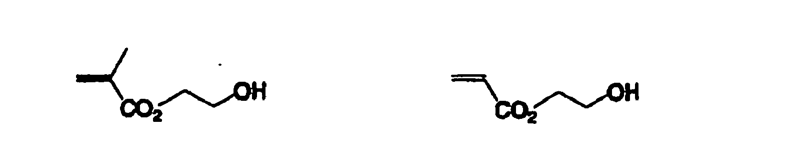

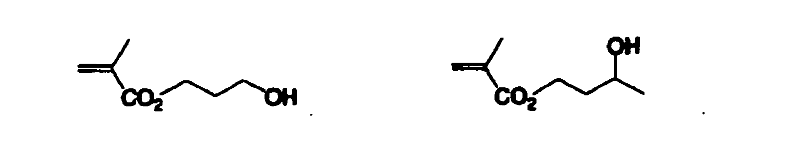

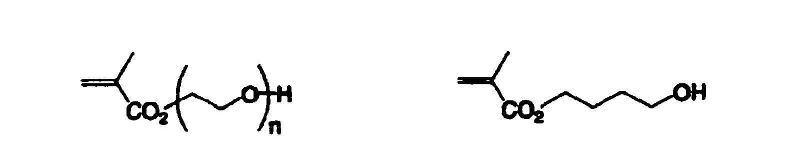

n represents an integer of 2 to 10.

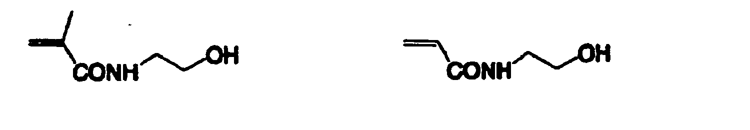

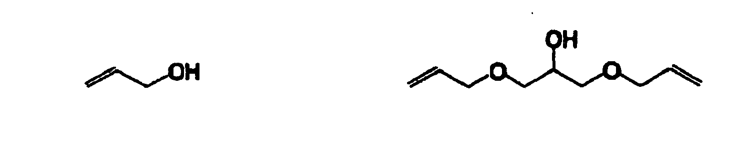

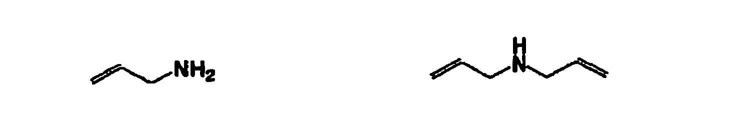

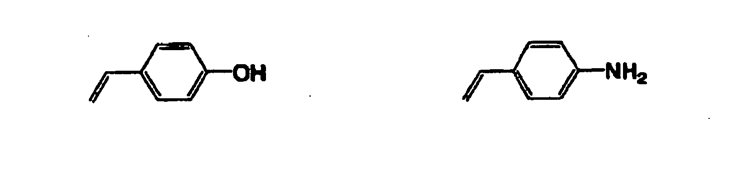

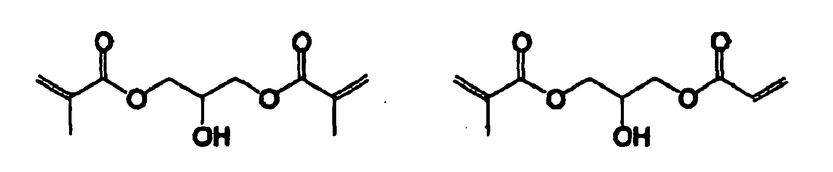

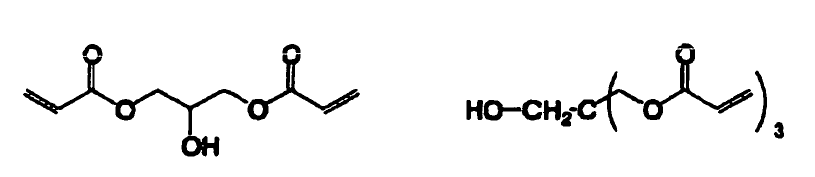

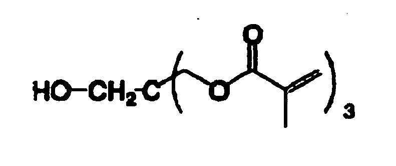

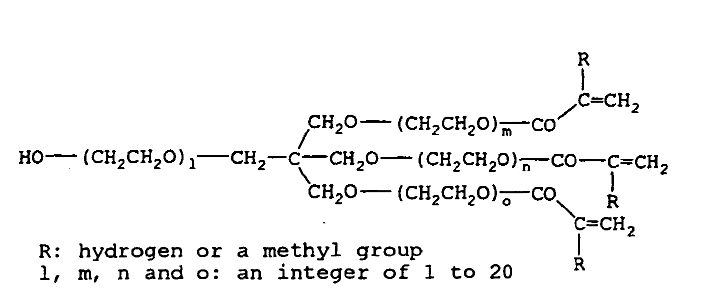

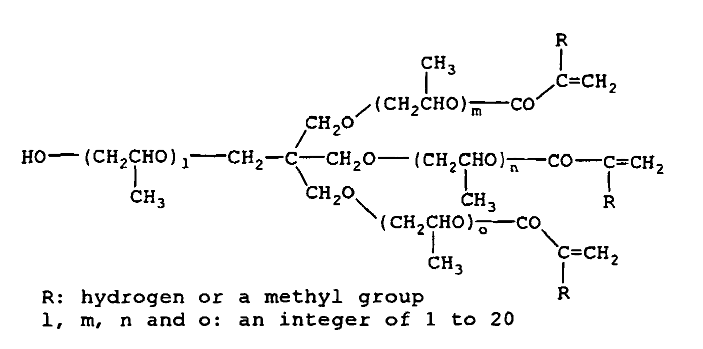

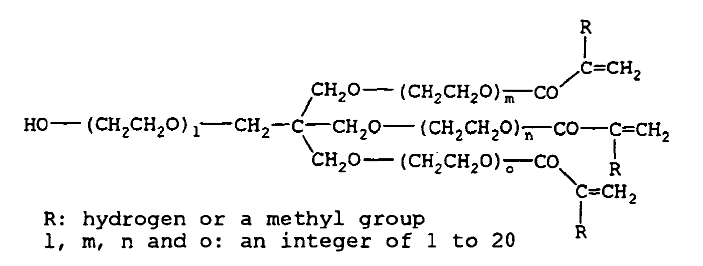

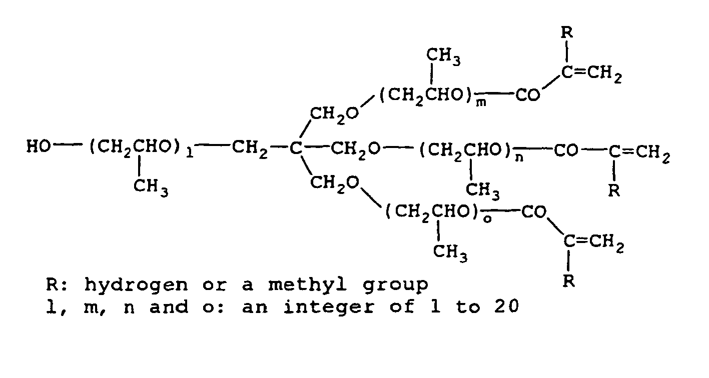

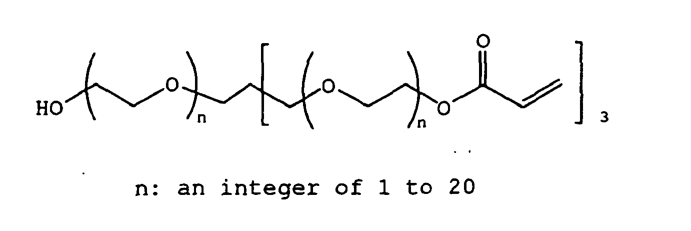

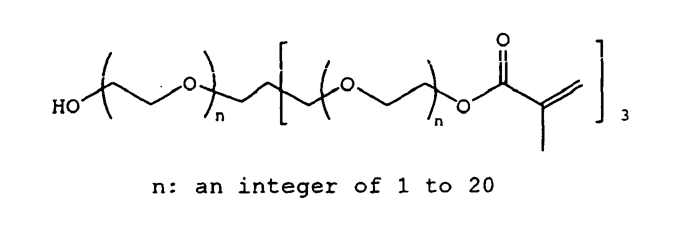

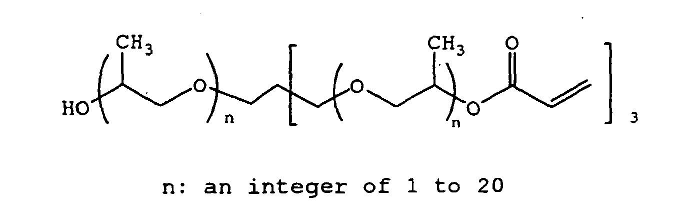

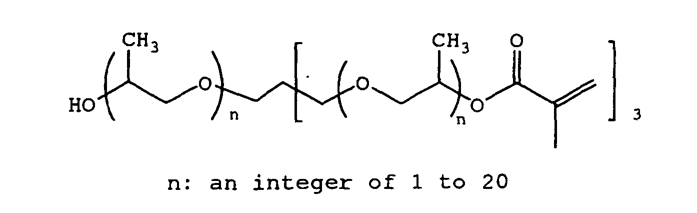

As for the method of introducing a crosslinking group into the side chain of the polyurethane resin, a method where a diisocyanate compound containing a crosslinking group in the side chain is used as a raw material in the production of the polyurethane resin, is preferred. Examples of the diisocyanate compound having a crosslinking group in the side chain, which can be obtained by the addition reaction of a triisocyanate compound with one equivalent of a monofunctional alcohol or monofunctional amine compound having a crosslinking group, include, but are not limited to, those set forth below.

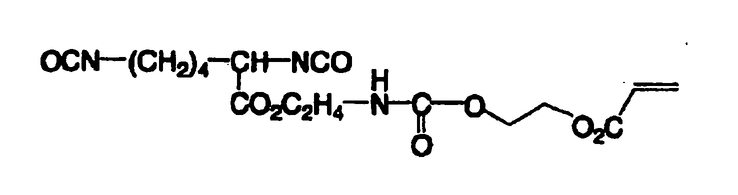

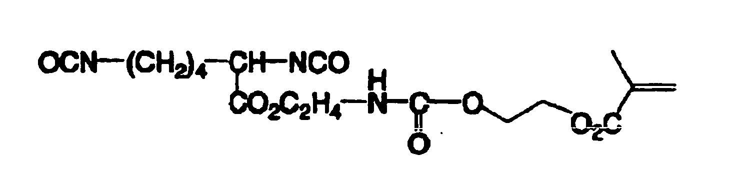

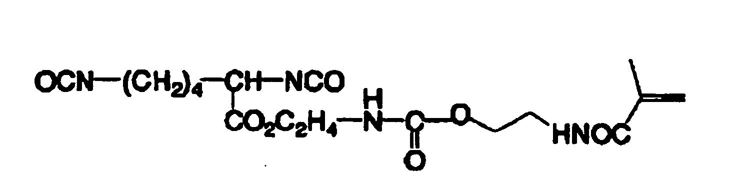

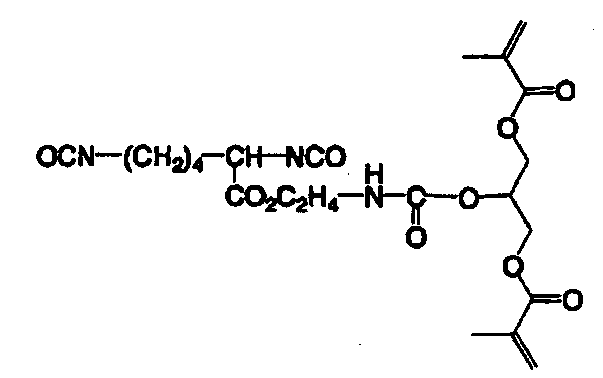

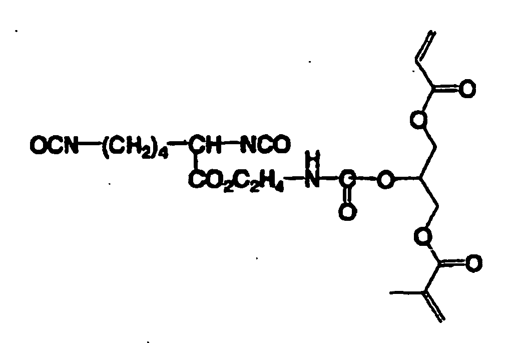

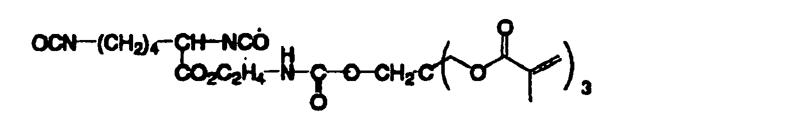

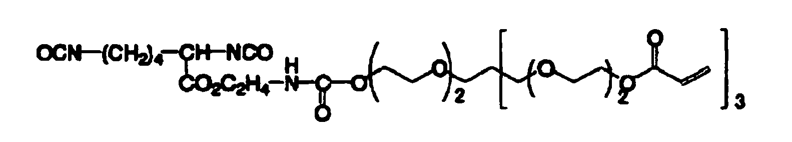

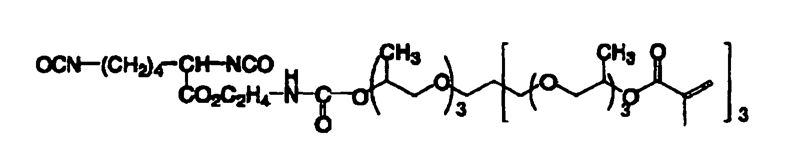

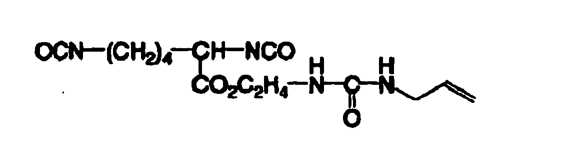

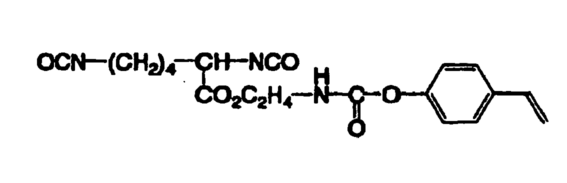

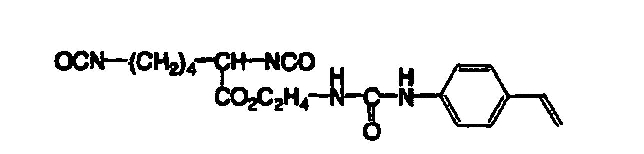

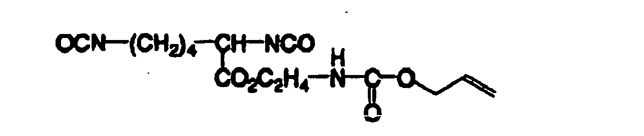

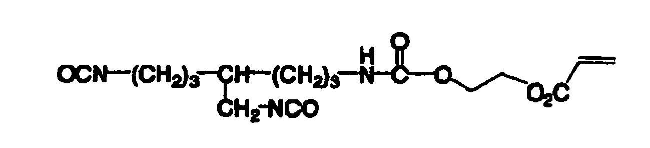

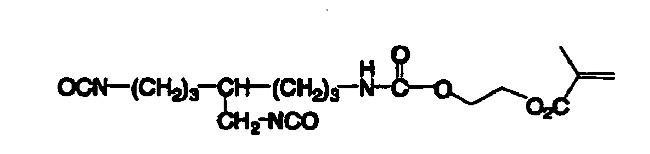

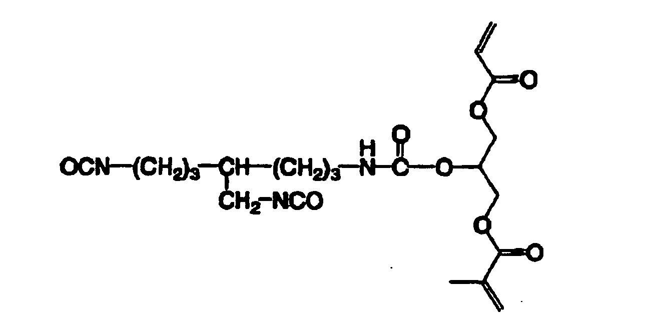

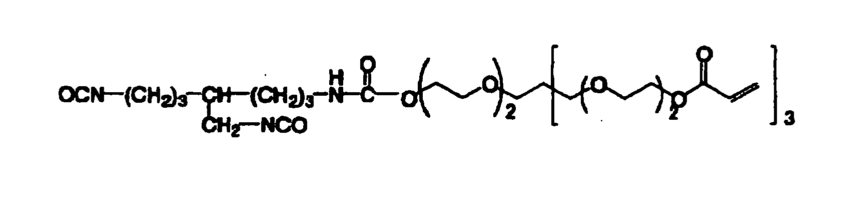

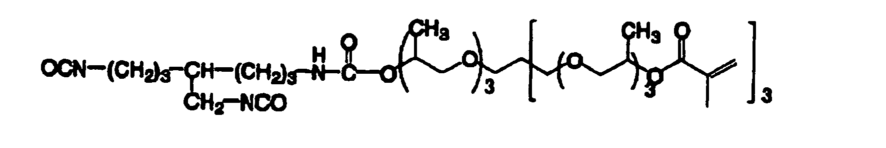

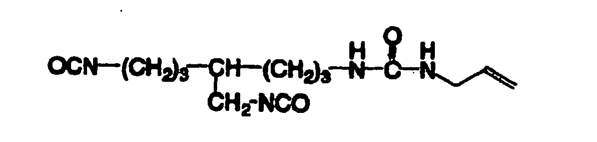

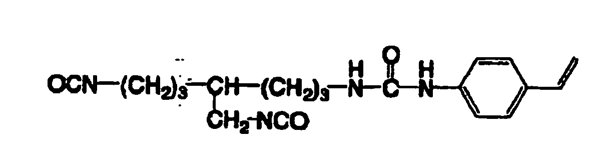

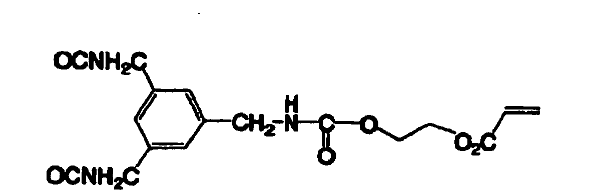

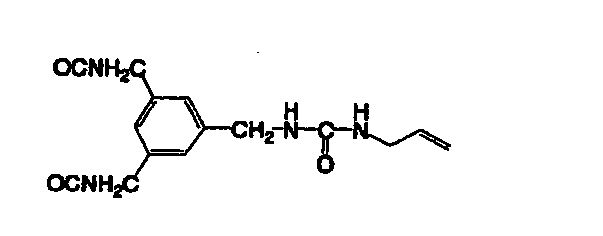

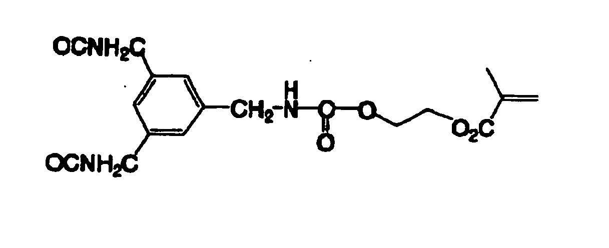

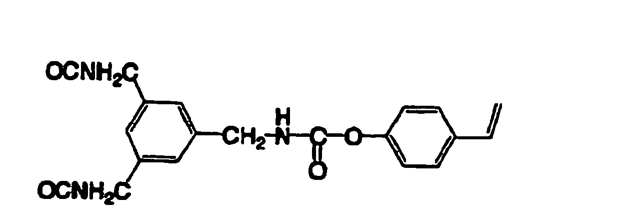

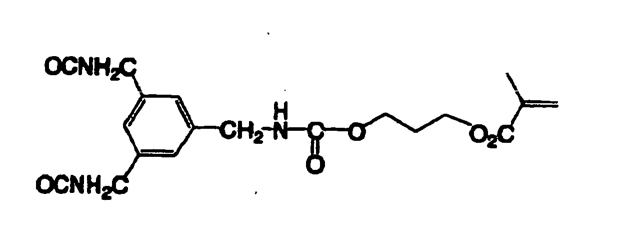

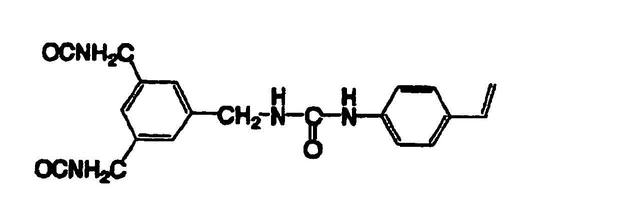

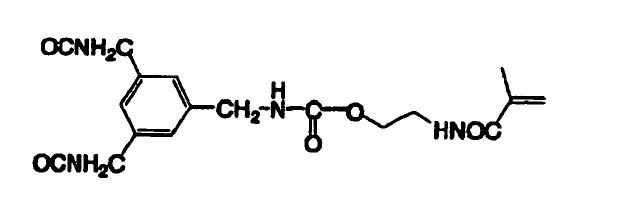

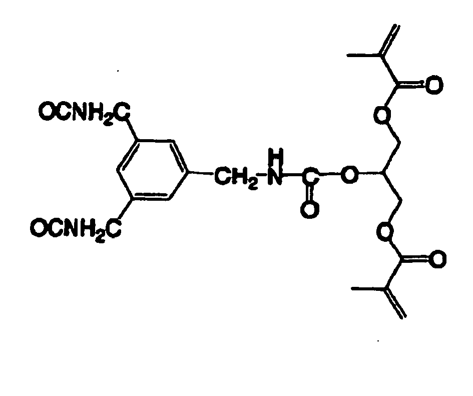

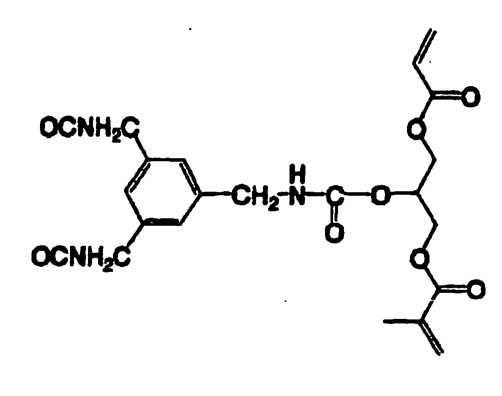

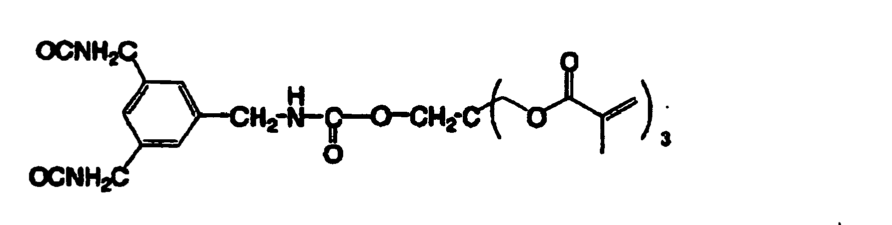

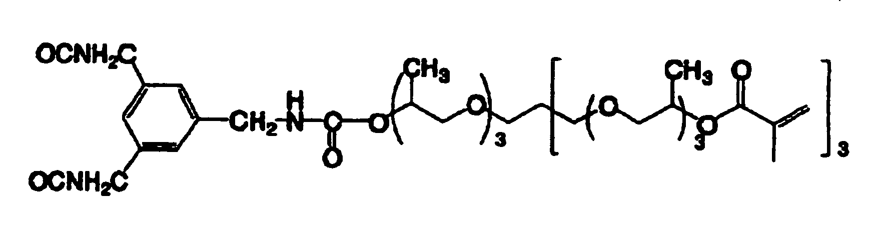

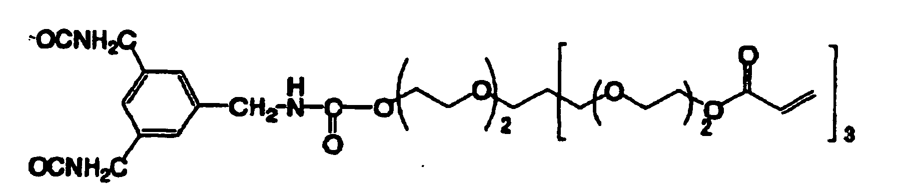

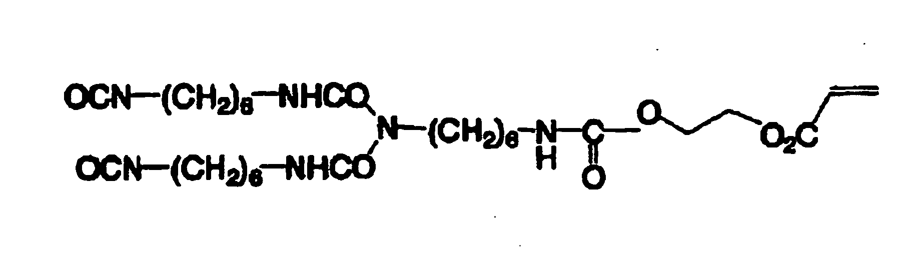

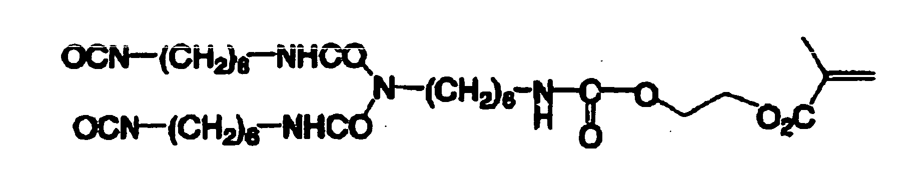

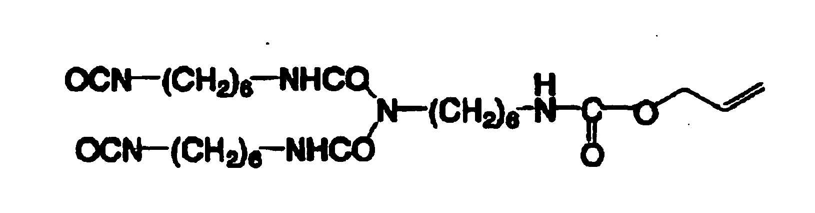

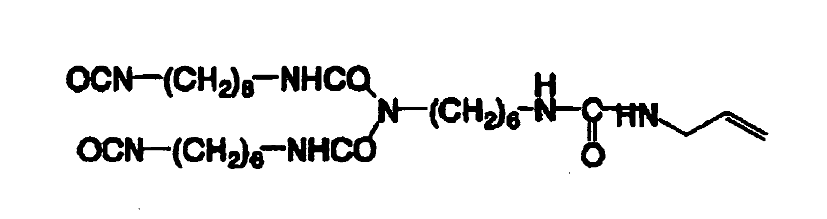

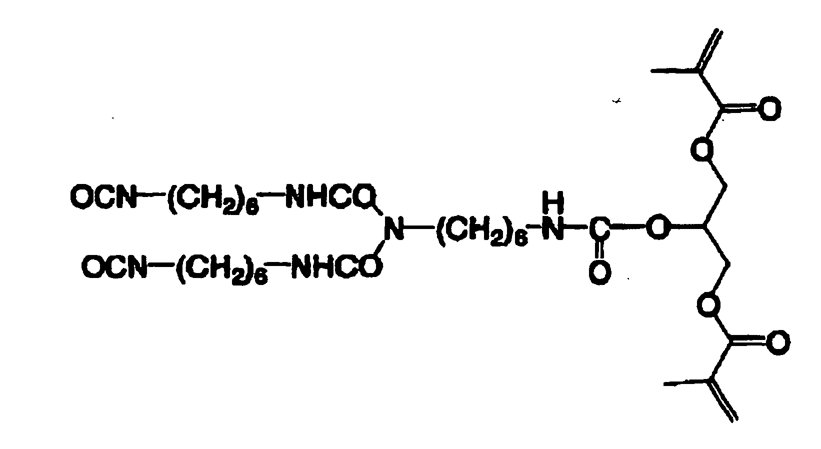

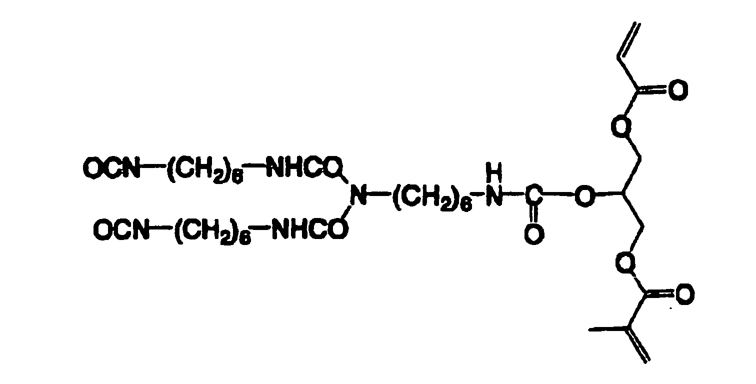

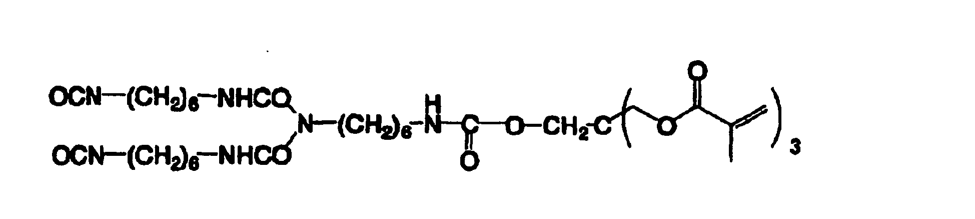

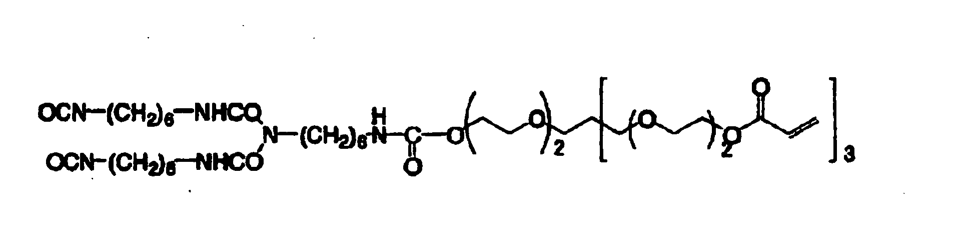

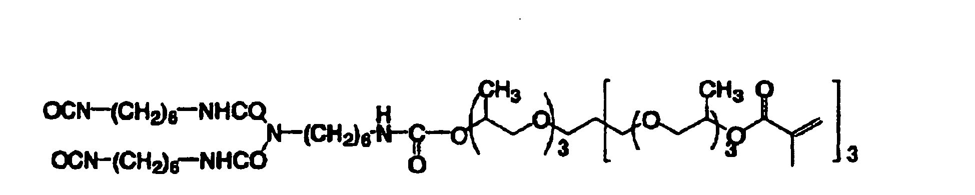

### (iv) Other diol compounds

As for the method of introducing an unsaturated group into the side chain of the polyurethane resin, in addition to the method described above, a method where a diol compound containing an unsaturated group in the side chain is used as a raw material in the production of the polyurethane resin, is also preferred. This diol compound may be, for example, a commercially available product such as trimethylolpropane monoallyl ether, or a compound easily produced by the reaction of a halogenated diol compound, triol compound or aminodiol compound with a carboxylic acid, acid chloride, isocyanate, alcohol, amine, thiol or halogenated alkyl compound having an unsaturated group. Specific examples of such a compound include, but are not limited to, the compounds set forth below.

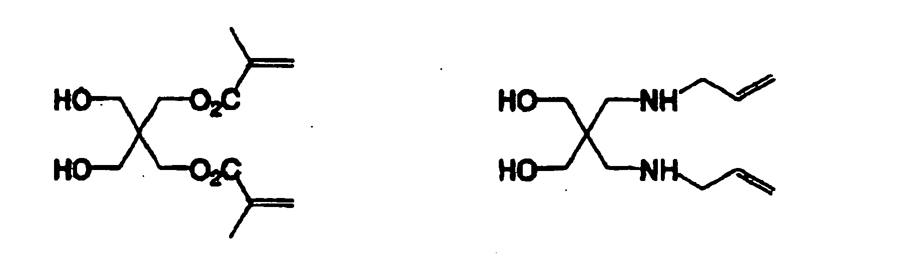

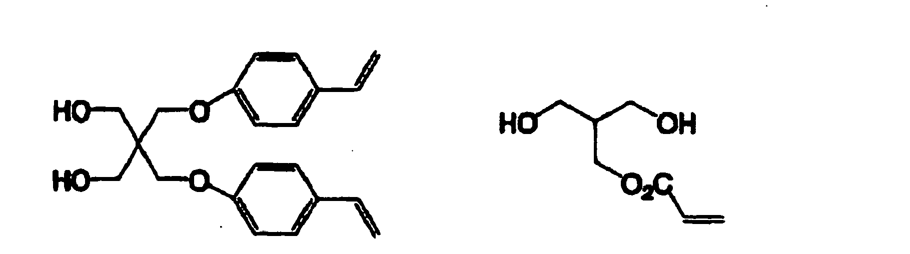

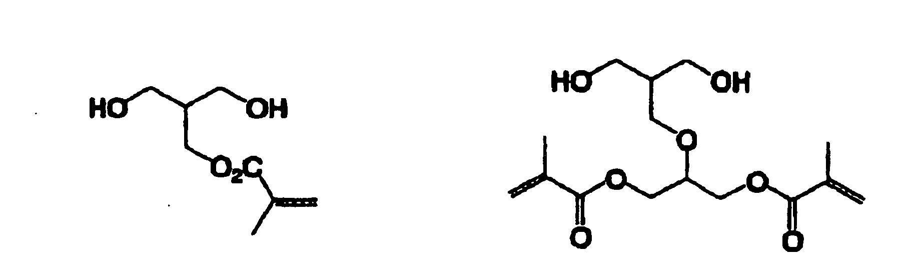

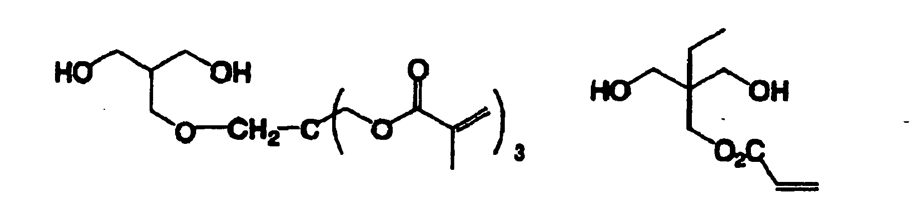

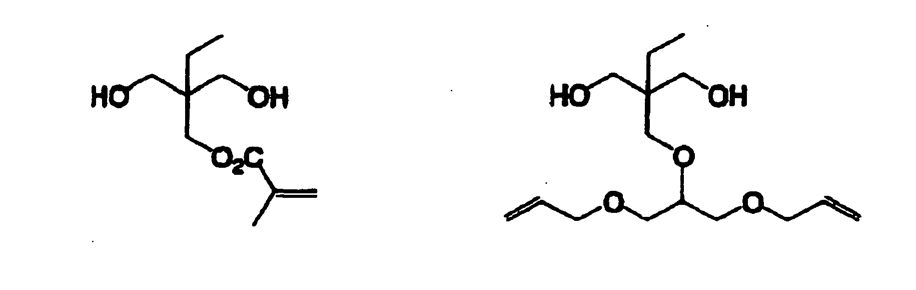

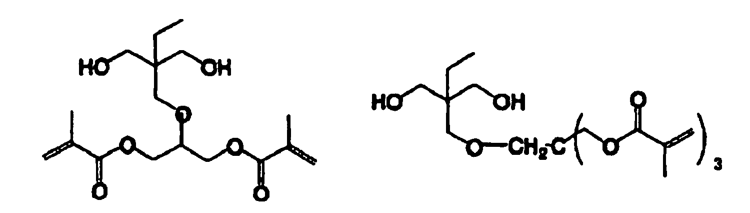

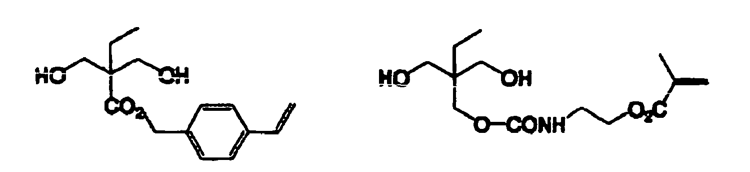

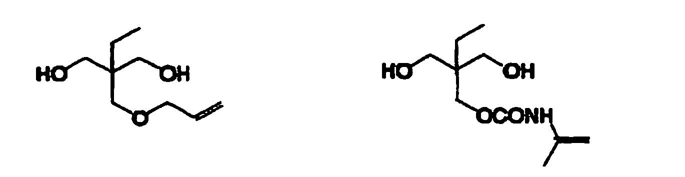

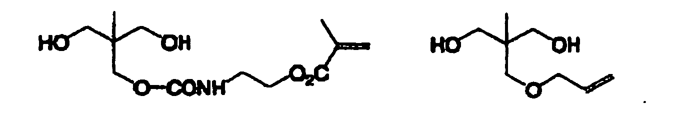

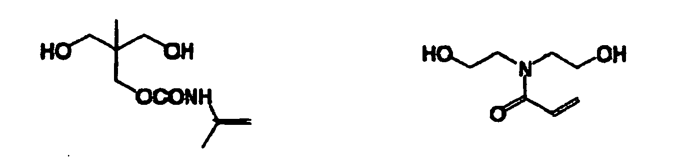

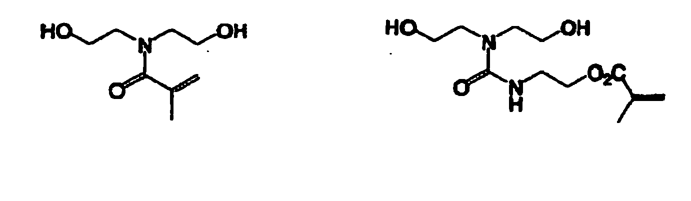

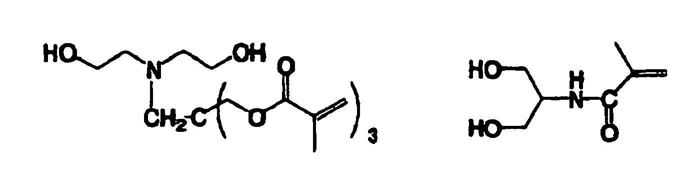

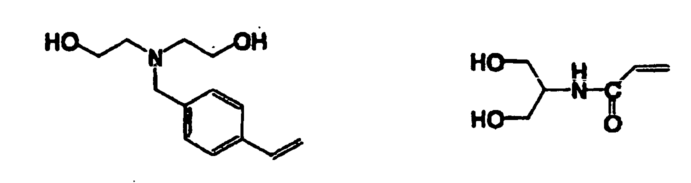

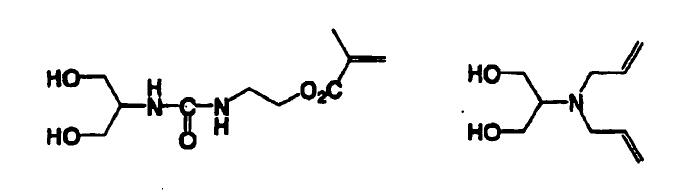

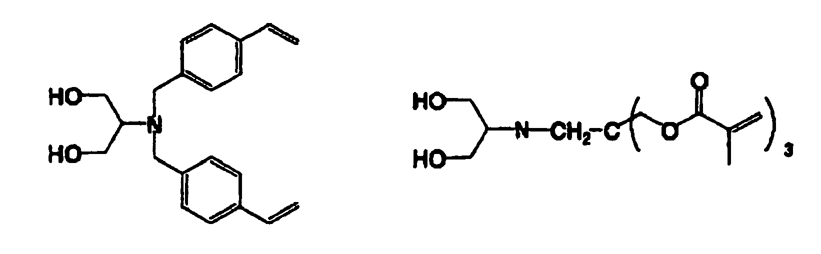

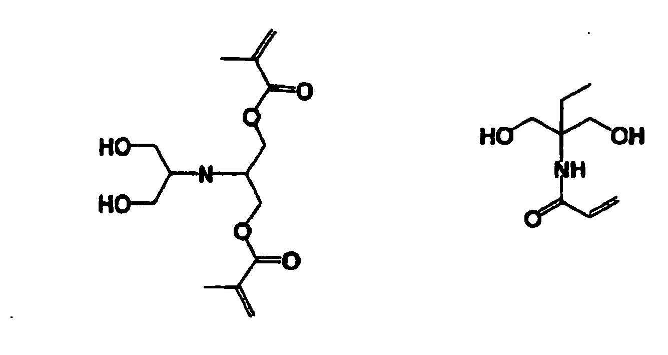

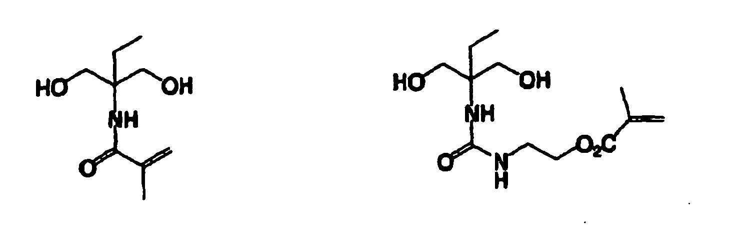

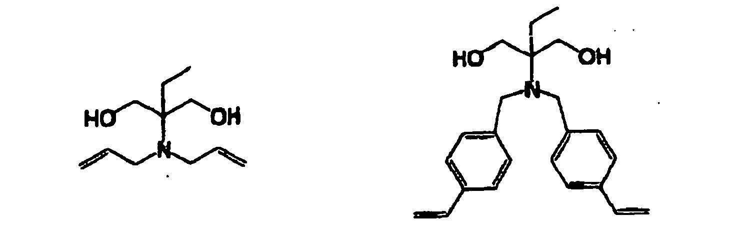

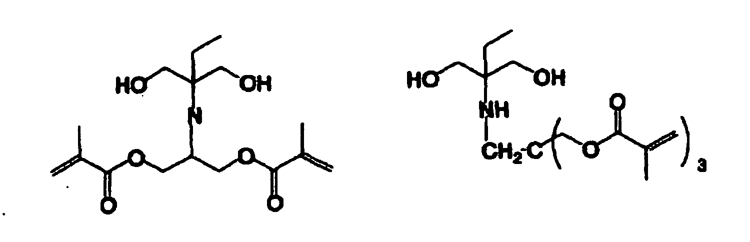

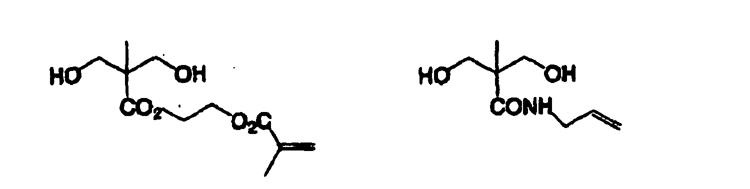

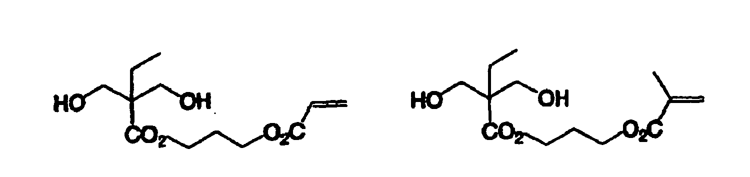

Still other examples of the diol compound include an ethylene glycol compound represented by the following formula (A').

HO-(CH₂CH₂O)ₙ-H (A')

(wherein n represents an integer of 1 or more).

Also, a random or block copolymer of a hydroxyl-terminated ethylene oxide and a propylene oxide may be used.

Furthermore, an ethylene oxide adduct of bisphenol A (the addition number of ethylene oxide is from 27 to 100), an ethylene oxide adduct of bisphenol F (the addition number of ethylene oxide is from 22 to 100), an ethylene oxide adduct of hydrogenated bisphenol A (the addition number of ethylene oxide is from 23 to 100), and an ethylene oxide adduct of hydrogenated bisphenol F (the addition number of ethylene oxide is from 18 to 100) may also be used. More specifically, an ethylene glycol compound represented by formula (A') is preferred in view of anti-staining property, an ethylene glycol compound where n is from 2 to 50 is more preferred, an ethylene glycol compound where n is from 3 to 30 is still more preferred, and an ethylene glycol compound where n is from 4 to 10 is yet still more preferred.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having a weight average molecular weight of 400, polypropylene glycol having a weight average molecular weight of 700, polypropylene glycol having a weight average molecular weight of 1,000, polypropylene glycol having a weight average molecular weight of 2,000, polypropylene glycol having a weight average molecular weight of 3,000, polypropylene glycol having a weight average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (the addition number of ethylene oxide is 26 or less), an ethylene oxide adduct of bisphenol F (the addition number of ethylene oxide is 21 or less), an ethylene oxide adduct of hydrogenated bisphenol A (the addition number of ethylene oxide is 22 or less), an ethylene oxide adduct of hydrogenated bisphenol F (the addition number of ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinonedihydroxyethyl ether, p-xylylene glycol, dihydroxyethylsulfone, bis(2-hydroxyethyl)-2,4-tolylene dicarbamate, 2,4-tolylenebis(2-hydroxyethylcarbamide), bis(2-hydroxyethyl)-m-xylylene dicarbamate and bis(2-hydroxyethyl) isophthalate.

In addition, polyether diol compounds represented by formulae (a), (b), (c), (d) and (e) may also be suitably used. 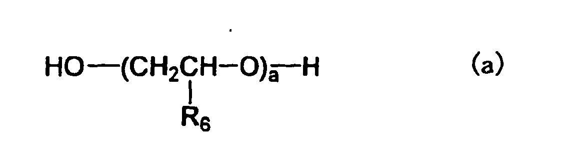 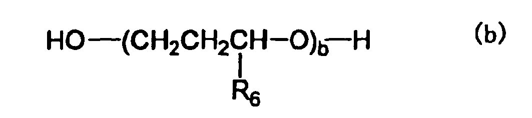 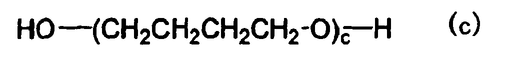 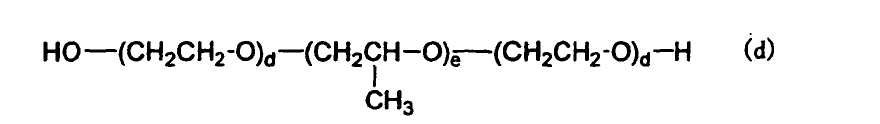 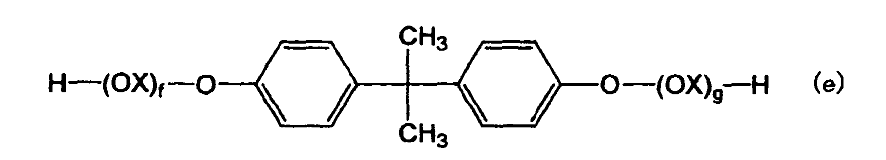 In the formulae above, R₆ represents a hydrogen atom or a methyl group, but in formula (a), R₆ represents a methyl group. X represents a group shown below: 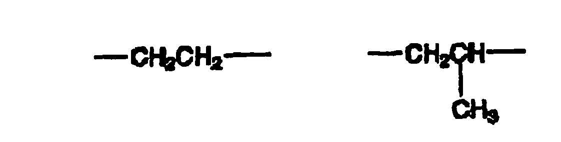 a, b, c, d, e, f and g each represents an integer of 2 or more, preferably an integer of 2 to 100.

Specific examples of the polyester diol compounds represented by formulae (11) and (12) include the followings.

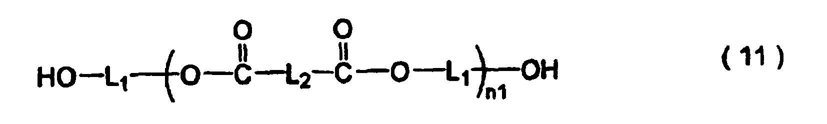

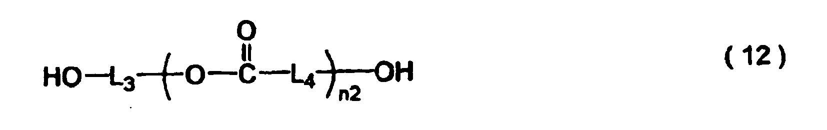

In the formulae above, L₁, L₂ and L₃, which may be the same or different, each represents a divalent aliphatic or aromatic hydrocarbon group, and L₄ represents a divalent aliphatic hydrocarbon group. L₁, L₂ and L₃ each preferably represents an alkylene group, an alkenylene group, an alkynylene group or an arylene group, and L₃ preferably represents an alkylene group. In L₁, L₂, L₃ and L₄, another functional group which does not react with the isocyanate group, such as ether group, carbonyl group, ester group, cyano group, olefin group, urethane group, amido group, ureido group and halogen atom, may be present. n1 and n2 each represents an integer of 2 or more, preferably an integer of 2 to 100.

Other specific examples include a polycarbonate diol compound represented by formula (13):

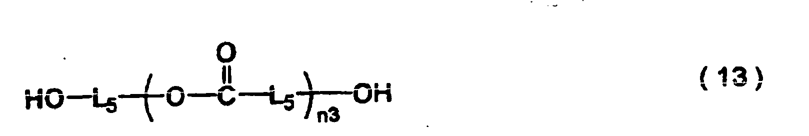

In the formula, L₅'s, which may be the same or different, each represents a divalent aliphatic or aromatic hydrocarbon group. L₅ is preferably an alkylene group, an alkenylene group, an alkynylene group or an arylene group. In L₅, another functional group which does not react with the isocyanate group, such as ether group, carbonyl group, ester group, cyano group, olefin group, urethane group, amido group, ureido group and halogen atom, may be present. n3 represents an integer of 2 or more, preferably an integer of 2 to 100.

Specific examples of the diol compound represented by formula (11), (12) or (13) include those set forth below. In these examples, n represents an integer of 2 or more.

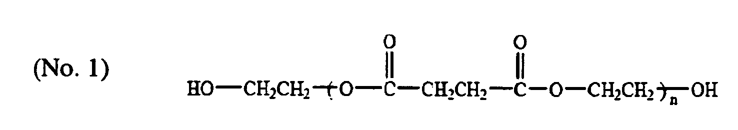

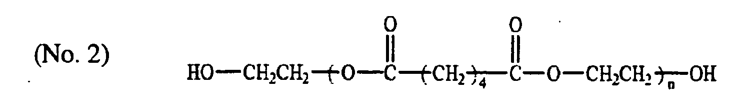

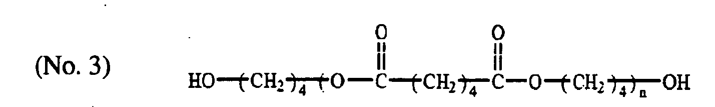

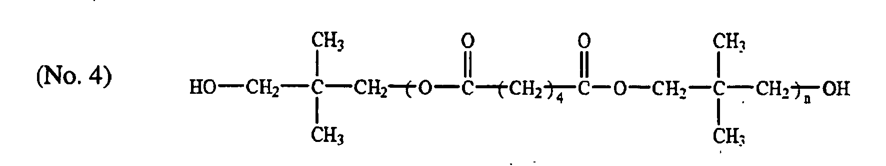

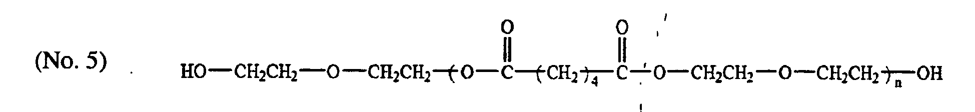

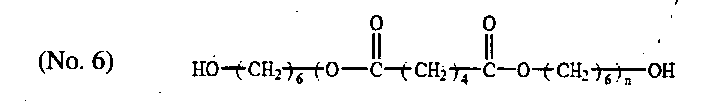

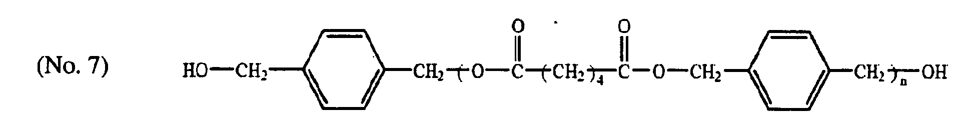

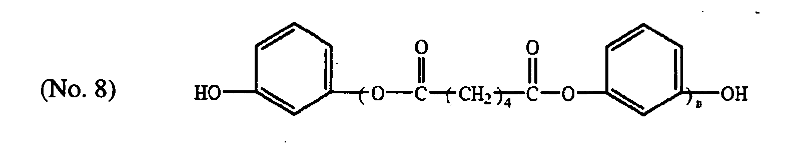

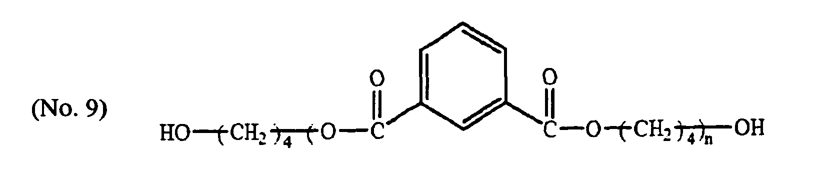

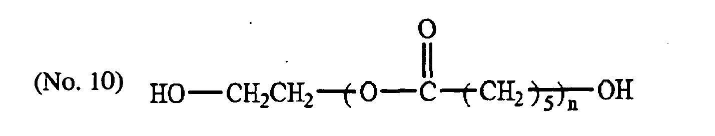

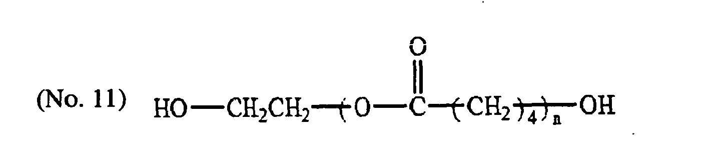

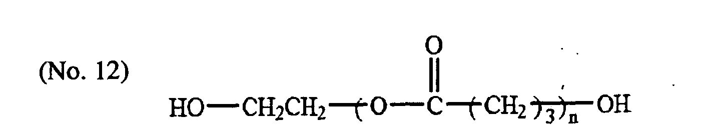

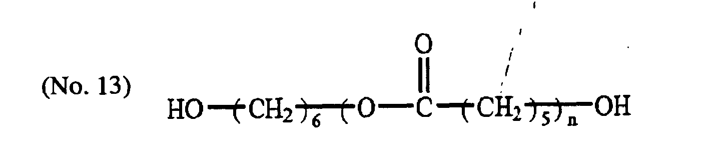

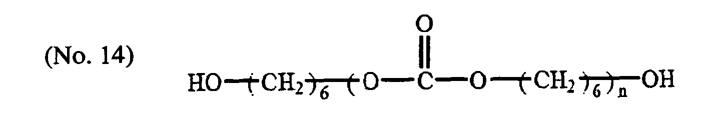

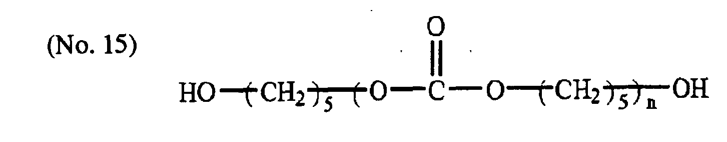

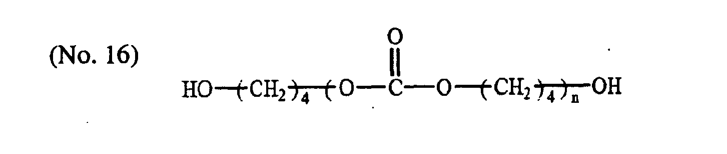

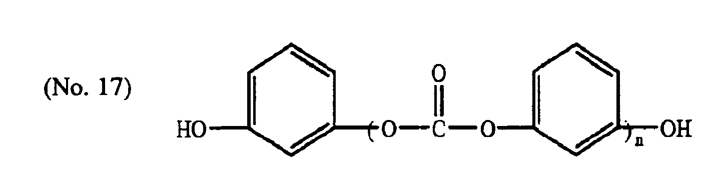

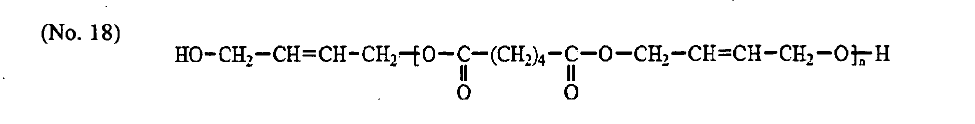

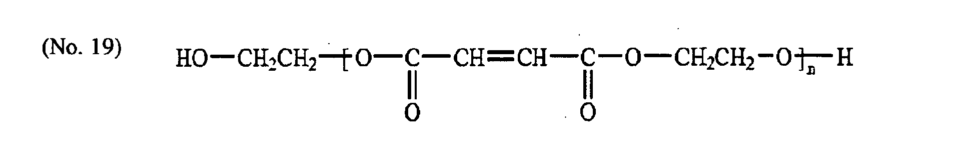

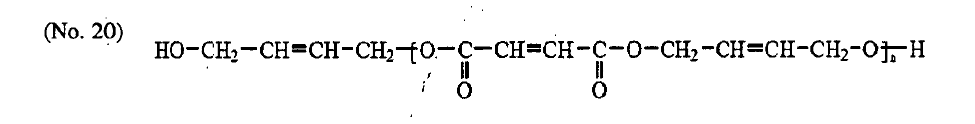

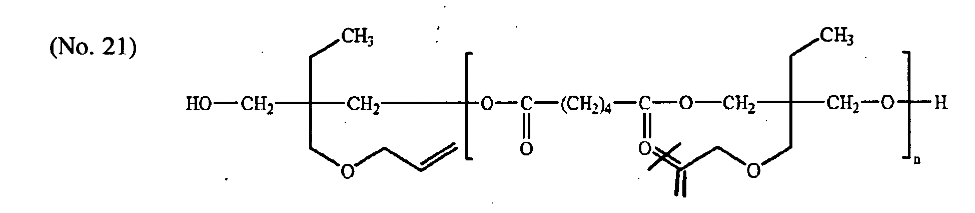

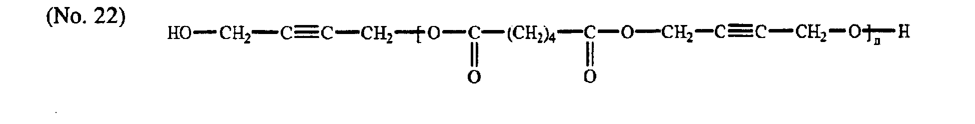

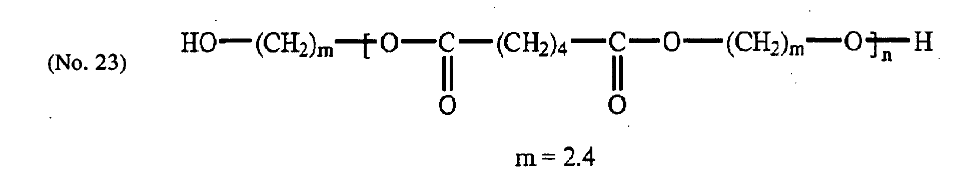

Furthermore, a diol compound which has no carboxyl group and may have another substituent incapable of reacting with isocyanate can also be used.

Examples of such a diol compound include the followings:

HO-L₆-O-CO-L₇-CO-O-L₆-OH (14)

HO-L₇-CO-O-L₆-OH (15)

wherein L₆ and L₇ may be the same or different and each represents a divalent aliphatic hydrocarbon group, aromatic hydrocarbon group or heterocyclic group which may have a substituent (examples of the substituent include an alkyl group, an aralkyl group, an aryl group, an alkoxy group, an aryloxy group and a halogen atom (e.g., -F, -Cl, -Br, -I)). If desired, L₆ and L₇ each may contain another functional group which does not react with the isocyanate group, such as carbonyl group, ester group, urethane group, amido group and a ureido group. L₆ and L₇ may form a ring together.

Specific examples of the compound represented by formula (14) or (15) include those set forth below.

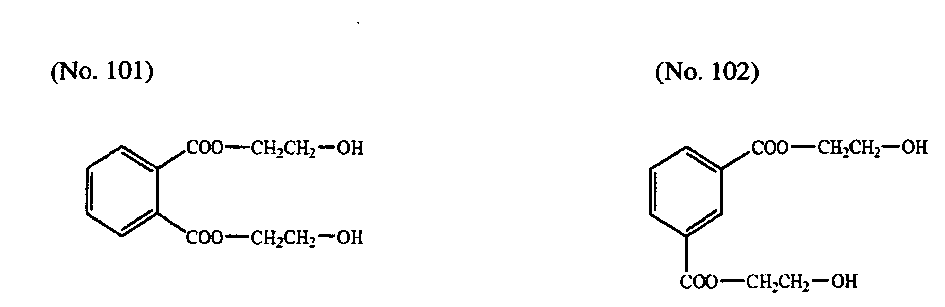

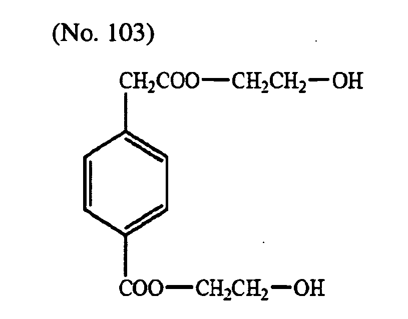

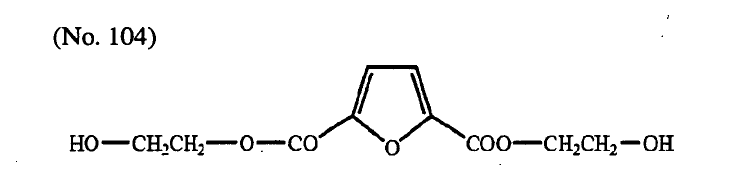

(No. 105) HO-CH₂CH₂-O-CO-CH=CH-COO-CH₂CH₂-OH

(No. 106) HO-CH₂CH₂-O-COC₁₁H₂₂COO-CH₂CH₂-OH

(No. 107) HO-CH₂CH₂-O-COC₁₂H₂₄COO-CH₂CH₂-OH

(No. 108) HO-CH₂CH₂-O-COC₁₄H₂₆COO-CH₂CH₂-OH

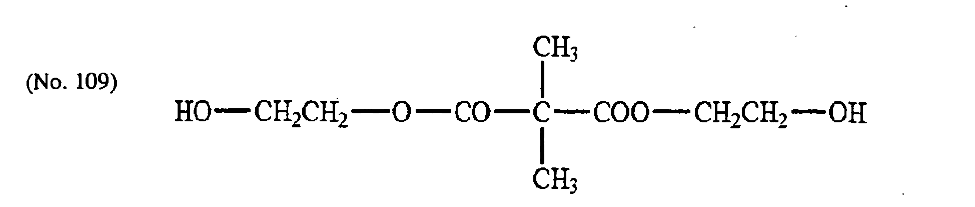

(No. 110) HO-CH₂CH₂-O-CO-C≡C-COO-CH₂CH₂-OH

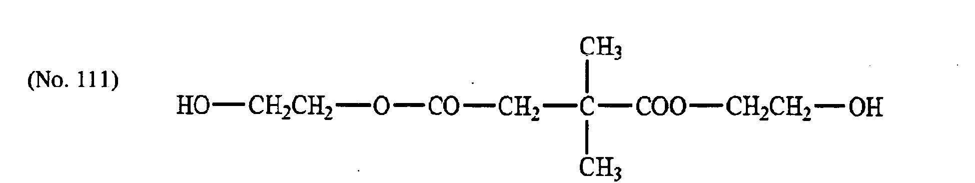

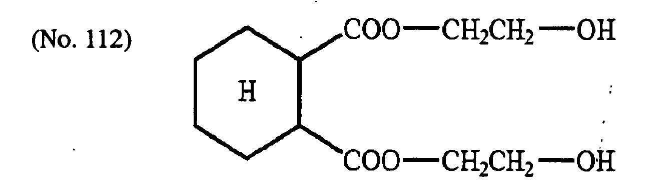

(No.113) HO-CH₂CH₂-O-CO-CH₂-O-CH₂-COO-CH₂CH₂-OH

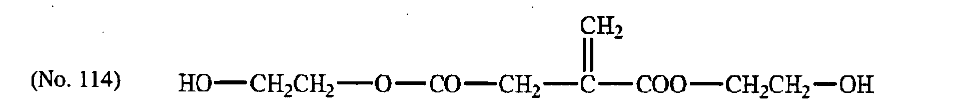

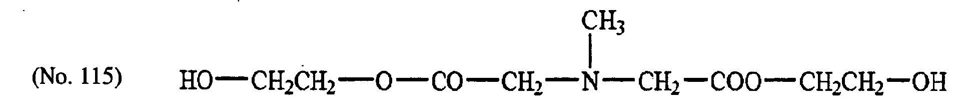

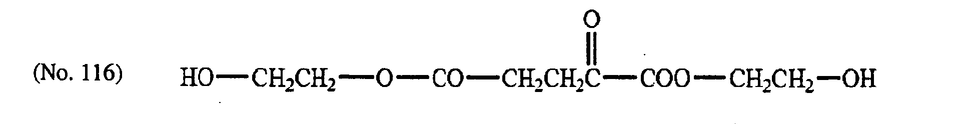

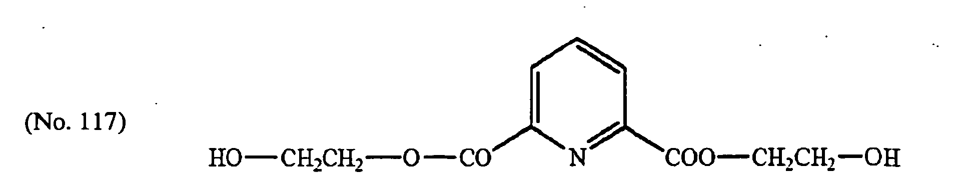

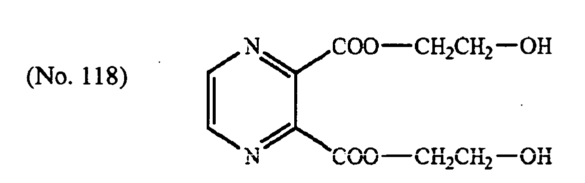

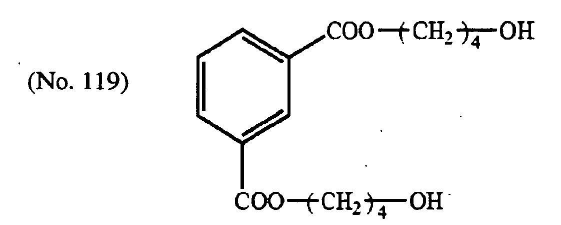

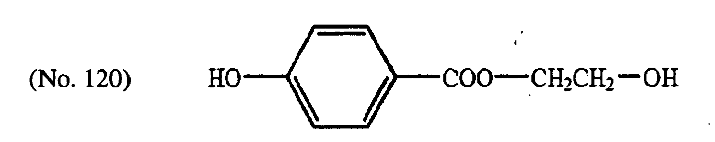

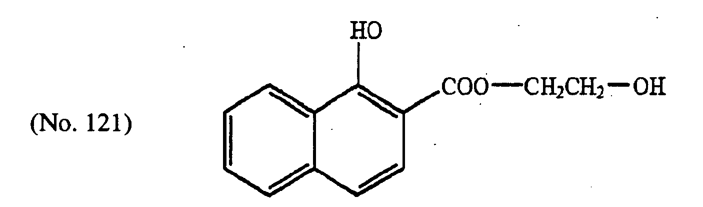

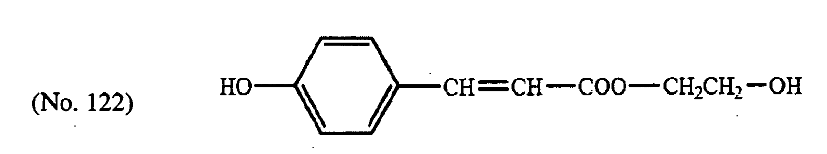

(No. 123) HO-CH₂CH₂-COO-CH₂CH₂-OH

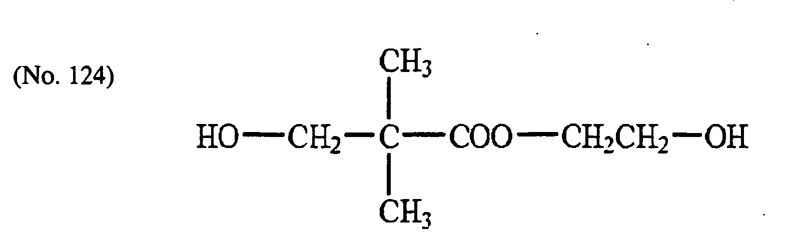

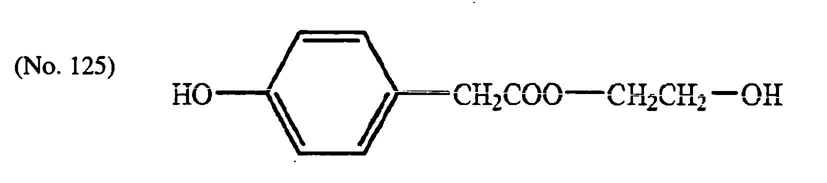

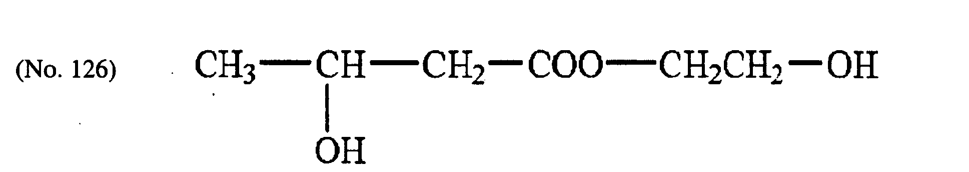

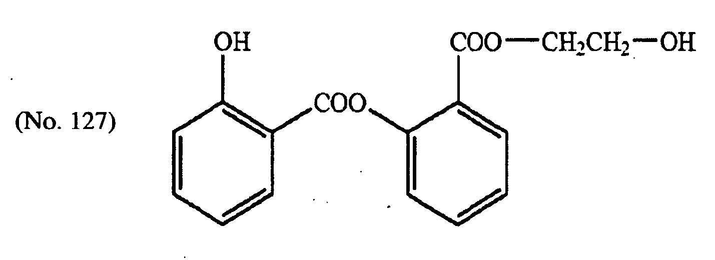

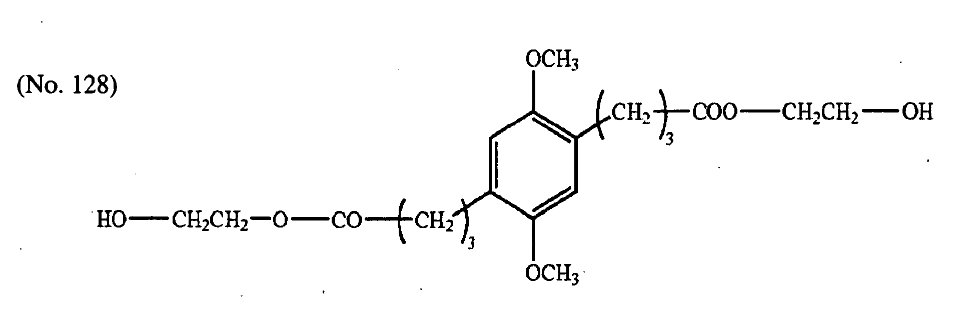

Furthermore, the following diol compounds may also be suitably used.

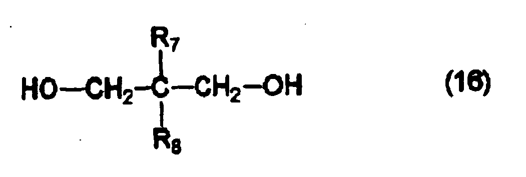

HO-CH₂-C≡-C-CH₂-OH (17)

HO-CH₂-CH=CH-CH₂-OH (18)

wherein R₇ and R₈, which may be the same or different, each represents an alkyl group which may have an alkyl group, preferably an alkyl group having a carbon number of 1 to 10, which may have a substituent such as cyano group, nitro group, halogen atom (e.g., -F, -Cl, -Br, -I), -CONH₂, -COOR and -OR (wherein R's may be the same or different and each represents an alkyl group having a carbon number of 1 to 10, an aryl group having a carbon number of 7 to 15, or an aralkyl group).

Specific examples of the diol compound represented by formula (16) include those set forth below.

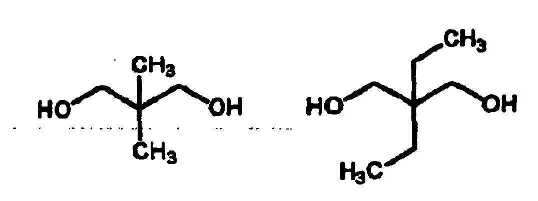

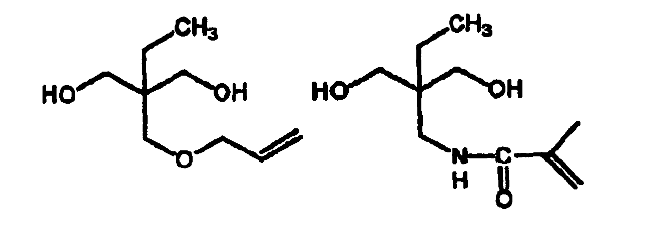

Examples of the diol compound represented by formula (17) include 2-butyne-1,4-diol; and examples of the diol compound represented by formula (18) include cis-2-butene-1,4-diol and trans-2-butene-1,4-diol.

The diol compounds represented by the following formulae (19) and (20) may also be suitably used.

HO-L₈-NH-CO-L₉-CO-NH-L₈-OH (19)

HO-L₉-CO-NH-L₈-OH (20)

wherein L₈ and L₉, which may be the same or different, each represents a divalent aliphatic hydrocarbon group, aromatic hydrocarbon group or heterocyclic group which may have a substituent (examples of the substituent include an alkyl group, an aralkyl group, an aryl group, an alkoxy group, an aryloxy group and a halogen atom (e.g., -F, -Cl, -Br, -I)). If desired, L₈ and L₉ each may contain another functional group which does not react with the isocyanate group, such as carbonyl group, ester group, urethane group, amido group and ureido group. L₈ and L₉ may form a ring together.

Specific examples of the compound represented by formula (19) or (20) include those set forth below.

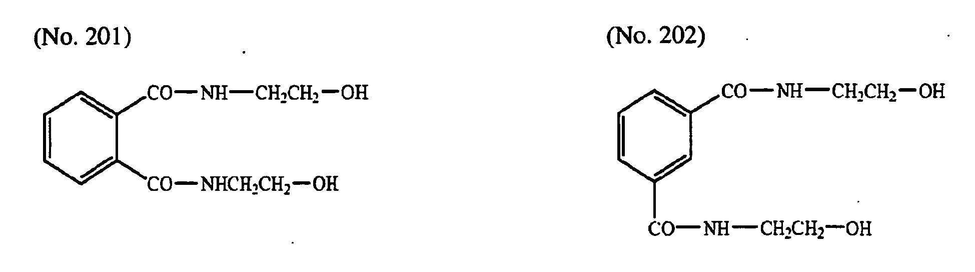

(No. 203) HO-CH₂CH₂-NH-CO-CH=CH-CO-NH-CH₂CH₂-OH

(No. 204) HO-CH₂CH₂-NH-CO-C=C-CO-NH-CH₂CH₂-OH

(No. 205) HO-CH₂CH₂-NH-CO-(CH₂)₂-CO-NH-CH₂CH₂-OH

(No. 206) HO-CH₂CH₂-NH-CO-(CH₂)₃-CO-NH-CH₂CH₂-OH

(No. 207) HO-CH₂CH₂-NH-CO-(CH₂)₅-CO-NH-CH₂CH₂-OH

(No. 208) HO-CH₂CH₂-NH-CO-(CH₂)₆-CO-NH-CH₂CH₂-OH

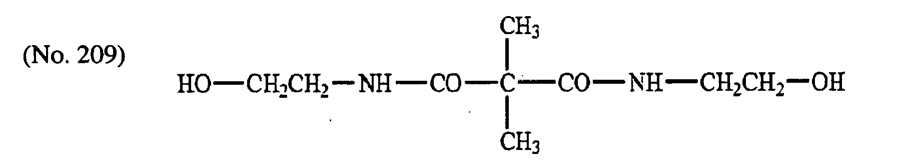

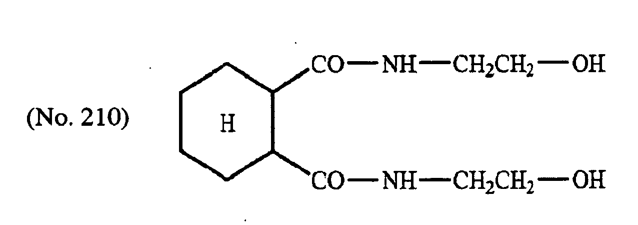

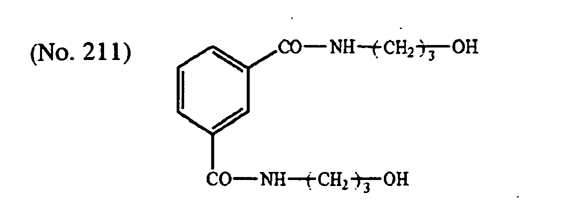

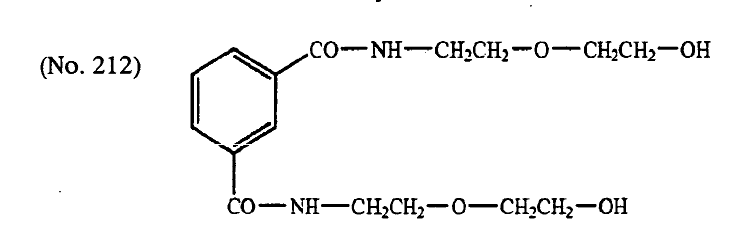

(No. 213) HO-(CH₂)₃-NH-(CH₂)₃-NH-CO-(CH₂)₂-CO-NH-(CH₂)₃-OH

(No.214) HO-CH₂CH₂-O-CH₂CH₂-NH-CO-(CH₂)₄-CO-NH-CH₂CH₂-O-CH₂CH₂-OH

(No. 215) HO-CH₂CH₂-NH-CO-CH₂-O-CH₂-CO-NH-CH₂CH₂-OH

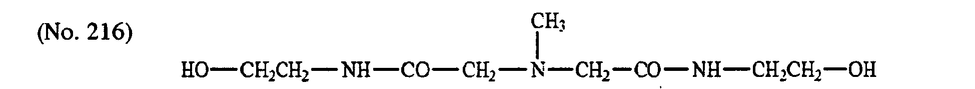

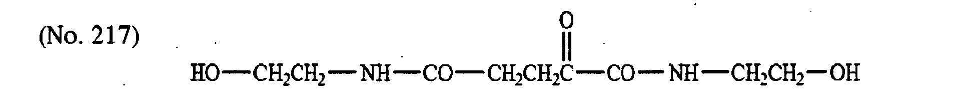

(No. 218) HO-CH₂CH₂-NH-CO-CH₂-S-CH₂-CO-NH-CH₂CH₂-OH

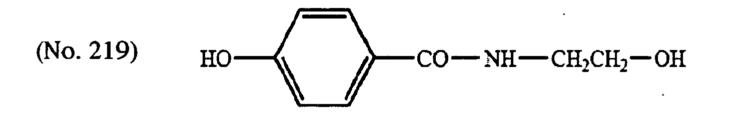

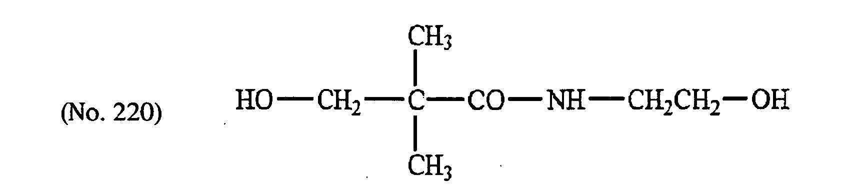

Furthermore, the diol compounds represented by the following formulae (21) and (22) may also be suitably used.

HO-Ar₂-(L₁₆-Ar₃)ₙ-OH (21)

HO-Ar₂-L₁₆-OH (22)

wherein L₁₆ represents a divalent aliphatic hydrocarbon group which may have a substituent (the substituent is preferably an alkyl group, an aralkyl group, an aryl group, an alkoxy group, an aryloxy group or a halogeno group). If desired, L₁₆ may contain another functional group which does not react with the isocyanate group, such as ester group, urethane group, amido group and ureido group.

Ar₂ and Ar₃, which may be the same or different, each represents a divalent aromatic hydrocarbon group which may have a substituent, preferably an aromatic group having a carbon number of 6 to 15. n represents an integer of 0 to 10.

Specific examples of the diol compound represented by formula (21) or (22) include:

catechol, resorcin, hydroquinone, 4-methylcatechol, 4-tert-butylcatechol, 4-acetylcatechol, 3-methoxycatechol, 4-phenylcatechol, 4-methylresorcin, 4-ethylresorcin, 4-tert-butylresorcin, 4-hexylresorcin, 4-chlororesorcin, 4-benzylresorcin, 4-acetylresorcin, 4-carbomethoxyreorcin, 2-methylresorcin, 5-methylresorcin, tert-butylhydroquinone, 2,5-di-tert-butylhydroquinone, 2,5-di-tert-amylhydroquinone, tetramethylhydroquinone, tetrachlorohydroquinone, methylcarboaminohydroquinone, methylureidohydroquinone, methylthiohydroquinone, benzonorbomene-3,6-diol, bisphenol A, bisphenol S, 3,3'-dichlorobisphenol S, 4,4'-dihdroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-(p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybenzyl alcohol, 4-hydroxybenzyl alcohol, 2-hydroxy-3,5-di-tert-butylbenzyl alcohol, 4-hydroxy-3,5-di-tert-butylbenzyl alcohol, 4-hydroxyphenethyl alcohol, 2-hydroxyethyl-4-hydroxybenzoate, 2-hydroxyethyl-4-hydroxyphenylacetate and resorcin mono-2-hydroxyethyl ether. The diol compounds shown below may also be suitably used.

### (v) Other amino group-containing compounds

In the polyurethane resin binder for use in the present invention, an amino group-containing compound represented by the following formula (31) or (32) may be reacted with a diisocyanate compound to form a urea structure and incorporated into the polyurethane resin structure.

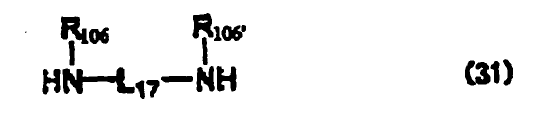

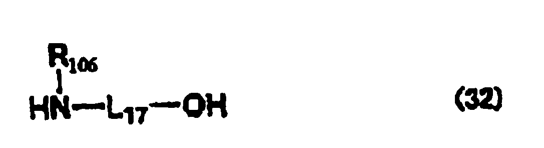

In the formulae above, R₁₀₆ and R_{106'}, which may be the same or different, each represents a hydrogen atom or an alkyl, aralkyl or aryl group which may have a substituent (examples of the substituent include an alkoxy group, a halogen atom (e.g., -F, -Cl, -Br, -I), an ester group and a carboxyl group), preferably a hydrogen atom, an alkyl group having a carbon number of 1 to 8 which may have a carboxyl group as a substituent, or an aryl group having a carbon number of 6 to 15. L₁₇ represents a divalent aliphatic hydrocarbon group, aromatic hydrocarbon group or heterocyclic group which may have a substituent (examples of the substituent include an alkyl group, an aralkyl group, an aryl group, an alkoxy group, an aryloxy group, a halogen atom (e.g., -F, -Cl, -Br, -I) and a carboxyl group). If desired, L₁₇ may contain another functional group which does not react with the isocyanate group, such as carbonyl group, ester group, urethane group and amido group. Two members out of R₁₀₆, L₁₇ and R₁₀₆ may form a ring together.

Specific examples of the compound represented by formula (31) or (32) include:

an aliphatic diamine compound such as ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine and isophoronediamine; an aromatic diamine compound such as o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis-(4-aminophenyl)sulfone, 4-carboxy-o-phenylenediamine, 3-carboxy-m-phenylenediamine, 4,4'-diaminophenyl ether and 1,8-naphthalenediamine; a heterocyclic amine compound such as 2-aminoimidazole, 3-aminotriazole, 5-amino-1H-tetrazole, 4-aminopyrazole, 2-aminobenzimidazole, 2-amino-5-carboxytriazole, 2,4-diamino-6-methyl-S-triazine, 2,6-diaminopyridine, L-histidine, DL-tryptophan and adenine; and an aminoalcohol or aminophenol compound such as ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol and L-tyrosine.

As for the binder polymer for use in the present invention, in addition to the above-described polyurethane resin obtained by introducing a crosslinking group into the side chain at the synthesis of polyurethane, a polyurethane resin described in JP-A-2003-270775, which is obtained by introducing a crosslinking group into a carboxyl group-containing polyurethane through a polymer reaction, may also be used.

The molecular weight of the binder polymer for use in the present invention is appropriately selected in view of image forming property and press life. The molecular weight is preferably from 2,000 to 1,000,000, more preferably from 5,000 to 500,000, still more preferably from 10,000 to 200,000.

One of these polymer binders for use in the present invention may be used alone, or two or more thereof may be used in combination. Furthermore, the polymer binder may also be used as a mixture by using one or more other binder polymer having no crosslinking group in combination. As for the binder polymer which can be used in combination, conventionally known alkali-soluble or swelling binders may be used without limitation. Specifically, an alkali main chain binder, a urethane binder and the like often used in this industry may be preferably used.

The total amount of the polymer binder and the binder polymer usable in combination in the photosensitive layer may be appropriately selected but is usually from 10 to 90 mass%, preferably from 20 to 80 mass%, more preferably from 30 to 70 mass%, based on the total mass of nonvolatile components in the photosensitive layer. Also, the ratio by mass of the photopolymerizable ethylenically unsaturated bond-containing compound to the binder polymer is preferably from 1/9 to 9/1, more preferably from 2/8 to 8/2, still more preferably from 3/7 to 7/3.

The polymer having a (meth)acryl structural unit suitably used in the present invention is a binder polymer having a repeating unit represented by the following formula (ii). The binder polymer having a repeating unit represented by formula (ii), which is sometimes referred to as a "specific binder polymer", is described in detail below. 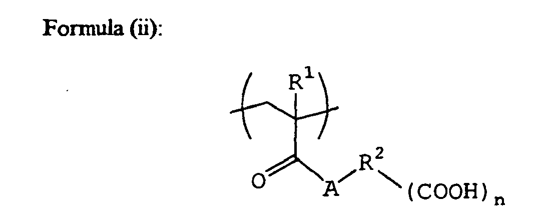 (wherein R¹ represents a hydrogen atom or a methyl group, R² represents a linking group comprising two or more atoms selected from the group consisting of a carbon atom, a hydrogen atom, an oxygen atom, a nitrogen atom and a sulfur atom, in which the total number of atoms is from 2 to 82, A represents an oxygen atom or -NR³, R³ represents a hydrogen atom or a monovalent hydrocarbon group having a carbon number of 1 to 10, and n represents an integer of 1 to 5).

R¹ in formula (ii) represents a hydrogen atom or a methyl group, preferably a methyl group.

The linking group represented by R² in formula (ii) comprises two or more atoms selected from the group consisting of a carbon atom, a hydrogen atom, an oxygen atom, a nitrogen atom and a sulfur atom, and the total number of atoms thereof is from 2 to 82, preferably from 2 to 50, more preferably from 2 to 30. The total number of atoms as used herein indicates, when the linking group has a substituent, a number of atoms including the substituent. More specifically, the number of atoms constituting the main frame of the linking group represented by R² is preferably from 1 to 30, more preferably from 3 to 25, still more preferably from 4 to 20, and most preferably from 5 to 10. The "main frame of the linking group" as used in the present invention indicates an atom or atomic group used only for linking A to terminal COOH in formula (ii) and when a plurality of linking paths are present, indicates an atom or atomic group constituting a path having a smallest number of atoms used. Accordingly, in the case of having a ring structure in the linking group, the number of atoms included differs depending on the linking site (for example, o-, m- or p-).

Specific examples thereof include an alkylene, a substituted alkylene, an arylene and a substituted arylene, and a plurality of these divalent groups may be linked by an amide bond or an ester bond.

Examples of the linking group having a chain structure include ethylene and propylene. A structure where these alkylenes are linked through an ester bond is also preferred.

Among these, the linking group represented by R² in formula (ii) is preferably a (n+1)-valent hydrocarbon group having an aliphatic cyclic or chained structure with from 3 to 30 carbon atoms. Specific examples thereof include a (n+1)-valent hydrocarbon group resulting from elimination of (n+1) hydrogen atoms on arbitrary carbon atoms constituting a compound containing an aliphatic cyclic structure, such as cyclopropane, cyclopentane, cyclohexane, cycloheptane, cyclooctane, cyclodecane, dicyclohexyl, tercyclohexyl and norbomane, which may be substituted by one or more arbitrary substituent. Also, R² is preferably a linking group having a carbon number of 3 to 30 including a substituent.

An arbitrary carbon atom constituting the compound having an aliphatic cyclic structure may be replaced by one or more heteroatom selected from a nitrogen atom, an oxygen atom and a sulfur atom. In view of the press life, R² is preferably a (n+1)-valent hydrocarbon group having an aliphatic cyclic structure comprising two or more rings and having from 5 to 30 carbon atoms, which may have a substituent, such as a condensed polycyclic aliphatic hydrocarbon, a crosslinked aliphatic cyclic hydrocarbon, a spiro-aliphatic hydrocarbon and an aliphatic hydrocarbon ring assembly (where a plurality of rings are bonded or connected through a linking group). Also in this case, the carbon number is a number of carbon atoms including those of a substituent.

Particularly; R² is preferably a linking group where the number of atoms constituting the main frame of the linking group is from 5 to 10, and in view of structure, preferably a linking group having a chain structure and containing an ester bond in the structure, or a linking group having a cyclic structure described above.

The substituent which can be introduced into the linking group represented by R² includes a monovalent nonmetallic atom group exclusive of hydrogen, and examples thereof include a halogen atom (e.g., -F, -Br, -Cl, -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group and a conjugate base group thereof, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo (-SO₃H) group and a conjugate base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugate base group thereof, an N-alkylsulfonylsulfamoyl group (-SO₂NHSO₂(alkyl)) and a conjugate base group thereof, an N-arylsulfonylsulfamoyl group (-SO₂NHSO₂(aryl)) and a conjugate base group thereof, an N-alkylsulfonylcarbamoyl group (-CONHSO₂(alkyl)) and a conjugate base group thereof, an N-arylsulfonylcarbamoyl group (-CONHSO₂(aryl)) and a conjugate base group thereof, an alkoxysilyl group (-Si(O-alkyl)₃), an aryloxysilyl group (-Si(O-aryl)₃), a hydroxysilyl group (-Si(OH)₃) and a conjugate base group thereof, a phosphono group (-PO₃H₂) and a conjugate base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof, a monoarylphosphono group (-PO₃H(aryl)) and a conjugate base group thereof, a phosphonoxy group (-OPO₃H₂) and a conjugate base group thereof, a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof, a monoarylphosphonoxy group (-OPO₃H(aryl)) and a conjugate base group thereof, a cyano group, a nitro group, a dialkylboryl group (-B(alkyl)₂), a diarylboryl group (-B(aryl)), an alkyhmylboryl group (-B(alkyl)(aryl)), a dihydroxyboryl group (-B(OH)₂) and a conjugate base group thereof, an alkylhydroxyboryl group (-B(alkyl)(OH)) and a conjugate base group thereof, an arylhydroxyboryl group (-B(aryl)(OH)) and a conjugate base group thereof, an aryl group, an alkenyl group and an alkynyl group.

In the lithographic printing plate precursor of the present invention, a substituent having a hydrogen atom capable of hydrogen bonding, particularly a substituent having acidity of giving an acid dissociation constant (pKa) lower than that of carboxylic acid, tends to reduce the press life and is not preferred, though this may vary depending on the design of the photosensitive layer. On the other hand, a hydrophobic substituent such as halogen atom, hydrocarbon group (e.g., alkyl, aryl, alkenyl, alkynyl), alkoxy group and aryloxy group is preferred because the press life tends to be enhanced. Particularly, when the cyclic structure is a 6-membered or less monocyclic aliphatic hydrocarbon such as cyclopentane and cyclohexane, the linking group preferably has the above-described hydrophobic substituent. If possible, these substituents may combine with each other to form a ring, or the substituent may combine with the hydrocarbon group to which the substituent is substituted, to form a ring. The substituent may be further substituted.

In the case where A in formula (ii) is NR³-, R³ represents a hydrogen atom or a monovalent hydrocarbon group having a carbon number of 1 to 10. Examples of the monovalent hydrocarbon group having a carbon number of 1 to 10 represented by R³ include an alkyl group, an aryl group, an alkenyl group and an alkynyl group.

Specific examples of the alkyl group include a linear, branched or cyclic alkyl group having a carbon number of 1 to 10, such as methyl group, ethyl group, propyl group, butyl group, pentyl group, hexyl group, heptyl group, octyl group, nonyl group, decyl group, isopropyl group, isobutyl group, sec-butyl group, tert-butyl group, isopentyl group, neopentyl group, 1-methylbutyl group, isohexyl group, 2-ethylhexyl group, 2-methylhexyl group, cyclopentyl group, cyclohexyl group, 1-adamantyl group and 2-norbornyl group.

Specific examples of the aryl group include an aryl group having a carbon number of 1 to 10, such as phenyl group, naphthyl group and indenyl group, and a heteroaryl group having a carbon number of 1 to 10 and containing one heteroatom selected from the group consisting of a nitrogen atom, an oxygen atom and a sulfur atom, such as furyl group, thienyl group, pyrrolyl group, pyridyl group and quinolyl group.

Specific examples of the alkenyl group include a linear, branched or cyclic alkenyl group having a carbon number of 1 to 10, such as vinyl group, 1-propenyl group, 1-butenyl group, 1-methyl-1-propenyl group, 1-cyclopentenyl group and 1-cyclohexenyl group.

Specific examples of the alkynyl group include an alkynyl group having a carbon number of 1 to 10, such as ethynyl group, 1-propynyl group, 1-butynyl group and 1-octynyl group. Examples of the substituent which R³ may have are the same as those of the substituent which can introduced into R². Here, the carbon number of R³ is from 1 to 10 including the carbon number of the substituent.

A in formula (ii) is preferably an oxygen atom or -NH-, because the synthesis is easy.

n in formula (ii) represents an integer of 1 to 5 and in view of printing durability, preferably 1.

Specific preferred examples of the repeating unit represented by formula (ii) are set forth below, but the present invention is not limited thereto.

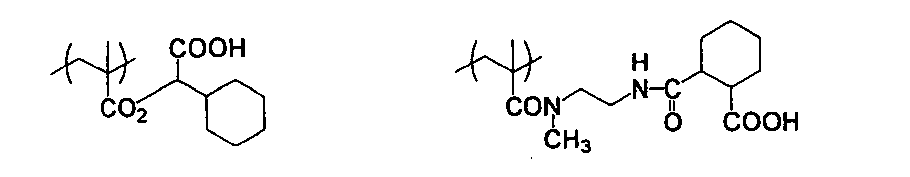

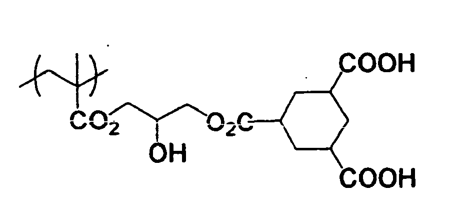

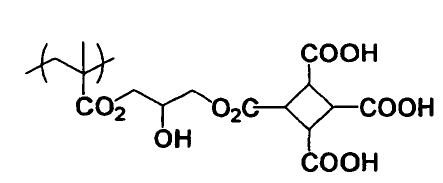

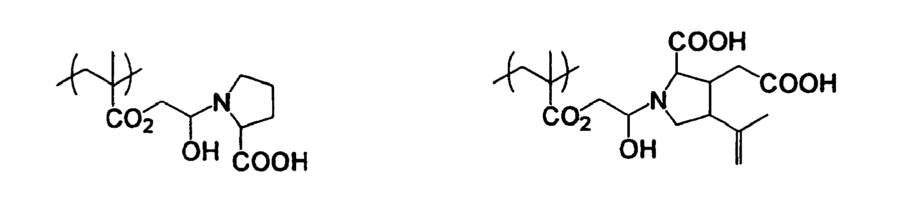

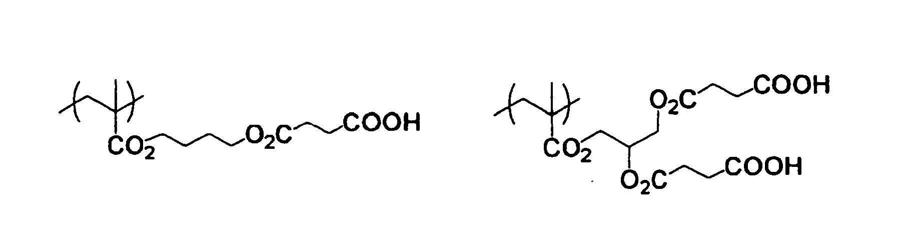

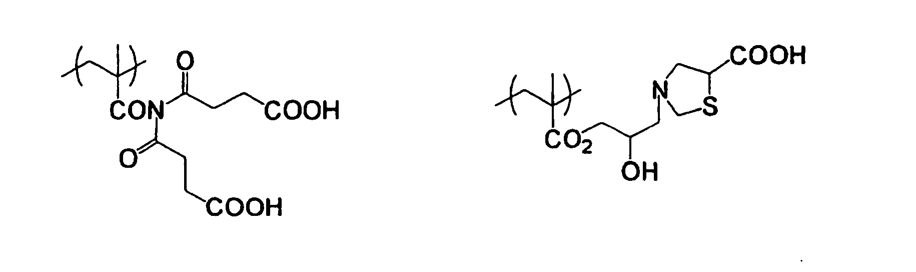

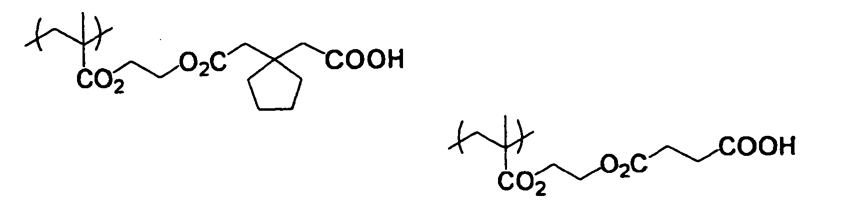

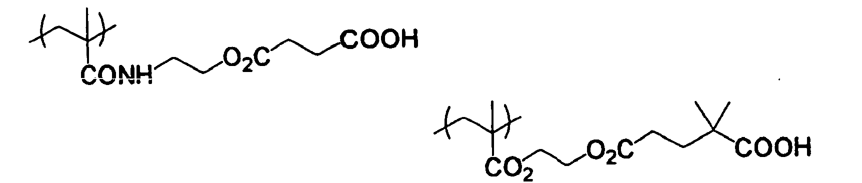

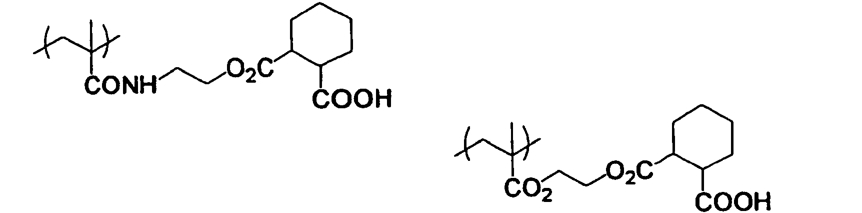

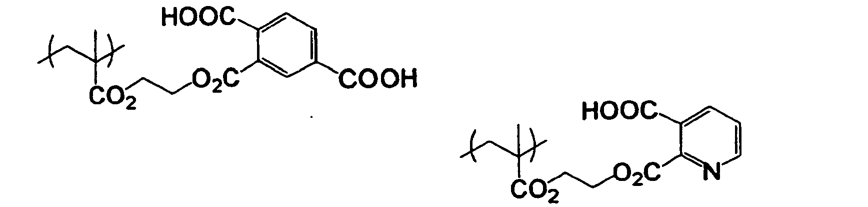

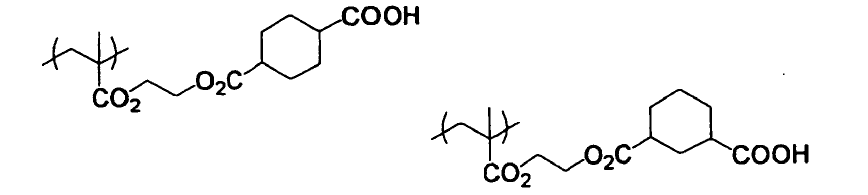

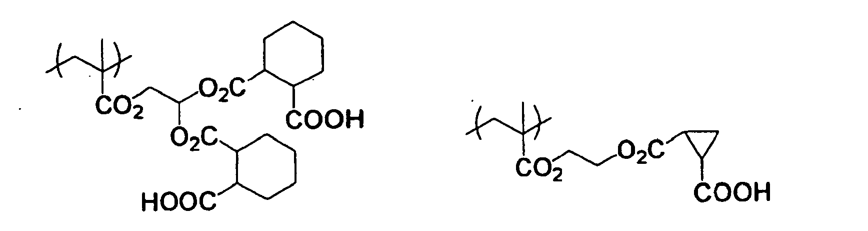

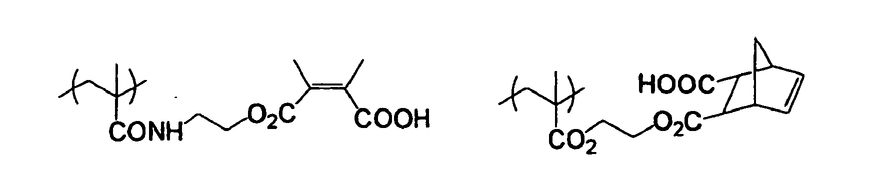

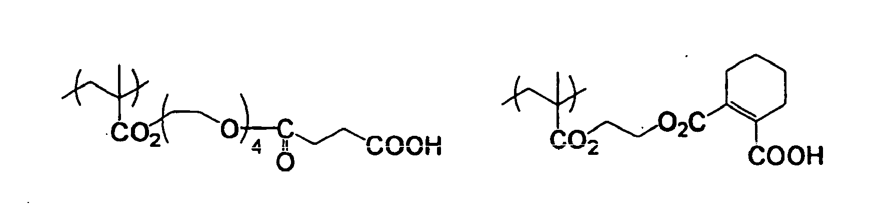

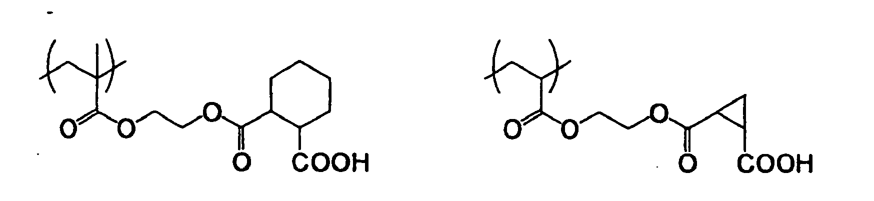

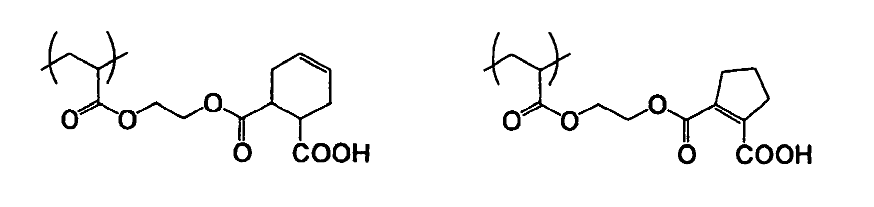

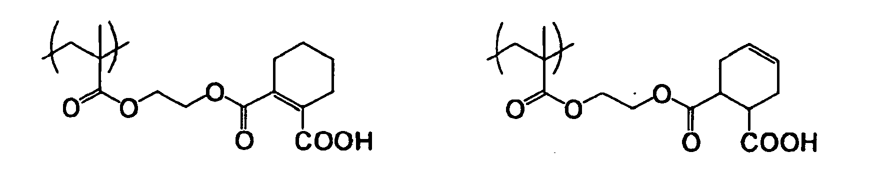

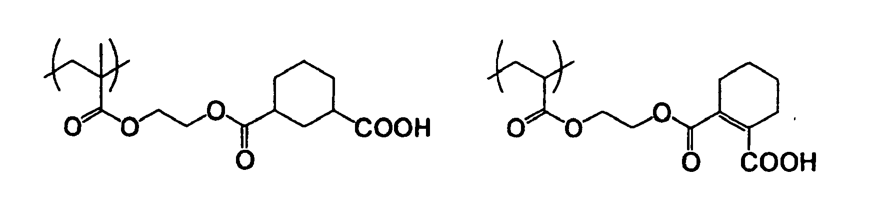

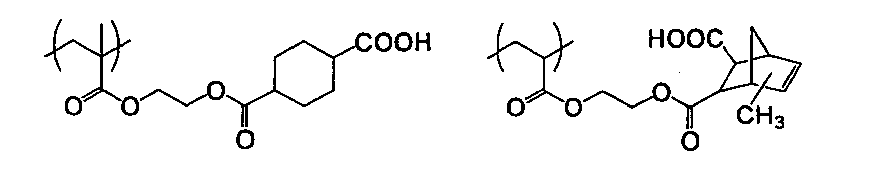

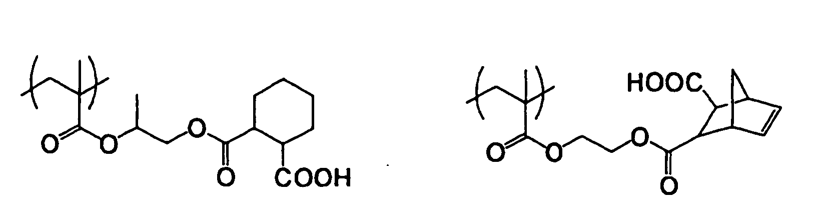

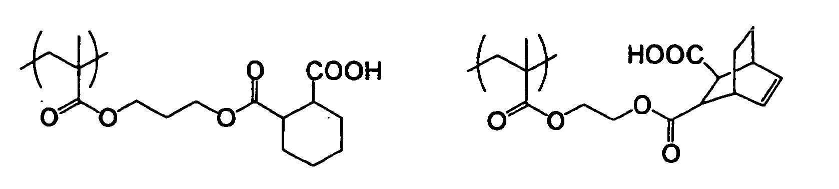

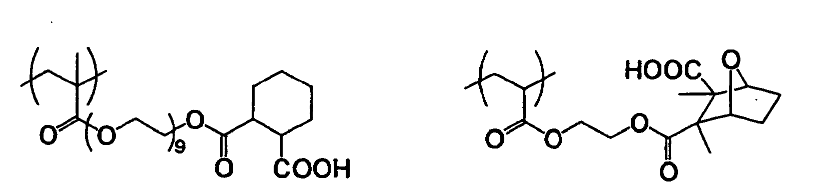

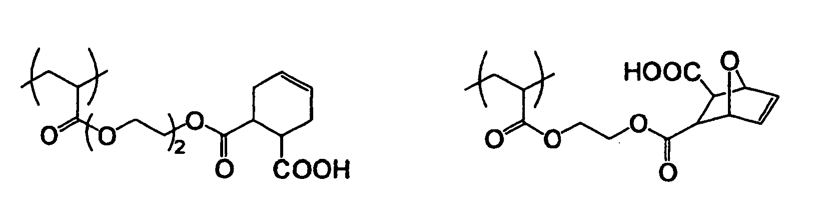

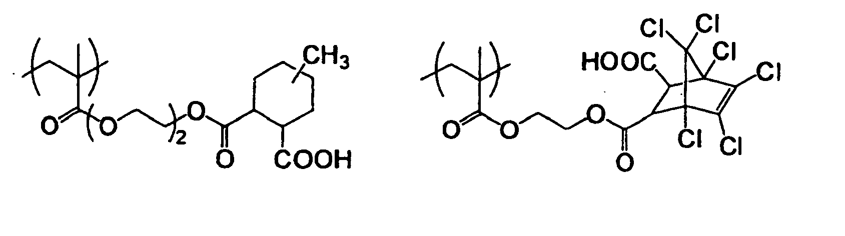

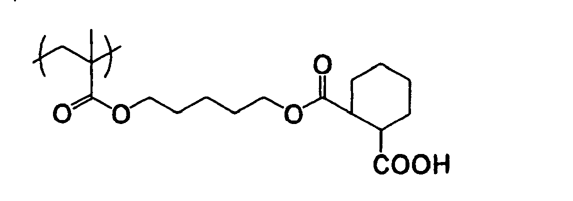

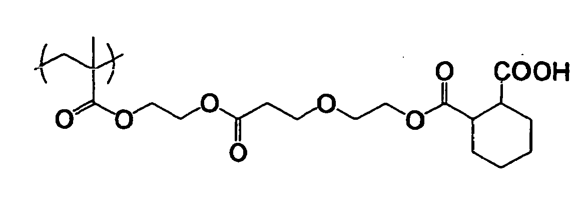

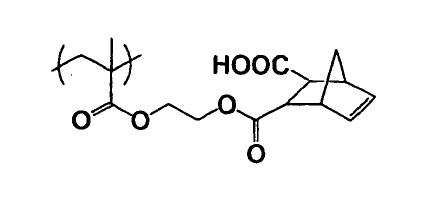

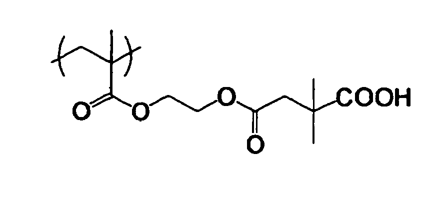

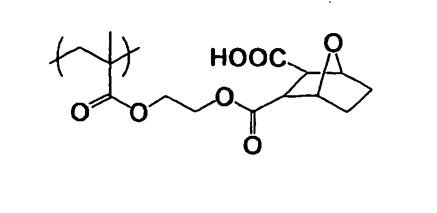

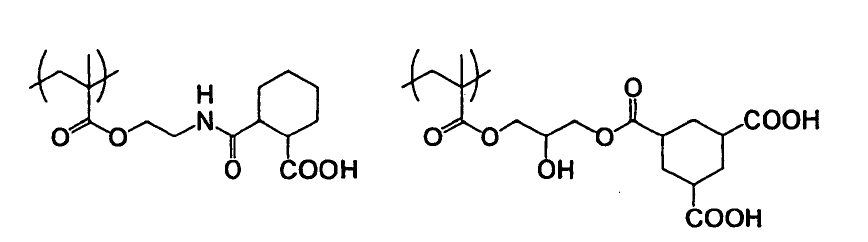

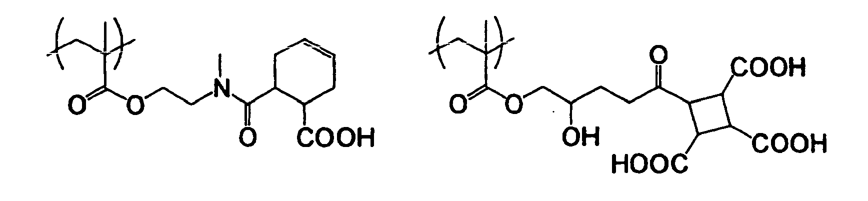

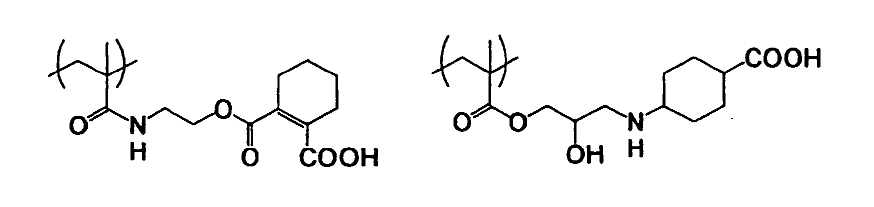

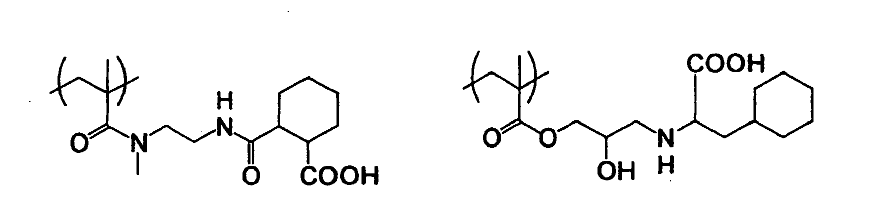

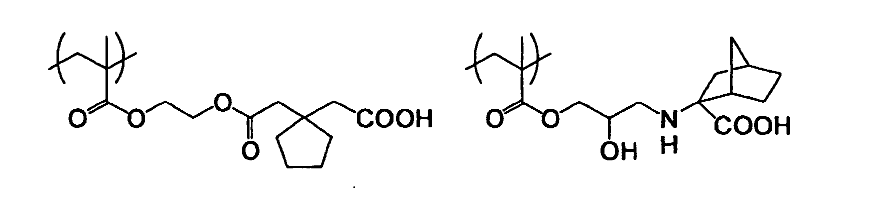

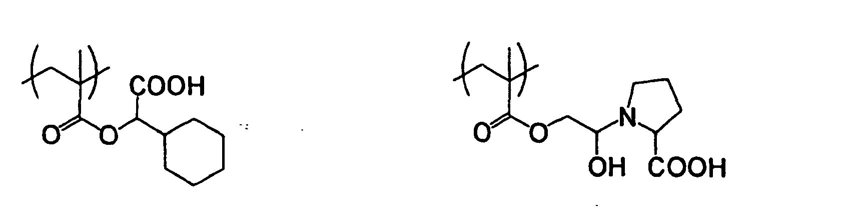

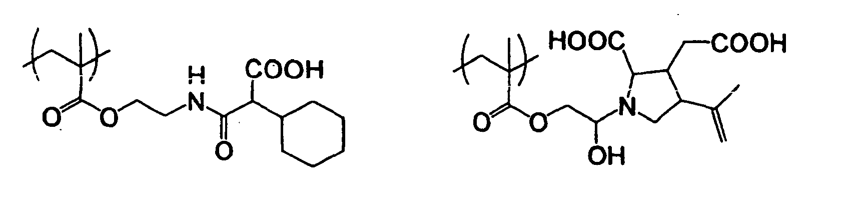

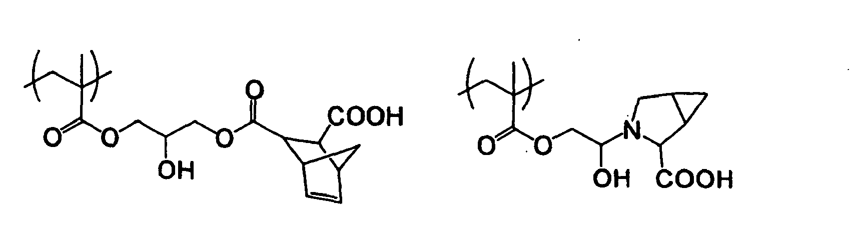

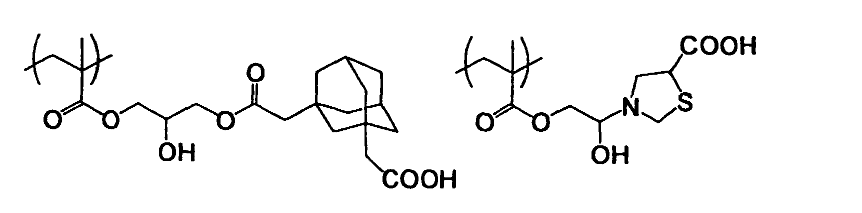

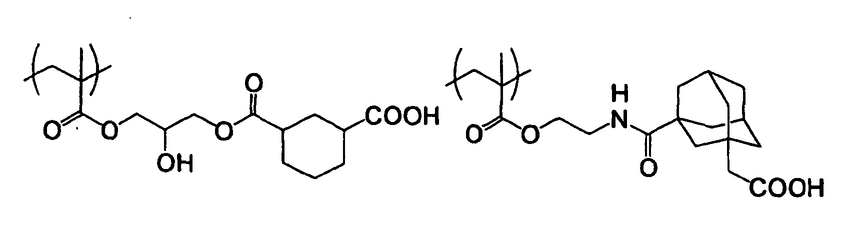

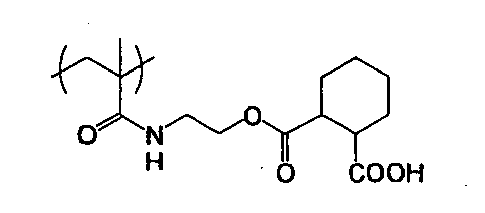

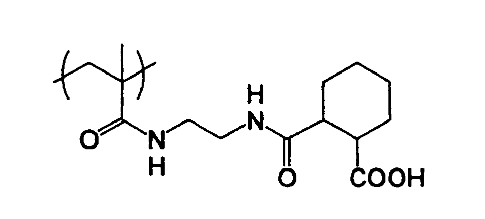

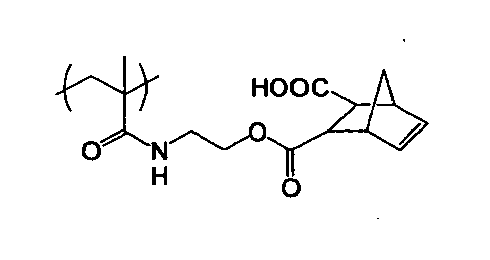

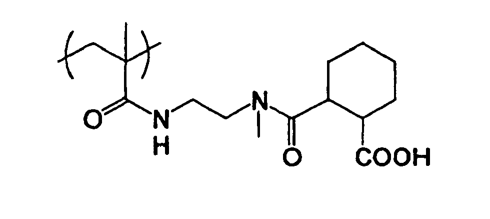

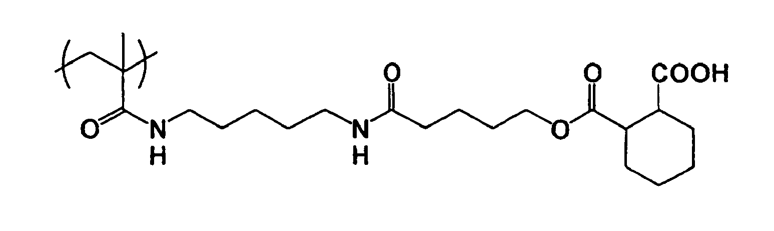

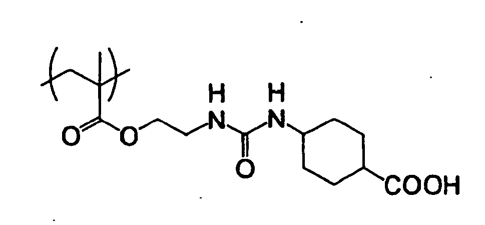

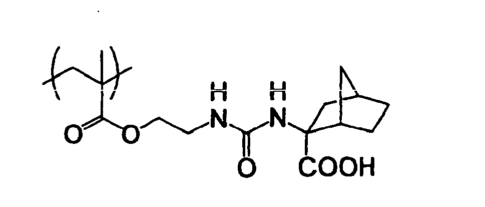

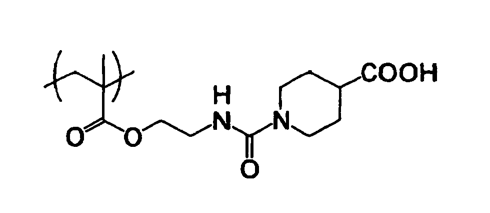

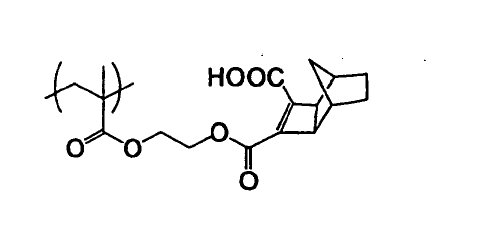

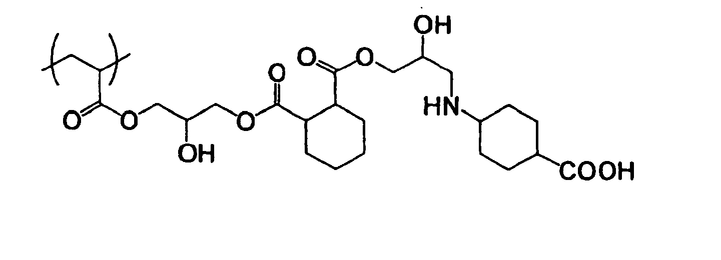

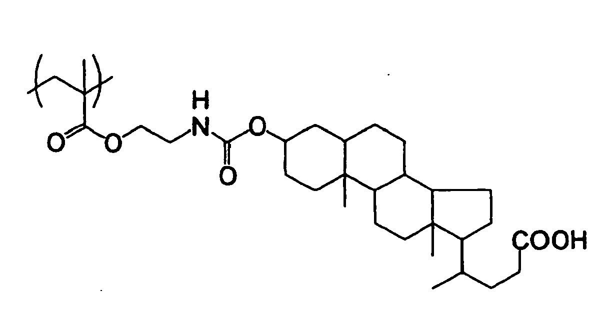

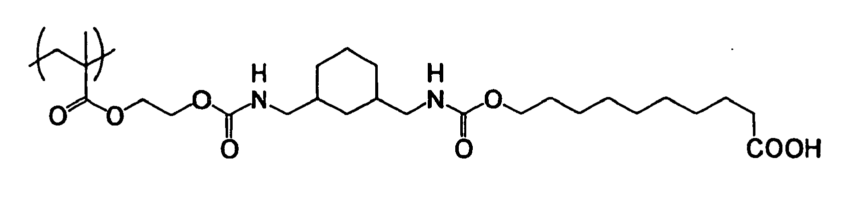

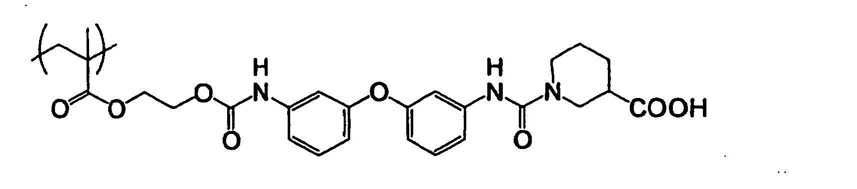

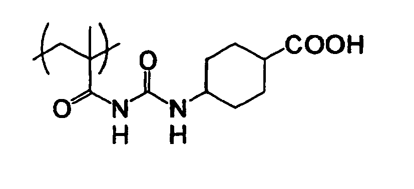

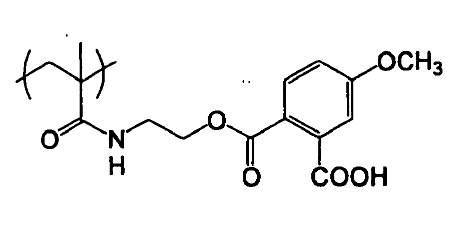

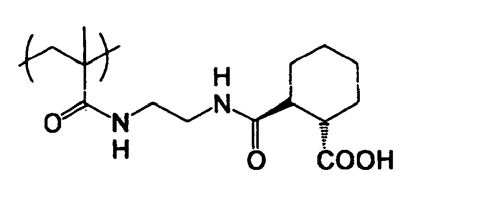

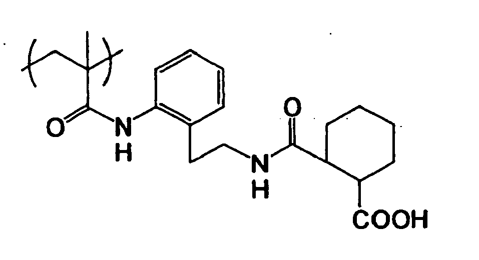

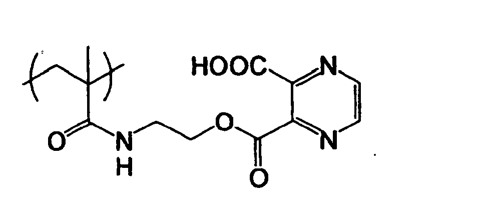

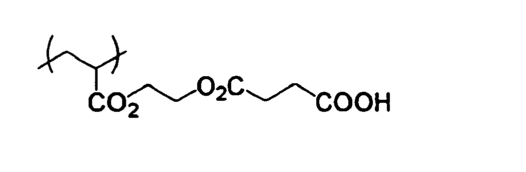

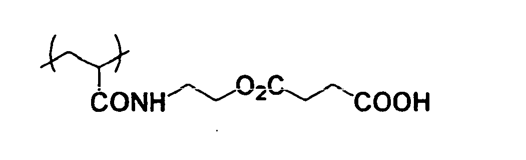

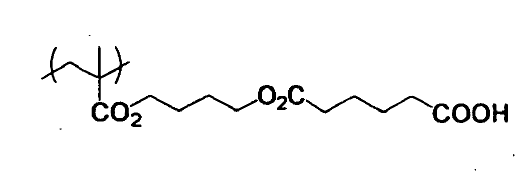

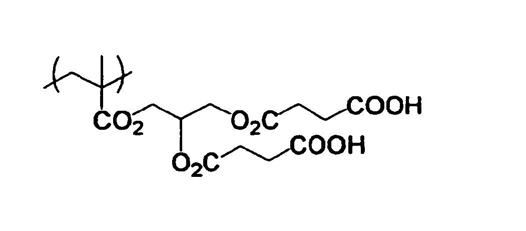

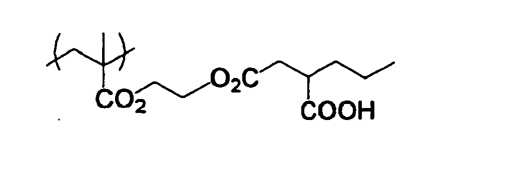

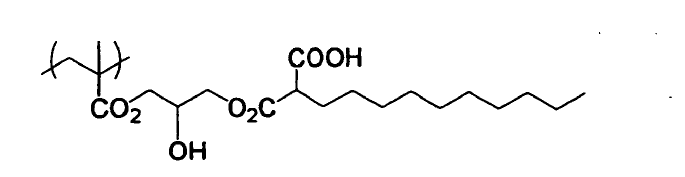

One repeating unit represented by formula (ii) may be contained in the binder polymer, or two or more kinds thereof may be contained. The specific binder polymer for use in the present invention may be a polymer comprising only the repeating unit represented by formula (ii) but is usually combined with other copolymerization components and used as a copolymer. The total content of the repeating unit represented by formula (ii) in the copolymer may be appropriately determined according to the structure of the copolymer, the design of the photosensitive composition and the like, but this repeating unit is usually contained in an amount of 1 to 99 mol%, more preferably from 5 to 40 mol%, still more preferably from 5 to 20 mol%, based on the total molar amount of the polymer components.

In the case of use as a copolymer, as for the copolymerization component, conventionally known monomers may be used without limitation as long as it is a radical-polymerizable monomer. Specific examples thereof include monomers described in Kobunshi Data Handbook -Koso Hen-(Polymer Data Handbook -Fundamental Version-), compiled by the Society of Polymer Science, Japan, Baifukan (1986). One of these copolymerization components may be used alone, or two or more thereof may be used in combination.

The molecular weight of the specific binder polymer for use in the present invention is appropriately determined from the viewpoint of image-forming property and press life. The molecular weight is preferably from 2,000 to 1,000,000, more preferably 5,000 to 500,000, still more preferably 10,000 to 200,000.

The binder polymer for use in the present invention may be the specific binder polymer alone or may be a mixture by using one or more other binder polymer in combination. The binder polymer used in combination is added in an amount of 1 to 60 mass%, preferably from 1 to 40 mass%, more preferably from 1 to 20 mass%, based on the total mass of the binder polymer components. As for the binder polymer usable in combination, conventionally known binder polymers may be used without limitation. Specific preferred examples thereof include an acrylic main-chain binder and a urethane binder, which are often used in this field.

The total amount of the specific binder polymer and the binder polymer which may be used in combination in the photosensitive composition may be appropriately determined, but this is usually from 10 to 90 mass%, preferably from 20 to 80 mass%, more preferably from 30 to 70 mass%, based on the total mass of the nonvolatile components in the photosensitive composition.

The acid value (meg/g) of such a binder polymer is preferably from 2.00 to 3.60.

If desired, various compounds such as co-sensitizer, colorant, plasticizer and thermopolymerization inhibitor may also be contained.

### [Co-Sensitizer]

The sensitivity of the photosensitive layer can be further enhanced by using a certain kind of additive (hereinafter referred to as a "co-sensitizer"). The operation mechanism thereof is not clearly known but is considered to mostly rely on the following chemical process.

That is, the co-sensitizer reacts with various intermediate active species (e.g., radical, peroxide, oxidant, reductant) generated in the process of photoreaction initiated by the light absorption of the photopolymerization initiation system described above and the subsequent addition-polymerization reaction, and a new active radical is produced.

The co-sensitizers are roughly classified into (a) to (c) below, but in many cases, a common view is not established about to which type individual compounds belong:
(a) a compound capable of producing an active radical by being reduced;
(b) a compound capable of producing an active radical by being oxidized; and
(c) a compound capable of reacting with a radical having low activity to convert it into a more highly active radical or acting as a chain transfer agent.

### (a) Compound capable of producing active radical by being reduced

### Compound having carbon-halogen bond:

An active radical is considered to be generated resulting from reductive cleavage of the carbon-halogen bond. Specific examples of this compound which can be suitably used include trihalomethyl-s-triazines and trihalomethyloxadiazoles.

### Compound having nitrogen-nitrogen bond:

An active radical is considered to be generated resulting from reductive cleavage of the nitrogen-nitrogen bond. Specific examples of this compound which can be suitably used include hexaarylbiimidazoles.

### Compound having oxygen-oxygen bond:

An active radical is considered to be generated resulting from reductive cleavage of the oxygen-oxygen bond. Specific examples of this compound which can be suitably used include organic peroxides.

### Onium compound:

An active radical is considered to be generated resulting from reductive cleavage of a carbon-hetero bond or an oxygen-nitrogen bond. Specific examples of this compound which can be suitably used include diaryliodonium salts, triarylsulfonium salts and N-alkoxypyridinium (azinium) salts.

### Ferrocene and iron arene complexes:

An active radical can be reductively produced.

### (b) Compound capable of producing active radical by being oxidized Alkylate complex:

An active radical is considered to be generated by resulting from oxidative cleavage of a carbon-hetero bond. Specific examples of this compound which can be suitably used include triaryl alkylborates. Alkylamine compound:

An active radical is considered to be generated resulting from oxidative cleavage of C-X bond on the carbon adjacent to nitrogen. X is preferably, for example, a hydrogen atom, a carboxyl group, a trimethylsilyl group or a benzyl group. Specific examples of this compound include ethanolamines, N-phenylglycines and N-trimethylsilylmethylanilines. Sulfur- or tin-containing compound:

This is a compound in which the nitrogen atom of the above-described amines is replaced by a sulfur atom or a tin atom. An active radical can be produced by the same activity. Also, a compound having an S-S bond is known to effect sensitization by the S-S cleavage.

### α-Substituted methylcarbonyl compound:

An active radical can be produced resulting from oxidative cleavage of a carbonyl-α carbon bond. A compound in which the carbonyl is converted into an oxime ether also shows the same activity. Specific examples of this compound include 2-alkyl-1-[4-(alkylthio)phenyl]-2-morpholinopronone-1 compounds and oxime ethers obtained by reacting such a compound with hydroxyamines and then etherifying N-OH.

### Sulfinic acid salts:

An active radical can be reductively produced. Specific examples of this compound include sodium arylsulfinate.

### (c) Compound capable of reacting with radical to convert it into highly active radical or acting as chain transfer agent:

For example, compounds having SH, PH, SiH or GeH within the molecule may be used. Such a compound can produce a radical by donating hydrogen to a low-activity radical species or by being oxidized and then deprotonated. Specific examples of this compound include 2-mercaptobenzimidazoles.

A large number of examples of the co-sensitizer are more specifically described, for example, in JP-A-9-236913 as an additive for enhancing the sensitivity. Some of these are set forth below, but the present invention is not limited thereto. 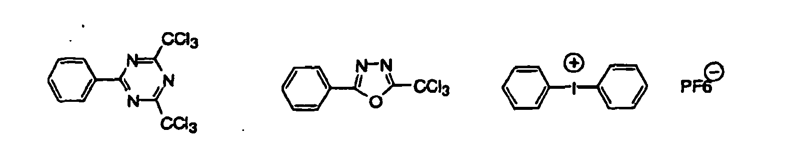 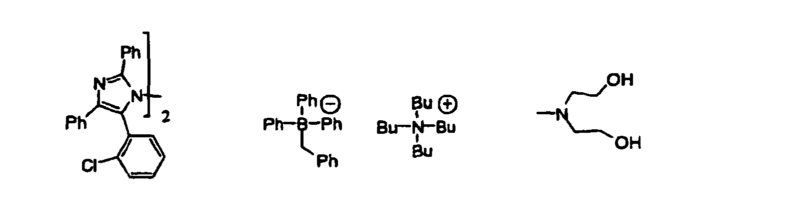 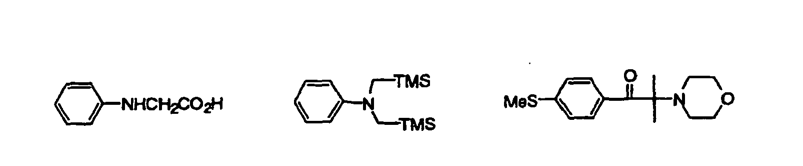 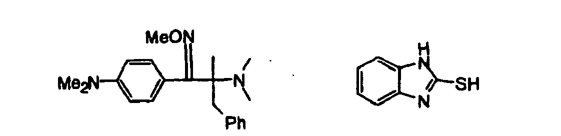 such a co-sensitizer may also be subjected to various chemical modifications so as to improve the properties of the photosensitive layer.

One of these co-sensitizers can be used alone, or two or more thereof may be used in combination.

The amount of the co-sensitizer added is usually from 0.05 to 100 parts by mass, preferably from 1 to 80 parts by mass, more preferably from 3 to 50 parts by mass, per 100 parts by mass of the polymerizable compound having an ethylenically unsaturated double bond.

### [Thermopolymerization Inhibitor]

In the present invention, in addition to these fundamental components, a small amount of a thermopolymerization inhibitor is preferably added so as to prevent unnecessary thermopolymerization of the polymerizable ethylenically unsaturated bond-containing compound during the production or storage of the photosensitive layer. Suitable examples of the thermopolymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol), N-nitroso-N-phenylhydroxylamine cerous salt and N-nitroso-N-phenylhydroxylamine aluminum salt.

The amount of the thermopolymerization inhibitor added is preferably from about 0.01 to about 5 mass% based on the entire solid content of the photosensitive layer. Also, if desired, a higher fatty acid derivative or the like, such as behenic acid and behenic acid amide, may be added and allowed to localize on the surface of the photosensitive layer in the process of drying after coating so as to prevent polymerization inhibition by oxygen. The amount of the higher fatty acid derivative or the like added is preferably from about 0.5 to about 10 mass% based on all solid contents constituting the photosensitive layer.

### [Colorant, Plasticizer]

Furthermore, a colorant may be added for the purpose of coloring the photosensitive layer. Examples of the colorant include pigments such as phthalocyanine-based pigment (e.g., C.I. Pigment Blue 15:3, 15:4, 15:6), azo-based pigment, carbon black and titanium oxide, Ethyl Violet, Crystal Violet, an azo dye, an anthraquinone-based dye and a cyanine-based dye. The amount of the dye or pigment added is preferably from about 0.5 to about 20 mass% based on the entire composition. In addition, an additive such as inorganic filler and plasticizer (e.g., dioctyl phthalate, dimethyl phthalate, tricresyl phosphate) may be added for improving the physical properties of the cured film. The amount of such an additive added is preferably 10 mass% or less based on the entire composition.

### [Support]

The support used for the photosensitive lithographic printing plate of the present invention is preferably a support having a hydrophilic surface (hydrophilic support). As for the hydrophilic support, conventionally known supports employed for a lithographic printing plate may be used without limitation. The support used is preferably a dimensionally stable plate-like material, for example, paper, paper laminated with plastic (e.g., polyethylene, polypropylene, polystyrene), a metal plate (e.g., aluminum, zinc, copper), a plastic film (e.g., cellulose diacetate, cellulose triacetate, polyethylene terephthalate, polyethylene, polystyrene, polypropylene, polycarbonate, polyvinyl acetal), and paper or plastic film having laminated or vapor-deposited thereon the above-described metal. If desired, the surface of such a support may be subjected to an appropriate known physical or chemical treatment for the purpose of imparting hydrophilicity, increasing strength, or the like.

Preferred examples of the support include paper, a polyester film and an aluminum plate. Among these, an aluminum plate is more preferred because this has good dimensional stability, is relatively inexpensive and can provide a surface excellent in the hydrophilicity and strength by a surface treatment as needed. Furthermore, a composite sheet comprising a polyethylene terephthalate film having bonded thereon an aluminum sheet described in JP-B-48-18327 is also preferred.

The aluminum substrate is a dimensionally stable metal plate mainly comprising aluminum, and this is selected from a pure aluminum plate, an alloy plate mainly comprising aluminum and containing a small amount of foreign elements, and a plastic film or paper having laminated or vapor-deposited thereon aluminum (or an alloy thereof).

In the following description, the substrate comprising aluminum and the substrate comprising an aluminum alloy are collectively referred to as an aluminum substrate. Examples of the foreign element contained in the aluminum alloy include silicon, iron, manganese, copper, magnesium, chromium, zinc, bismuth, nickel and titanium. The foreign element content in the alloy is 10 mass% or less. In the present invention, a pure aluminum plate is preferred, but perfectly pure aluminum is difficult to produce in view of the refining technique and therefore, an aluminum plate containing a trace foreign element may be used.

Such an aluminum plate for use in the present invention is not particularly limited in its composition, and those formed of a conventionally known and commonly employed material such as JIS A 1050, JIS A 1100, JIS A 3103 and JIS A 3005 can be appropriately used. The thickness of the aluminum substrate for use in the present invention is approximately from 0.1 to 0.6 mm, preferably from 0.15 to 0.4 mm, more preferably from 0.2 to 0.3 mm. This thickness may be appropriately changed depending on the size of printing press, the size of printing plate or the demands of users. The aluminum substrate may be appropriately subjected, if desired, to a substrate surface treatment described later. Of course, the aluminum substrate may not be subjected to such a surface treatment.

### [Surface-Roughening Treatment]

The aluminum substrate is usually subjected to a surface-roughening treatment. The surface-roughening treatment method includes mechanical surface roughening, chemical etching, electrolytic graining and the like as disclosed in JP-A-56-28893. Also, an electrochemical surface-roughening method of electrochemically roughening the surface in a hydrochloric acid or nitric acid electrolytic solution, or a mechanical surface-roughening method such as a ball graining method of graining the aluminum surface with polishing balls and an abrasive, and a brush graining method of roughening the surface with a nylon brush and an abrasive, may be used. These surface-roughening methods may be used individually or in combination. Among these, the method useful for the surface roughening is an electrochemical method of chemically roughening the surface in a hydrochloric acid or nitric acid electrolytic solution, where the quantity of electricity at the anode time is suitably from 50 to 400 C/dm². More specifically, AC and/or DC electrolysis is preferably performed in an electrolytic solution containing from 0.1 to 50% of hydrochloric acid or nitric acid under the conditions such that the temperature is from 20 to 80°C, the treating time is from 1 second to 30 minutes and the current density is from 100 to 400 C/dm².

The surface-roughened aluminum substrate may be chemically etched with an acid or an alkali. Examples of the etching agent which is suitably used include sodium hydroxide, sodium carbonate, sodium aluminate, sodium metasilicate, sodium phosphate, potassium hydroxide and lithium hydroxide. The concentration and the temperature are preferably from 1 to 50% and from 20 to 100°C, respectively. After the etching, pickling is performed so as to remove smut remaining on the surface. Examples of the acid used therefor include nitric acid, sulfuric acid, phosphoric acid, chromic acid, hydrofluoric acid and borofluoric acid. In particular, as for the method of removing smut after the electrochemical surface-roughening treatment, a method of contacting the substrate surface with 15 to 65 mass% of sulfuric acid at a temperature of 50 to 90°C described in JP-A-53-12739, and a method of alkali-etching the substrate surface described in JP-B-48-28123 are preferred. As long as the center line average roughness Ra on the treated surface after such a treatment is from 0.2 to 0.55 µm, the method and the conditions are not particularly limited.

### [Anodization Treatment]

The thus surface-roughened aluminum substrate is then subjected to an anodization treatment to form an oxide film. In the anodization treatment, a sole aqueous solution of sulfuric acid, phosphoric acid, oxalic acid, or boric acid/sodium borate, or a combination of multiple kinds of such aqueous solutions is used as the main component of the electrolytic bath. At this time, the electrolytic solution may of course contain the components usually contained at least in aluminum alloy plate, electrode, tap water, underground water and the like. In the electrolytic solution, second and third components may be further added. Examples of the second and third components as used herein include a cation such as metal (e.g., Na, K, Mg, Li, Ca, Ti, Al, V, Cr, Mn, Fe, Co, Ni, Cu, Zn) ion and ammonium ion, and an anion such as nitrate ion, carbonate ion, chloride ion, phosphate ion, fluoride ion, sulfite ion, titanate ion, silicate ion and borate ion. The concentration of the ion contained is approximately from 0 to 10,000 ppm. The conditions for the anodization treatment are not particularly limited, but the treatment is preferably performed by DC or AC electrolysis at a concentration of 30 to 500 g/liter, a treating solution temperature of 10 to 70°C and a current density of 0.1 to 40 A/m². The thickness of the anodic oxide film formed is from 0.5 to 1.5 µm, preferably from 0.5 to 1.0 µm.

A substrate subjected to, after such a treatment, undercoating with a water-soluble resin (e.g., polyvinylphosphonic acid, a polymer or copolymer having a sulfonic group in the side chain), a polyacrylic acid, a water-soluble metal salt (e.g., zinc borate), a yellow dye, an amine salt or the like, is also suitable. Furthermore, a sol-gel treated substrate obtained through covalent bonding with a functional group capable of causing an addition reaction by the effect of a radical disclosed in JP-A-7-159983 may also be suitably used.

Other preferred examples include those where a water-resistant hydrophilic layer is provided as the surface layer on an arbitrary support. Examples of such a surface layer include a layer comprising an inorganic pigment and a binder described in U.S. Patent 3,055,295 and JP-A-56-13168; a hydrophilic swelling layer described in JP-A-9-80744; and a sol-gel film comprising titanium oxide, polyvinyl alcohol and a silicate described in JP-T-8-507727 (the term "JP-T" as used herein means a "published Japanese translation of a PCT patent application"). Such a hydrophilic treatment is applied not only to render the support surface hydrophilic but also, for example, to prevent a harmful reaction of the photopolymerizable composition provided thereon and enhance the adhesion of the photosensitive layer.

The surface roughness of the thus-produced aluminum support is preferably, in terms of the Ra indication, from 0.2 to 0.55 µm. When the surface roughness Ra is 0.2 µm or more, incomplete graining of the aluminum support may be more successfully suppressed and a higher press life can be ensured. Also, when Ra is 0.55 µm or less, the reproducibility of dot or fine line can be more successfully prevented from reduction due to retarded progress of photopolymerization in the deep grained portion. The surface roughness Ra (grained roughness) is more preferably from 0.25 to 0.5 µm, and most preferably from 0.3 to 0.45 µm.

A photopolymerizable photosensitive layer described above is formed on the thus surface-treated aluminum support, whereby the photosensitive lithographic printing plate of the present invention is produced. If desired, an organic or inorganic undercoat layer may be provided before providing the photosensitive layer.

### [Undercoat Layer]

Before providing the photosensitive layer on the aluminum plate, an organic undercoat layer is provided, if desired. The organic compound used for the organic undercoat layer is selected, for example, from carboxymethyl cellulose; dextrin; gum arabic; phosphonic acids having an amino group, such as 2-aminoethylphosphonic acid; an organic phosphonic acid such as phenylphosphonic acid, naphthylphosphonic acid, alkylphosphonic acid, glycerophosphonic acid, methylenediphosphonic acid and ethylenediphosphonic acid, which may have a substituent; an organic phosphoric acid ester such as phenylphosphoric acid, naphthylphosphoric acid, alkylphosphoric acid and glycerophosphoric acid, which may have a substituent; an organic phosphinic acids such as phenylphosphinic acid, naphthylphosphinic acid, alkylphosphinic acid and glycerophosphinic acid, which may have a substituent; amino acids such as glycine and β-alanine; and a hydrochloride of a hydroxy group-containing amine, such as hydrochloride of triethanolamine. Two or more of these compounds may be used as a mixture.

After the surface treatment is performed, a water-soluble resin (for example, a polyvinylphosphonic acid, a polymer or copolymer having a sulfonic group in the side chain (see, JP-A-59-101651), a polyacrylic acid or a water-soluble metal salt (e.g., zinc borate)), a yellow dye or an amine salt may be provided as the undercoat layer. Furthermore, a sol-gel treated substrate obtained through covalent bonding with a functional group capable of causing an addition reaction by the effect of a radical disclosed in JP-A-7-159983 may also be suitably used.

Other preferred examples include those where a water-resistant hydrophilic layer is provided as the surface layer on an onium group-containing undercoat layer or an arbitrary support described in JP-A-2003-021908. Examples of such a surface layer include a layer comprising an inorganic pigment and a binder described in U.S. Patent 3,055,295 and JP-A-56-13168; a hydrophilic swelling layer described in JP-A-9-80744; and a sol-gel film comprising titanium oxide, polyvinyl alcohol and a silicate described in JP-T-8-507727. Such a hydrophilic treatment is applied not only to render the support surface hydrophilic but also, for example, to prevent a harmful reaction of the photopolymerizable composition provided thereon and enhance the adhesion of the photosensitive layer.

The coverage of the undercoat layer is, in terms of the dry mass, generally from 0.5 to 500 mg/m², preferably from 1 to 100 mg/m².

### [Backcoat Layer]

After a surface treatment is applied to the support or an undercoat layer is formed thereon, a backcoat layer may be provided on the back surface of the support, if desired.

Suitable examples of the backcoat layer include a coat layer comprising an organic polymer compound described in JP-A-5-45885 or comprising a metal oxide obtained by the hydrolysis and polycondensation of an organic or inorganic metal compound described in JP-A-6-35174. In particular, an alkoxy compound of silicon, such as Si(OCH₃)₄, Si(OC₂H₅)₄, Si(OC₃H₇)₄ and Si(OC₄H₉)₄, is preferably used, because the raw material is inexpensive and easily available.

### [Coating Solution]

At the time of providing the photosensitive layer by coating, the above-described components are dissolved in a solvent to prepare a coating solution.

Examples of the solvent used here include an organic solvent such as acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethylsulfoxide, γ-butyrolactone, methyl lactate and ethyl lactate. These solvents may be used individually or as a mixture thereof. These solvents may be used individually or in combination.

The solid content concentration in the coating solution is usually from 1 to 50 mass%.

### [Protective Layer]

The photosensitive lithographic printing plate has a water-soluble polymer-containing protective layer on the photosensitive layer. The water-soluble polymer contained in the protective layer is preferably, for example, a water-soluble polymer compound having relatively excellent crystallinity. Specifically, this is a water-soluble polymer such as polyvinyl alcohol (PVA), polyvinylpyrrolidone, acidic celluloses, gelatin, gum arabic and polyacrylic acid. Among these, when a polyvinyl alcohol is used as the main component, most excellent results are obtained with respect to fundamental properties such as oxygen-blocking property and removability. As long as the polyvinyl alcohol contains an unsubstituted vinyl alcohol unit for imparting required oxygen-blocking property and water solubility, it may be partially substituted by an ester, an ether or an acetal or may have partially another copolymerization component. Preferred examples of the polyvinyl alcohol include those having a hydrolysis degree of 71 to 100% and a molecular amount of 300 to 2,400.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (for example, selection of PVA and use of additives), coated amount and the like of the protective layer are selected by taking account of fogging, adhesion, scratch resistance and the like in addition to the oxygen-blocking property and removability. In general, as the PVA used has a higher percentage of hydrolysis (namely, as the unsubstituted vinyl alcohol unit content in the protective layer is higher) or as the film thickness is larger, the oxygen-blocking property is more enhanced and this is advantageous in view of sensitivity. However, if the oxygen-blocking property is excessively intensified, unnecessary polymerization reaction may occur during production or stock storage or there may arise a problem of causing unnecessary fogging or thickening of image line at the image exposure. The adhesion to the image area and the scratch resistance are also very important in view of handling of the plate. More specifically, when a hydrophilic layer comprising a water-soluble polymer is stacked on a lipophilic polymerized layer, film separation readily occurs due to insufficient adhesive strength and the separated portion gives rise to defects such as curing failure ascribable to polymerization inhibition by oxygen.

The proportion of the water-soluble polymer in the protective layer is usually from 40 to 100 mass%, preferably from 80 to 95 mass%, based on the entire mass of the protective layer.

The coverage of the protective layer is, in terms of the dry mass, generally from 0.1 to 10 g/m², preferably from 0.5 to 5 g/m².

As for the protective layer in the present invention, known techniques on the protective layer may be applied, and examples thereof include the following technique.

The protective layer prevents a low molecular compound such as oxygen and basic substance present in the air, which inhibits the image forming reaction generated upon exposure in the photosensitive layer, from mingling into the photosensitive layer and enables exposure in the air. Accordingly, the property required of the protective layer is to have low permeability to a low molecular compound such as oxygen. Furthermore, the protective layer preferably ensures that it does not substantially disturb the transmission of light used for exposure, exhibits excellent adhesion to the photosensitive layer and is easily removable by water washing after exposure. In this respect, the techniques on the protective layer described in U.S. Patent 3,458,311 and JP-B-55-49729 may be applied.

Various proposals have been made with an attempt to improve the adhesion between the photosensitive layer and the protective layer. For example, U.S. Patents 292,501 and 44,563 describe a technique of mixing from 20 to 60 mass% of an acrylic emulsion, a water-insoluble vinyl pyrrolidone-vinyl acetate copolymer, or the like in a hydrophilic polymer mainly comprising polyvinyl alcohol and stacking the resulting solution on the polymerized layer, thereby obtaining sufficiently high adhesion. The coating method for such a protective layer is described in detail, for example, in U.S. Patent 3,458,311 and JP-B-55-49729.

Furthermore, other functions may also be imparted to the protective layer. For example, when a colorant (for example, a water-soluble dye) excellent in the transparency to light used for exposure and capable of efficiently absorbing light at 550 nm or more is added, safelight aptitude can be more enhanced without causing reduction in the sensitivity.

### [Examples]

The present invention is described in greater detail below by referring to the Examples, but the present invention should not be construed as being limited to these Examples.

### [Examples 1 to 10 and Comparative Examples 1 to 4]

A 0.3 mm-thick aluminum plate was etched by dipping it in 10 mass% sodium hydroxide at 60°C for 25 seconds, washed with running water, washed for neutralization with 20 mass% of nitric acid and then washed with water.

The resulting plate was subjected to an electrolytic surface-roughening treatment in an aqueous 1 mass% nitric acid solution by using a sinusoidal wave alternating current at an anodic time electricity of 300 coulomb/dm². Subsequently, the aluminum plate was dipped in an aqueous 1 mass% sodium hydroxide solution at 40°C for 5 seconds, desmutted at 60°C for 40 seconds in an aqueous 30 mass% sulfuric acid solution, and then anodized in an aqueous 20 wt% sulfuric acid solution for 2 minutes at a current density of 2 A/dm² to have an anodic oxide film thickness of 2.7 g/m². The surface roughness was measured and found to be 0.3 µm (Ra indication according to JIS B0601).

### [Coating of Undercoat Layer]

Thereafter, the coating solution for providing an undercoat layer, having the following composition, was coated on the aluminum support by a wire bar and then dried by a hot air drier at 90°C for 30 seconds. The coverage after drying was 10 mg/m².

### (Coating Solution for Providing Undercoat Layer)

| | |
|---|---|
| A 75/25 (by mol) copolymer of ethyl methacrylate and sodium 2-acrylamido-2-methyl-1-propanesulfonate (molecular weight: 18,000) | 0.1 g |
| 2-Aminoethylphosphonic acid | 0.1 g |
| Methanol | 50 g |
| Ion exchanged water | 50 g |

### [Coating of Photosensitive Layer]

A coating solution for photosensitive layer having the following composition was prepared and coated on the undercoat layer by using a wheeler to have a dry thickness of 0.15 g/m² and then dried at 100°C for one minute.

### (Coating Solution for Photosensitive Layer)

| | |
|---|---|
| Ethylenically unsaturated compound: | 1.5 g |
| pentaerythritol tetraacrylate | |
| Binder having a structure shown below | 1.8 g |
| 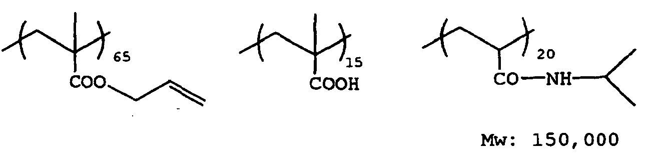 | |
| Sensitizing dye having a structure shown below | 0.1 g |
| 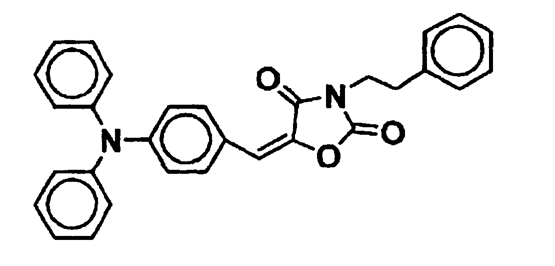 | |
| Polymerization inititor having a strcture shown below | 0.15 g |
| 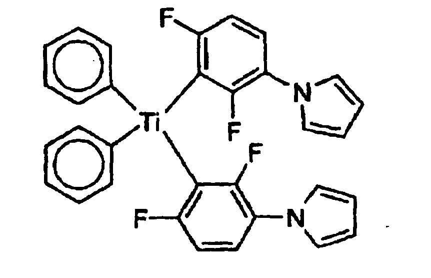 | |
| Sensitization aid having a structure shown below | 0.2 g |
| 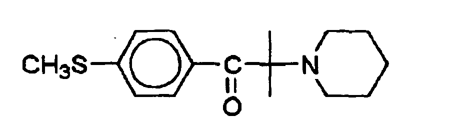 | |
| Specific copolymer or comparative copolymer (compound shown in Table 1) | 0.14 g |
| Color pigment dispersion having a composition described below | 1.5 g |
| Thermopolymerization inhibitor: | 0.01 g |
| N-nitrosophenylhydroxylamine | |
| Surfactant: Megafac F-176, produced by Dai-Nippon Ink & Chemicals, Inc. | |
| Methyl ethyl ketone | 20.0 g |
| Propylene glycol monomethyl ethyl | 20.0 g |

### (Composition of Pigment Dispersion)

| | |
|---|---|
| Pigment Blue 15:6 | 15 parts by mass |
| Allyl methacrylate/methacrylic acid copolymer (copolymerization molar ratio: 83/17 | 10 parts by mass |
| Cyclohexanone | 15 parts by mass |
| Methoxypropyl acetate | 20 parts by mass |
| Propylene glycol monomethyl ether | 40 parts by mass |

The structure of each comparative copolymer used in Comparative Examples is shown below together with its weight average molecular weight (Mw).

| Mw (ten-thousands) | | |
|---|---|---|
| AP-1 | 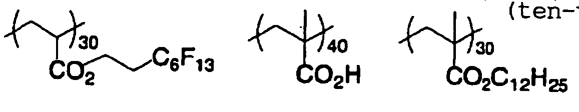 | 2.1 |
| AP-2 | 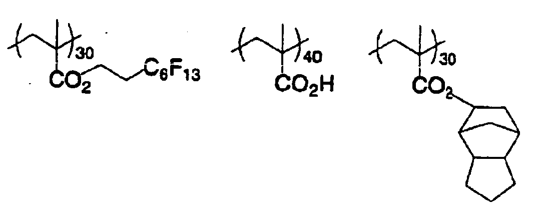 | 1.9 |
| AP-3 | 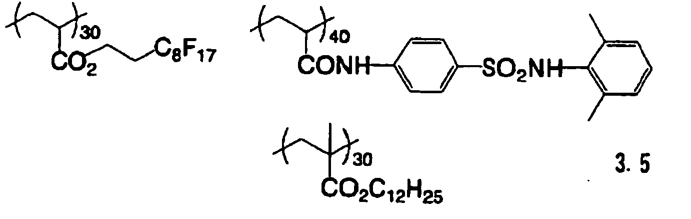 | 3.5 |
| AP-4 | 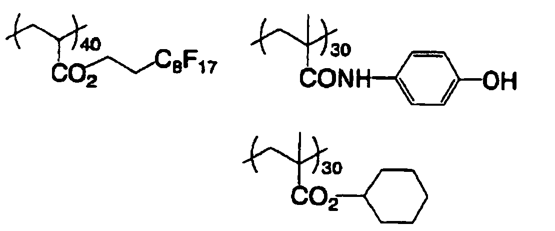 | 4.2 |
| AP-5 | 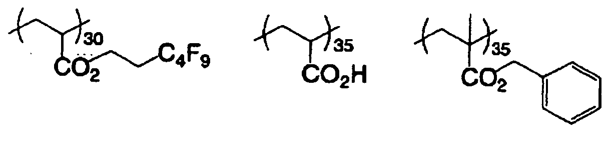 | 2.9 |
| AP-6 | 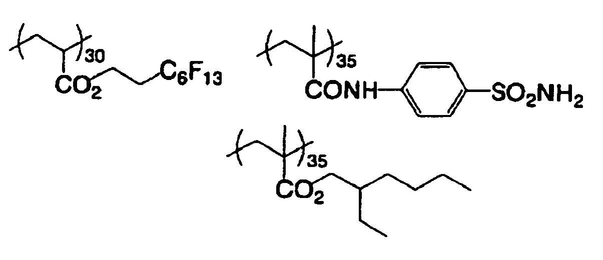 | 3.6 |

### [Coating of Protective Layer]

On this photosensitive layer, a coating solution for protective layer having the following composition was coated to have a dry coated mass of 2 g/m² and dried at 100°C for 2 minutes.

### (Composition of Coating Solution for Protective Layer)

| | |
|---|---|
| Polyvinyl alcohol (saponification degree: 98 mol%, polymerization degree: 550) | 4 g |
| Polyvinylpyrrolidone (molecular weight: 100,000) | 1 g |
| Water | 95 g |

### [Evaluation of Photosensitive Lithographic Printing Plate]

### 1. Presence or Absence of Sludge Generation

The thus-obtained photosensitive lithographic printing plate (1 m²) was developed with Developer (DV-1) shown below (produced by Fuji Photo Film Co., Ltd.) and evaluated on whether sludge due to a precipitate or aggregate originated in the specific copolymer according to the present invention was generated or not in the processing solution. The rating was "A" when the generation was not confirmed with an eye, and "B" when sludge generation due to an aggregate was confirmed. The results are shown in Table 1 below.

### 2. Inking Property

The lithographic printing plate precursor was imagewise exposed by Vx9600CTP manufactured by Fuji Photo Film Co., Ltd. with a setter exposure amount of 50 µJ/cm², and after charging a developer shown below and a finisher FP-2W produced by Fuji Photo Film Co., Ltd. into an automatic developing machine LP-850P2 (preheat temperature: 100°C) manufactured by Fuji Photo Film Co., Ltd., developed/processed for plate making under the conditions that the developer temperature was 30°C and the development time was 18 seconds, and a lithographic printing plate was thereby obtained. Incidentally, the protective layer was removed by washing with water at 25°C for 10 seconds in the automatic developing machine.

The obtained lithographic printing plate was loaded in a printing press and evaluated on the number of sheets printed until the ink was normally taken by the image area and a problem-free printed matter was obtained. As the number of sheets is smaller, the inking property is better. The results are shown in Table 1 below.

### (Aqueous Solution at pH of 11.6 Comprising the Following Composition)

| | |
|---|---|
| Sodium hydroxide | 0.15 parts by mass |
| Compound having a structure shown below | 5.0 parts by mass |
| Ethylenediaminetetraacetate tetrasodium salt | 0.1 part by mass |
| Water | 94.75 parts by mass |

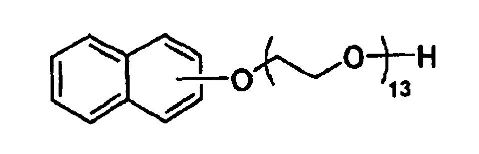

**Table 1**

| | Specific Copolymer | Sludge Generation | Inking Property |
|---|---|---|---|
| Example 1 | P-1 | A | 14 |
| Example 2 | P-2 | A | 14 |
| Example 3 | P-3 | A | 17 |
| Example 4 | P-4 | A | 16 |
| Example 5 | P-6 | A | 16 |
| Example 6 | P-7 | A | 13 |
| Example 7 | P-8 | A | 15 |
| Example 8 | P-9 | A | 12 |
| Example 9 | P-15 | A | 15 |
| Example 10 | P-16 | A | 17 |
| Comparative Example 1 | AP-1 | A | 33 |
| Comparative Example 2 | AP-2 | A | 28 |
| Comparative Example 3 | AP-3 | B | 8 |
| Comparative Example 4 | AP-4 | B | 12 |

As seen from Table 1, in the lithographic printing plates of Examples 1 to 10, improvement of the inking property was realized. Also, sludge generation ascribable to a precipitate in the developer was not observed. On the other hand, in the lithographic printing plates of Comparative Examples 1 and 2, the inking property was poor in either case as compared with those of Examples, and in the lithographic printing plates of Comparative Examples 3 and 4 using a copolymer having no carboxyl group, the inking property was good, but sludge generation ascribable to a precipitate in the developer was observed.

### [Examples 11 to 20 and Comparative Examples 5 to 8]

Photosensitive lithographic printing plates of Examples 11 to 20 and Comparative Examples 5 to 8 were produced thoroughly in the same manner as in Examples 1 to 10 and Comparative Examples 5 to 8 except for changing the ethylenically unsaturated bond-containing compound and the binder to the following compounds.

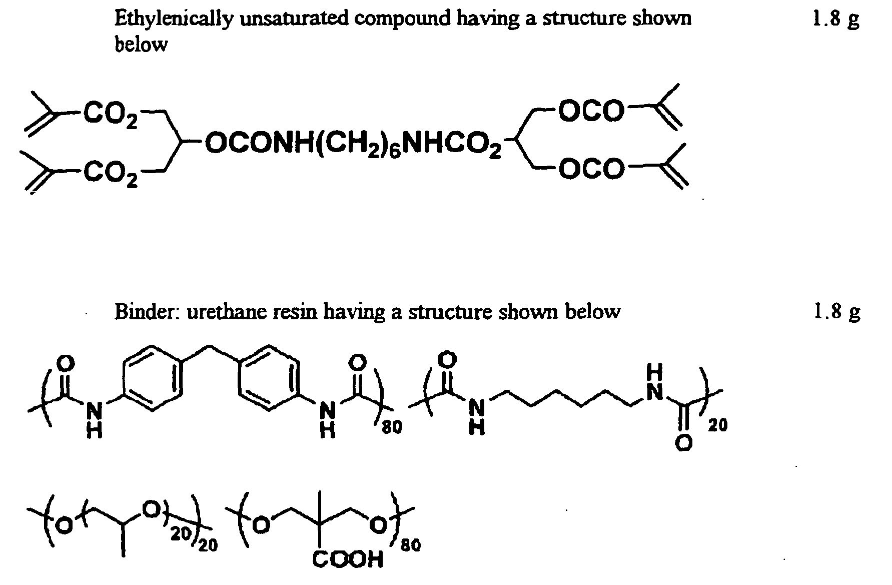

The thus-obtained lithographic printing plates were evaluated in the same manner as in Examples 1 to 10 and Comparative Examples 1 to 4. The results are shown in Table 2

**Table 2**

| | Specific Copolymer | Sludge Generation | Inking Property |
|---|---|---|---|
| Example 11 | P-1 | A | 17 |
| Example 12 | P-7 | A | 17 |
| Example 13 | P-8 | A | 18 |
| Example 14 | P-9 | A | 18 |
| Example 15 | P-14 | A | 19 |
| Example 16 | P-15 | A | 18 |
| Example 17 | P-16 | A | 18 |
| Example 18 | P-19 | A | 17 |
| Example 19 | P-20 | A | 17 |
| Example 20 | P-21 | A | 18 |
| Comparative Example 5 | AP-2 | A | 40 |
| Comparative Example 6 | AP-3 | A | 16 |
| Comparative Example 7 | AP-4 | B | 17 |
| Comparative Example 8 | AP-6 | B | 18 |

As seen from Table 2, in the lithographic printing plates of Examples 11 to 20, similarly to Examples 1 to 10, improvement of the inking property was realized. Also, sludge generation ascribable to a precipitate in the developer was not observed.

In the lithographic printing plate of Comparative Example 5, the inking property was poor as compared with those of Examples, and in the lithographic printing plates of Comparative Examples 6 to 8, the inking property was good, but the developability was bad and sludge generation ascribable to a precipitate in the developer was observed.

### [Examples 21 to 28 and Comparative Examples 9 and 10]

Photosensitive lithographic printing plates of Examples 21 to 28 *and Comparative Examples* 9 and 10 were produced thoroughly in the same manner as in Examples 1 to 10 and Comparative Examples 1 to 4 except for changing the ethylenically unsaturated compound, the binder, the sensitizing dye, the polymerization initiator and the sensitization aid to the followings.

| | |
|---|---|
| Ethylenically unsaturated compound having a structure shown below | 1.8 g |
| 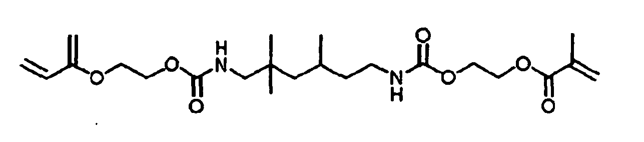 | |
| Binder having a structure shown below | 1.8 g |
| 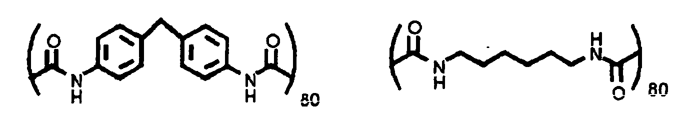 | |
| 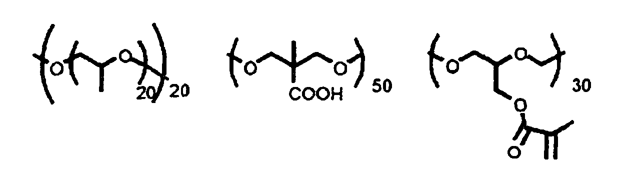 | |
| Sensitizing dye having a structure shown below | 0.1 g |
| 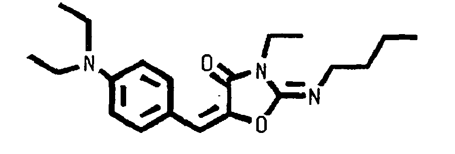 | |
| Polymeriation initiator having a structure shown below | 0.4 g |
| 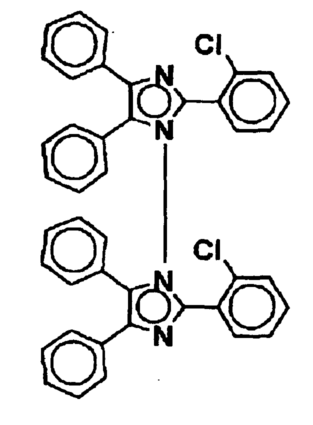 | |
| Sensitization aid having a structure shown below | 0.2 g |
| 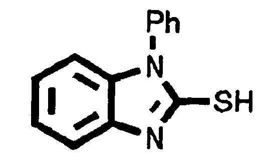 | |

The thus-obtained lithographic printing plates were evaluated in the same manner as in Examples 1 to 10 and Comparative Examples 1 to 4. The results are shown in Table 3.

**Table 3**

| | Specific Copolymer | Sludge Generation | Inking Property |
|---|---|---|---|
| Example 21 | P-1 | A | 18 |
| Example 22 | P-9 | A | 18 |
| Example 23 | P-10 | A | 17 |
| Example 24 | P-14 | A | 18 |
| Example 25 | P-15 | A | 20 |
| Example 26 | P-19 | A | 19 |
| Example 27 | P-20 | A | 18 |
| Example 28 | P-21 | A | 17 |
| Comparative Example 9 | AP-1 | A | 41 |
| Comparative Example 10 | AP-3 | B | 16 |

As seen from Table 3, in the lithographic printing plates of Examples 20 to 28, similarly to Examples 1 to 10, improvement of the inking property was realized. Also, sludge generation ascribable to a precipitate in the developer was not observed. On the other hand, in the lithographic printing plate of Comparative Example 9, the inking property was poor as compared with those of Examples, and in the lithographic printing plate of Comparative Example 10, sludge generation ascribable to a precipitate in the developer was observed, failing in achieving both inking property and suppression of sludge generation.

### [Example 31]

### (Production of Support)

An aluminum plate (according to JIS A1050) having a thickness of 0.30 mm and a width of 1,030 mm was subjected to the following surface treatment.

### <Surface Treatment>

In the surface treatment, the following treatments (a) to (f) were continuously performed. Incidentally, the liquid was squeezed out by nip rollers after each processing and water washing.
(a) The aluminum plate was etched under the conditions that the sodium hydroxide concentration was 26 mass%, the aluminum ion concentration was 6.5 mass% and the temperature was 70°C, to dissolve 5 g/m² of the aluminum plate and then washed with water.
(b) The aluminum plate was desmutted by spraying an aqueous solution having a nitric acid concentration of 1 mass% (containing 0.5 mass% of aluminum ion) at a temperature of 30°C and then washed with water.
(c) The aluminum plate was subjected to a continuous electrochemical surface roughening treatment by using an AC voltage of 60 Hz. At this time, the electrolytic solution was an aqueous 1 mass% nitric acid solution (containing 0.5 mass% of aluminum ion and 0.007 mass% of ammonium ion) at a temperature of 30°C. The electrochemical surface roughening treatment was performed by using an AC power source of giving a rectangular wave AC having a trapezoidal waveform such that the time TP necessary for the current value to reach the peak from zero was 2 msec and the duty ratio was 1:1, and disposing a carbon electrode as the counter electrode. The auxiliary anode was ferrite. The current density was 25 A/dm² in terms of the peak value of current, and the quantity of electricity was 250 C/dm² in terms of a total quantity of electricity when the aluminum plate was serving as the anode. Also, 5% of the current flowing from the power source was split to the auxiliary anode. Thereafter, the aluminum plate was washed with water.
(d) The aluminum plate was etched at 35°C by spraying an etching solution having a sodium hydroxide concentration of 26 mass% and an aluminum ion concentration of 6.5 mass% to dissolve 0.2 g/m² of the aluminum plate, so that the smut component mainly comprising aluminum hydroxide produced at the previous electrochemical surface roughening with use of AC could be removed and also the edge portion of a pit produced could be dissolved and smoothened. Thereafter, the aluminum plate was washed with water.
(e) The aluminum plate was desmutted by spraying an aqueous solution having a sulfuric acid concentration of 25 mass% (containing 0.5 mass% of aluminum ion) at a temperature of 60°C and then washed with water by spraying.
(f) The aluminum plate was subjected to an anodization treatment for 50 seconds under the conditions that the sulfuric acid concentration was 170 g/liter (containing 0.5 mass% of aluminum ion), the temperature was 33°C and the current density was 5 (A/dm²), and then washed with water. At this time, the mass of the anodic oxide film was 2.7 g/m².

The thus-obtained aluminum support had a surface roughness Ra of 0.27 (measuring meter: Surfcom manufactured by Tokyo Seimitsu Co., Ltd., probe tip diameter: 2 µm).

### <Undercoat Layer>

The following coating solution for undercoat layer was coated on the aluminum support by a wire bar and dried at 90°C for 30 seconds to form an undercoat layer. The coated amount after drying was 10 mg/m².

### (Coating Solution for Undercoat Layer)

| | |
|---|---|
| Polymer Compound A | 0.05 g |
| Methanol | 27 g |
| Ion exchanged water | 3 g |

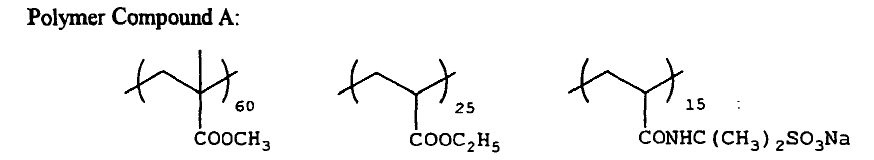

### [Photosensitive Layer]

The following Coating Solution [P-1] for Photosensitive Layer was prepared and coated on the undercoated aluminum support by using a wire bar. The drying was then performed by a hot air drier at 122°C for 43.5 seconds to form a photosensitive layer. The coverage after drying was 1.4 g/m².

### <Coating Solution [P-1] for Photosensitive Layer>

| | |
|---|---|
| Ultraviolet Absorbent (IR-1) | 0.08 g |
| Polymerization Initiator (OS-13) | 0.25 g |
| Dipentaerythritol hexaacrylate | 1.00 g |
| Binder Polymer (BT-1) (Mw: 100,000) | 1.00 g |
| Chloride salt of Ethyl Violet | 0.04 g |
| Specific polymer compound or comparative copolymer (shown in Table 1) | 0.03 g |
| Methyl ethyl ketone | 10.4 g |
| Methanol | 4.83 g |
| 1-Methoxy-2-propanol | 10.4 g |

The structures of Infrared Absorbent (IR-1), Polymerization Initiator (OS-13) and Binder Polymer (BT-1) used in the coating solution for photosensitive layer are shown below.

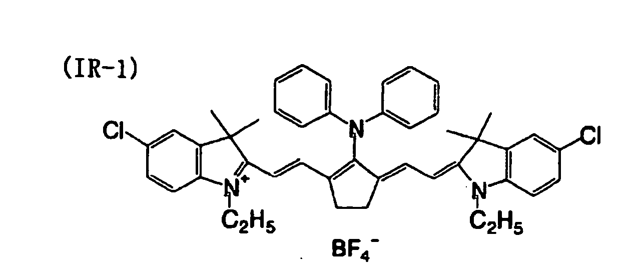

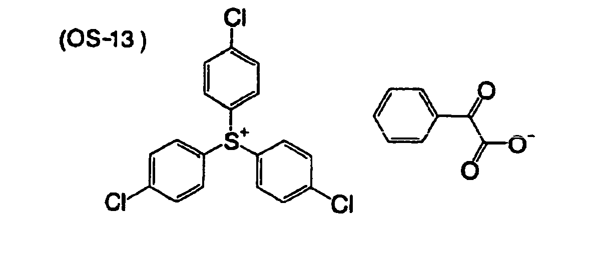

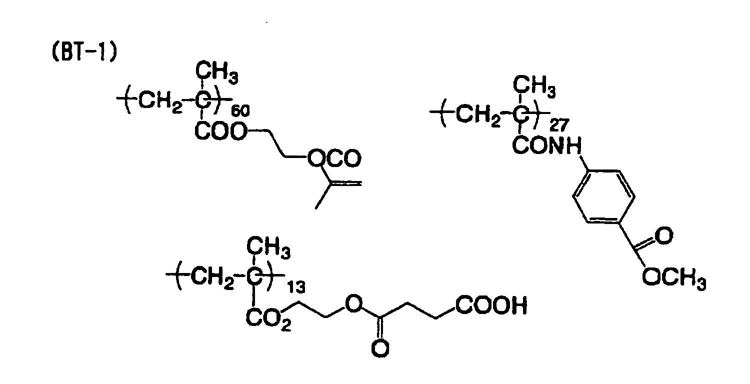

Comparative Copolymers [(AP-1) to (AP-6)] used in Comparative Examples were the same as those described above.

### [Protective Layer (Overcoat Layer)]

A mixed aqueous solution of polyvinyl alcohol (saponification degree: 98 mol%; polymerization degree: 500) and polyvinylpyrrolidone (Luviskol K-30, produced by BASF) was coated on the surface of the photosensitive layer by using a wire bar and dried by a hot air drier at 125°C for 75 seconds. The PVA content was 85 mass%, and the coated amount (coverage after drying) was 2.45 g/m².

In this way, a photosensitive lithographic printing plate precursor was obtained.

### (Evaluation of Lithographic Printing Plate Precursor)

### 1. Presence or Absence of Sludge Generation

The photosensitive lithographic printing plate precursor (1 m²) was developed with 100 ml of Developer (DH-N) produced by Fuji Photo Film Co., Ltd. and evaluated on whether sludge due to a precipitate or aggregate originated in the specific copolymer according to the present invention was generated or not in the processing solution. The rating was A when the generation was not confirmed with an eye, and B when sludge generation due to an aggregate was confirmed. The results are shown in Table 1 below.

### 2. Inking Property

The obtained lithographic printing plate precursor was exposed by Trendsetter 3244 manufactured by Creo set such that the resolution was 2,400 dpi and the rotation number of outer surface drum was 150 rpm, while varying the output in steps of logE=0.15 within the range from 0 to 8 W. The exposure was performed under the conditions of 25°C and 50% RH. After the exposure, without performing a heat treatment, the precursor was developed by using an automatic developing machine LP-1310 News manufacture by Fuji Photo Film Co., Ltd. at a developing temperature of 30°C and a conveying speed (line speed) of 2 m/min. Incidentally, a 1:4 water-diluted solution of DH-N was used as the developer and a 1:1 water-diluted solution of GN-2K produced by Fuji Photo Film Co., Ltd. was used as the finisher.

The lithographic printing plate obtained after the development was loaded in a printing press and evaluated on the number of sheets printed until the ink was normally taken by the image area and a problem-free printed matter was obtained. As the number of sheets is smaller, the inking property is better. The results are shown in Table 4 below.

**Table 4**

| | Specific Polymer Compound or Comparative Copolymer | Sludge Generation | Inking Property |
|---|---|---|---|
| Example 31 | P-1 | A | 12 |
| Example 32 | P-2 | A | 12 |
| Example 33 | P-3 | A | 14 |
| Example 34 | P-4 | A | 15 |
| Example 35 | P-6 | A | 15 |
| Example 36 | P-7 | A | 12 |
| Example 37 | P-8 | A | 13 |
| Example 38 | P-9 | A | 11 |
| Example 39 | P-15 | A | 14 |
| Example 40 | P-16 | A | 15 |
| Comparative Example 11 | AP-1 | A | 33 |
| Comparative Example 12 | AP-3 | B | 16 |
| Comparative Example 13 | AP-5 | A | 28 |
| Comparative Example 14 | AP-6 | B | 17 |

As seen from Table 4, in the lithographic printing plates of Examples 31 to 40, improvement of the inking property was realized. Also, sludge generation ascribable to a precipitate in the developer was not observed. On the other hand, in the lithographic printing plates of Comparative Examples 11 and 13 using a copolymer not having an aliphatic cyclic structure capable of shielding the hydrophilic carboxylic acid group present in the side chain and thereby inhibiting expression of hydrophilicity, the inking property was poor in either case as compared with those of Examples, and in the lithographic printing plates of Comparative Examples 12 and 14 using a copolymer having no carboxyl group, the inking property was good, but sludge generation ascribable to a precipitate in the developer was observed.

### (Examples 41 to 50 and Comparative Examples 15 to 18)

Photosensitive lithographic printing plate precursors of Examples 41 to 50 and Comparative Examples 15 to 18 were produced thoroughly in the same manner as in Examples 31 to 40 and Comparative Examples 11 to 14 except for changing the specific polymer compound or comparative compound contained in the photosensitive layer to the compound shown in Table 4 and changing the protective layer components to those described below. These lithographic printing plate precursors were evaluated in the same manner as in Example 31. The results are shown in Table 5 below.

### (Protective Layer Components)

| | |
|---|---|
| Water dispersion of synthetic mica (8%) (Somasif ME-100, produced by CO-OP Chemical Co., Ltd.) | 16 g |
| | |
| Polyvinyl alcohol having a saponification degree of 94 mol% (JM-05, produced by Japan Vam & Poval Co., Ltd., polymerization degree: 500) | 80 g |
| | |
| Copolymer of polyvinylpyrrolidone and vinyl acetate (LUVITEC VA64W, produced by ICP, polyvinylpyrrolidone/vinyl acetate = 6/4) | 2 g |
| | |
| Surfactant (EMALEX 710, produced by Nihon Emulsion Co., Ltd.) | 2 g |

**Table 5**

| | Specific Polymer Compound or Comparative Copolymer | Sludge Generation | Inking Property |
|---|---|---|---|
| Example 41 | P-1 | A | 15 |
| Example 42 | P-7 | A | 15 |
| Example 43 | P-8 | A | 16 |
| Example 44 | P-9 | A | 16 |
| Example 45 | P-14 | A | 18 |
| Example 46 | P-15 | A | 19 |
| Example 47 | P-16 | A | 19 |
| Example 48 | P-19 | A | 17 |
| Example 49 | P-20 | A | 15 |
| Example 50 | P-21 | A | 16 |
| Comparative Example 15 | AP-2 | A | 27 |
| Comparative Example 16 | AP-3 | B | 14 |
| Comparative Example 17 | AP-4 | B | 15 |
| Comparative Example 18 | AP-5 | A | 33 |

As seen from Table 5, in the lithographic printing plates of Examples 41 to 50, similarly to Examples 31 to 40, improvement of the inking property was realized. Also, sludge generation ascribable to a precipitate in the developer was not observed. Furthermore, from the comparison of Examples 31 to 40, it is understood that the effects of the present invention could be achieved irrespective of the formulation of protective layer.

In the lithographic printing plates of Comparative Examples 15 and 18, similarly to Comparative Examples 12 and 14, the inking property was poor as compared with those of Examples, and in the lithographic printing plates of Comparative Examples 16 and 17, the inking property was good, but the developability was bad and sludge generation ascribable to a precipitate in the developer was observed.

According to the present invention, there can be obtained a lithographic printing plate precursor ensuring that the inking property of the image area is excellent, a good printed matter is obtained and even when the plate-making process is continuously performed, generation of a precipitate such as development scum or sludge in the developer is suppressed.

## Claims

1. A photosensitive lithographic printing plate comprising:
a support; and
a polymerizable photosensitive layer that comprises:
an addition-polymerizable compound having an ethylenically unsaturated double bond;
a polymerization initiator; and
a polymer compound having (a) a monomer represented by formula (I) and (b) a monomer represented by formula (II) as copolymerization components: 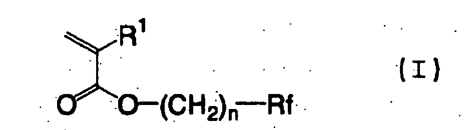
wherein Rf represents a substituent containing a fluoroalkyl or perfluoroalkyl group having 9 or more fluorine atoms;
n represents 1 or 2; and
R¹ represents a hydrogen atom or a methyl group; 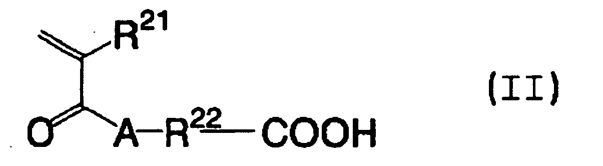
wherein R²¹ represents a hydrogen atom or a methyl group;
R²² represents a divalent hydrocarbon group having a carbon number of 3 to 30 and having an aliphatic cyclic structure;
A represents an oxygen atom or -NR²³-; and
R²³ represents a hydrogen atom or a monovalent hydrocarbon group having a carbon number of 1 to 10.

2. The photosensitive lithographic printing plate according to claim 1,
wherein the polymerizable photosensitive layer further comprises a sensitizing dye having an absorption maximum wavelength in a range of from 330 to 430 nm.

3. The photosensitive lithographic printing plate according to claim 2,
wherein the sensitizing dye is a compound represented by formula (4): 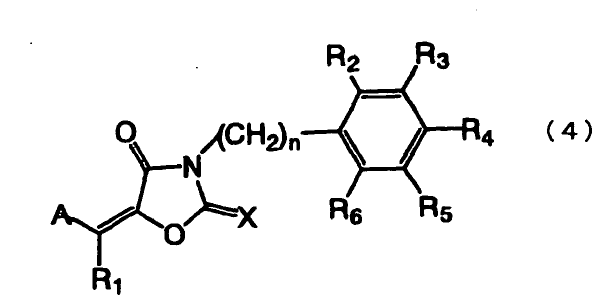 wherein A represents an aromatic or heterocyclic ring which may have a substituent;
X represents an oxygen atom, a sulfur atom or =NR₇;
R₁, R₂, R₃, R₄, R₅, R₆ and R₇ each independently represents a hydrogen atom or a monovalent nonmetallic atom group, provided that at least one of R₂, R₃, R₄, R₅ and R₆ represents a substituent represented by -OR₈, wherein each R₈ independently represents a monovalent nonmetallic atom group; and
n represents an integer of 1 to 6.

4. The photosensitive lithographic printing plate according to claim 3,
wherein the compound represented by formula (4) is a compound represented by formula (5): 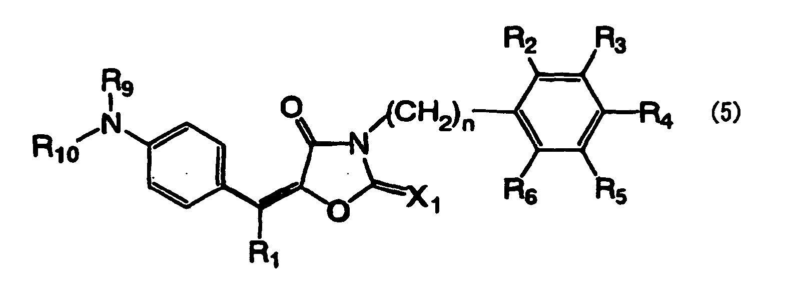 wherein X₁ represents an oxygen atom or a sulfur atom;
R₁, R₂, R₃, R₄, R₅ and R₆ each independently represents a hydrogen atom or a monovalent nonmetallic atom group;
R₉ and R₁₀ each independently represents a monovalent nonmetallic atom group, provided that at least one of R₂, R₃, R₄, R₅ and R₆ represents a substituent represented by -OR₈, wherein each R₈ independently represents a monovalent nonmetallic atom group; and
n represents an integer of 1 to 6.

5. The photosensitive lithographic printing plate according to claim 1,
wherein the polymerizable photosensitive layer further comprises an infrared absorbent having an absorption maximum wavelength in a range of from 750 to 1,400 nm.

6. The photosensitive lithographic printing plate according to claim 5,
wherein the infrared absorbent is a cyanine dye represented by formula (i): Formula (i): 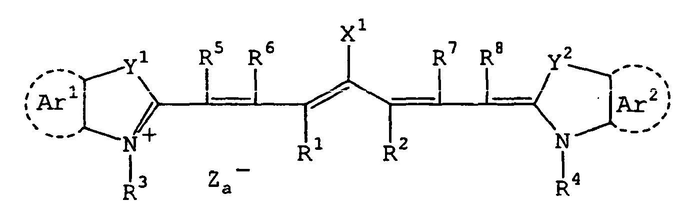 wherein X¹ represents a hydrogen atom, a halogen atom, -NPh₂, X²-L¹ or a group shown below, wherein X² represents an oxygen atom, a nitrogen atom or a sulfur atom, L¹ represents a hydrocarbon group having from 1 to 12 carbon atoms, an aromatic ring having a heteroatom, or a hydrocarbon group having from 1 to 12 carbon atoms and containing a heteroatom; 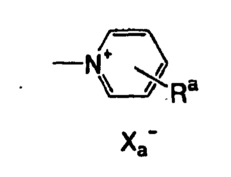
Xₐ⁻ has the same definition as Zₐ⁻ described below;
R^{a} represents a substituent selected from a hydrogen atom, an alkyl group, an aryl group, a substituted or unsubstituted amino group and a halogen atom;
R¹ and R² each independently represents a hydrocarbon group having from 1 to 12 carbon atoms;
Ar¹ and Ar² each independently represents an aromatic hydrocarbon group which may have a substituent;
Y¹ and Y² each independently represents a sulfur atom or a dialkylmethylene group having 12 or less carbon atoms;
R³ and R⁴ each independently represents a hydrocarbon group having 20 or less carbon atoms, which may have a substituent;
R⁵, R⁶, R⁷ and R⁸ each independently represents a hydrogen atom or a hydrocarbon group having 12 or less carbon atoms; and
Zₐ⁻ represents a counter anion but when a cyanine dye represented by formula (i) has an anionic substituent in its structure and a neutralization of electric charge is not necessary, Zₐ⁻ is not present.

7. The photosensitive lithographic printing plate according to claim 1,
wherein Rf in formula (I) represents a substituent containing a fluoroalkyl or perfluoroalkyl group having 13 to 25 fluorine atoms.

8. The photosensitive lithographic printing plate according to claim 1,
wherein the polymerizable photosensitive layer further comprises a binder polymer having a crosslinking group represented by any one of formulae (1) to (3): 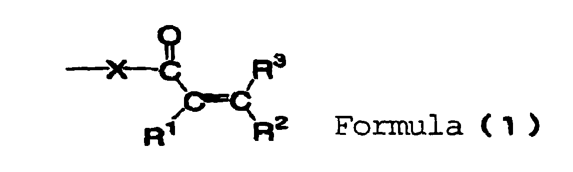 wherein in formula (1), R¹ to R³ each independently represents a hydrogen atom or a monovalent organic group;
X represents an oxygen atom, a sulfur atom or -N(R¹²)-; and
R¹² represents a hydrogen atom or a monovalent organic group; 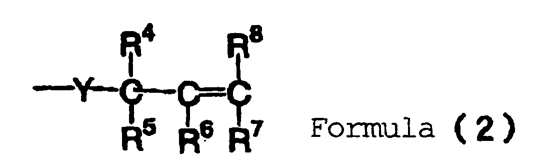
wherein in formula (2), R⁴ to R⁸ each independently represents a monovalent organic group;
Y represents an oxygen atom, a sulfur atom or N(R¹²)-; and
R¹² has the same meaning as R¹² in formula (1); 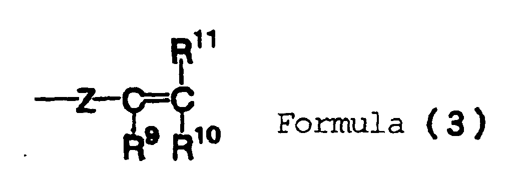 wherein in formula (3), R⁹ represents a hydrogen atom or an alkyl group which may have a
substituent;
R¹⁰ and R¹¹ each independently represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent;
Z represents an oxygen atom, a sulfur atom, -N(R¹³)- or a phenylene group which may have a substituent; and
R¹³ represents an alkyl group which may have a substituent.

9. The photosensitive lithographic printing plate according to claim 1,
wherein Rf in formula (I) represents one of following fluoroalkyl (meth)acrylates:
CH₂=CRCO₂(CH₂)ₘCₙF₂ₙ₊₁
wherein m represents 1 or 2, n represents an integer of 4 to 12, and R represents an alkyl group having a carbon number of 1 to 4; and
CH₂=CRCO₂(CH₂)ₘ(CF₂)ₙH
wherein m represents 1 or 2, n represents an integer of 4 to 12, and R represents an alkyl group having a carbon number of 1 to 4.

10. The photosensitive lithographic printing plate according to claim 2,
wherein the polymerization initiator is a hexaarylbiimidazole.

11. The photosensitive lithographic printing plate according to claim 5,
wherein the polymerization initiator is an onium salt.

## Patentansprüche

1. Fotoempfindliche Lithografie-Druckplatte, umfassend:
einen Träger; und
eine polymerisierbare fotoempfindliche Schicht, die umfasst:
eine additionspolymerisierbare Verbindung mit einer ethylenisch ungesättigten Doppelbindung;
einen Polymerisationsinitiator; und
eine Polymerverbindung, die (a) ein Monomer, das durch die Formel (I) dargestellt wird, und (b) ein Monomer, das durch die Formel (II) dargestellt wird, als Copolymerisationskomponenten aufweist: 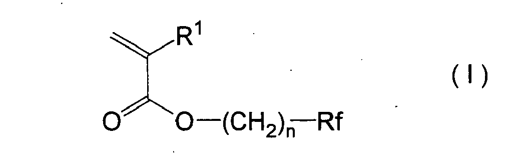
worin Rf einen Substituenten darstellt, der eine Fluoralkyl- oder Perfluoralkylgruppe mit 9 oder mehr Fluoratomen enthält:
n 1 oder 2 darstellt; und
R¹ ein Wasserstoffatom oder eine Methylgruppe darstellt; 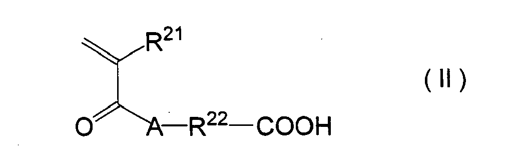 worin R²¹ ein Wasserstoffatom oder eine Methylgruppe darstellt;
R²² eine divalente Kohlenwasserstoffgruppe mit einer Kohlenstoffzahl von 3 bis 30, die eine aliphatische cyclische Struktur aufweist, darstellt;
A ein Sauerstoffatom oder -NR²³- darstellt; und
R²³ ein Wasserstoffatom oder eine monovalente Kohlenwasserstoffgruppe mit einer Kohlenstoffzahl von 1 bis 10 darstellt.

2. Fotoempfindliche Lithografie-Druckplatte gemäss Anspruch 1, worin die polymerisierbare fotoempfindliche Schicht ferner einen Sensibilisierungsfarbstoff mit einer Wellenlänge des Absorptionsmaximums im Bereich von 330 bis 430 nm umfasst.

3. Fotoempfindliche Lithografie-Druckplatte gemäss Anspruch 2, worin der Sensibilisierungsfarbstoff eine durch die Formel (4) dargestellte Verbindung ist: 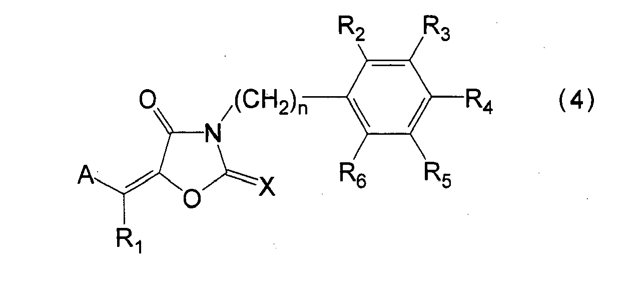 worin A einen aromatischen oder heterocyclischen Ring darstellt, der einen Substituenten aufweisen kann;
X ein Sauerstoffatom, ein Schwefelatom oder =NR₇ darstellt;
R₁, R₂, R₃, R₄, R₅, R₆ und R₇ jeweils unabhängig voneinander ein Wasserstoffatom oder eine monovalente nicht-metallische Atomgruppe darstellen, vorausgesetzt, dass zumindest eines von R², R³, R⁴, R⁵ und R⁶ einen Substituenten darstellt, der durch -OR₈ dargestellt wird, worin jedes R₈ unabhängig voneinander eine monovalente, nicht-metallische Atomgruppe darstellt; und
n eine ganze Zahl von 1 bis 6 darstellt.

4. Fotoempfindliche Lithografie-Druckplatte gemäss Anspruch 3, worin die durch die Formel (4) dargestellte Verbindung eine Verbindung ist, die durch die Formel (5) dargestellt wird: 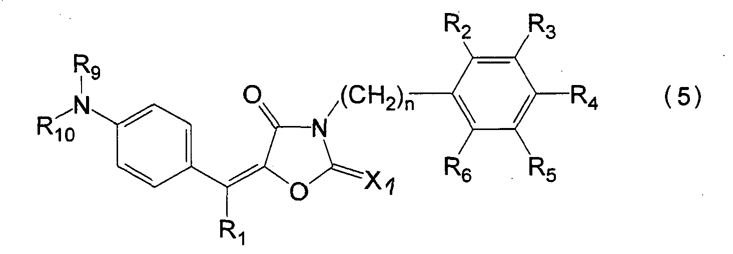 worin X₁ ein Sauerstoffatom oder ein Schwefelatom darstellt;
R₁, R₂, R₃, R₄, R₅ und R₆ jeweils unabhängig voneinander ein Wasserstoffatom oder eine monovalente nicht-metallische Atomgruppe darstellen;
R₉ und R₁₀ jeweils unabhängig voneinander eine monovalente nicht-metallische Atomgruppe darstellen, vorausgesetzt, dass zumindest eines von R₂, R₃, R₄, R₅ und R₆ einen Substituenten darstellt, der durch -OR₈ dargestellt wird, worin jedes R₈ unabhängig voneinander eine monovalente nicht-metallische Atomgruppe darstellt; und
n eine ganze Zahl von 1 bis 6 darstellt.

5. Fotoempfindliche Lithografie-Druckplatte gemäss Anspruch 1, worin die polymerisierbare fotoempfindliche Schicht ferner einen Infrarotabsorber mit einer Wellenlänge des Absorptionsmaximums im Bereich von 750 bis 1.400 nm umfasst.

6. Fotoempfindliche Lithografie-Druckplatte gemäss Anspruch 5, worin der Infrarotabsorber ein durch die Formel (i) dargestellter Cyaninfarbstoff ist: 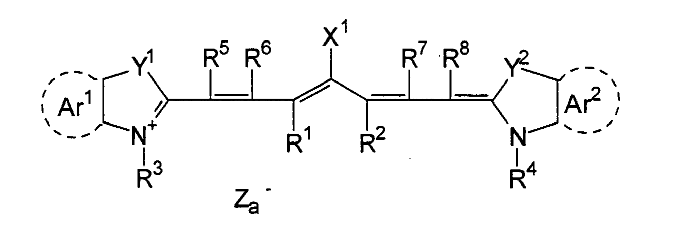 worin X¹ ein Wasserstoffatom, ein Halogenatom, -NPh₂, X²-L¹ oder eine nachstehend gezeigte Gruppe darstellt,
worin X² ein Sauerstoffatom, ein Stickstoffatom oder ein Schwefelatom darstellt, L¹ eine Kohlenwasserstoffgruppe mit 1 bis 12 Kohlenstoffatomen, einen aromatischen Ring, der ein Heteroatom aufweist, oder eine Kohlenwasserstoffgruppe, die 1 bis 12 Kohlenstoffatome aufweist und ein Heteroatom enthält, darstellt; 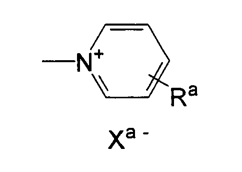
worin Xₐ⁻ die gleiche Definition wie das nachstehend beschriebene Zₐ⁻ besitzt;
R^{a} einen Substituenten darstellt, der aus einem Wasserstoffatom, einer Alkylgruppe, einer Arylgruppe, einer substituierten oder unsubstituierten Aminogruppe und einem Halogenatom ausgewählt ist;
R¹ und R² jeweils unabhängig voneinander eine Kohlenwasserstoffgruppe mit 1 bis 12 Kohlenstoffatomen darstellen;
Ar¹ und Ar² jeweils unabhängig voneinander eine aromatische Kohlenwasserstoffgruppe, die einen Substituenten aufweisen kann, darstellen;
Y¹ und Y² jeweils unabhängig voneinander ein Schwefelatom oder eine Dialkylmethylengruppe mit 12 oder weniger Kohlenstoffatomen darstellen;
R³ und R⁴ jeweils unabhängig voneinander eine Kohlenwasserstoffgruppe mit 20 oder weniger Kohlenstoffatomen, die einen Substituenten aufweisen kann, darstellen;
R⁵, R⁶, R⁷ und R⁸ jeweils unabhängig voneinander ein Wasserstoffatom oder eine Kohlenwasserstoffgruppe mit 12 oder weniger Kohlenstoffatomen darstellen; und
Zₐ⁻ ein Gegenanion darstellt, wenn jedoch ein durch die Formel (I) dargestellter Cyaninfarbstoff einen anionischen Substituenten in seiner Struktur aufweist und eine Neutralisation der elektrischen Ladung nicht notwendig ist, liegt Zₐ⁻ nicht vor.

7. Fotoempfindliche Lithografie-Druckplatte gemäss Anspruch 1, worin Rf in Formel (I) einen Substituenten, der eine Fluoralkyl- oder Perfluoralkylgruppe mit 13 bis 25 Fluoratomen enthält, darstellt.

8. Fotoempfindliche Lithografie-Druckplatte gemäss Anspruch 1, worin die polymerisierbare fotoempfindliche Schicht ferner ein Bindemittelpolymer umfasst, das eine durch irgendeine der Formeln (1) bis (3) dargestellte Vernetzungsgruppe aufweist: 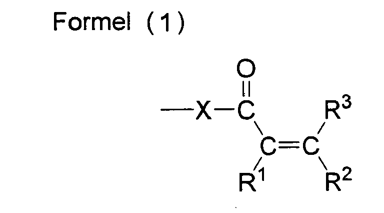 worin in Formel (1) R¹ bis R³ jeweils unabhängig voneinander ein Wasserstoffatom oder eine monovalente organische Gruppe darstellen;
X ein Sauerstoffatom, ein Schwefelatom oder -N(R¹²)- darstellt; und
R¹² ein Wasserstoffatom oder eine monovalente organische Gruppe darstellt; 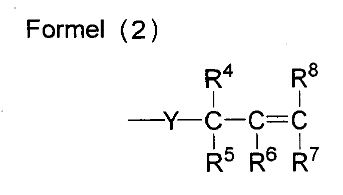
worin in Formel (2) R⁴ bis R⁸ jeweils unabhängig voneinander eine monovalente organische Gruppe darstellen;
Y ein Sauerstoffatom, ein Schwefelatom oder N(R¹²)- darstellt; und
R¹² die gleiche Bedeutung wie R¹² in Formel (1) besitzt; 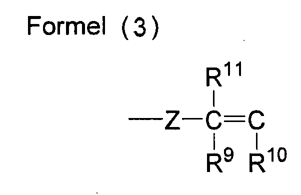
worin in Formel (3) R⁹ ein Wasserstoffatom oder eine Alkylgruppe, die einen Substituenten aufweisen kann, darstellt;
R¹⁰ und R¹¹ jeweils unabhängig voneinander ein Wasserstoffatom, ein Halogenatom, eine Aminogruppe, eine Dialkylaminogruppe, eine Carboxylgruppe, eine Alkoxycarbonylgruppe, eine Sulfogruppe, eine Nitrogruppe, eine Cyanogruppe, eine Alkylgruppe, die einen Substituenten aufweisen kann, eine Arylgruppe, die einen Substituenten aufweisen kann, eine Alkoxygruppe, die einen Substituenten aufweisen kann, eine Aryloxygruppe, die einen Substituenten aufweisen kann, eine Alkylaminogruppe, die einen Substituenten aufweisen kann, eine Arylaminogruppe, die einen Substituenten aufweisen kann, eine Alkylsulfonylgruppe, die einen Substituenten aufweisen kann, oder eine Arylsulfonylgruppe, die einen Substituenten aufweisen kann, darstellen;
Z ein Sauerstoffatom, ein Schwefelatom, -N(R¹³)- oder eine Phenylengruppe, die einen Substituenten aufweisen kann, darstellt; und
R¹³ eine Alkylgruppe, die einen Substituenten aufweisen kann, darstellt.

9. Fotoempfindliche Lithografie-Druckplatte gemäss Anspruch 1, worin Rf in Formel (I) eines der folgenden Fluoralkyl(meth)acrylate darstellt:
CH₂=CRCO₂(CH₂)ₘCₙF₂ₙ₊₁
worin m 1 oder 2 darstellt, n eine ganze Zahl von 4 bis 12 darstellt und R eine Alkylgruppe mit einer Kohlenstoffzahl von 1 bis 4 darstellt; und
CH₂=CRCO₂(CH₂)ₘ(CF₂)ₙH
worin m 1 oder 2 darstellt, n eine ganze Zahl von 4 bis 12 darstellt und R eine Alkylgruppe mit einer Kohlenstoffzahl von 1 bis 4 darstellt.

10. Fotoempfindliche Lithografie-Druckplatte gemäss Anspruch 2, worin der Polymerisationsinitiator ein Hexaarylbiimidazol ist.

11. Fotoempfindliche Lithografie-Druckplatte gemäss Anspruch 5, worin der Polymerisationsinitiator ein Oniumsalz ist.

## Revendications

1. Plaque d'impression lithographique photosensible, comprenant :
un support, et
une couche photosensible polymérisable, qui comprend :
un composé polymérisable par addition, ayant une double liaison éthyléniquement insaturée ;
un initiateur de polymérisation, et
un composé polymère ayant (a) un monomère représenté par la formule (I), et (b) un monomère représenté par la formule (II) en tant que composants de copolymérisation : 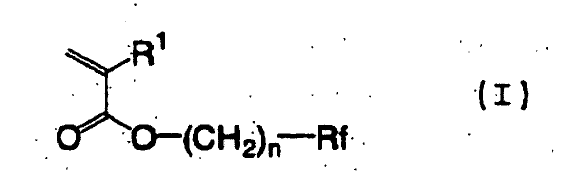 où Rf représente un substituant contenant un groupe fluoroalkyle ou perfluoroalkyle ayant 9 atomes de fluor ou plus ;
n représente 1 ou 2, et
R¹ représente un atome d'hydrogène ou un groupe méthyle ; 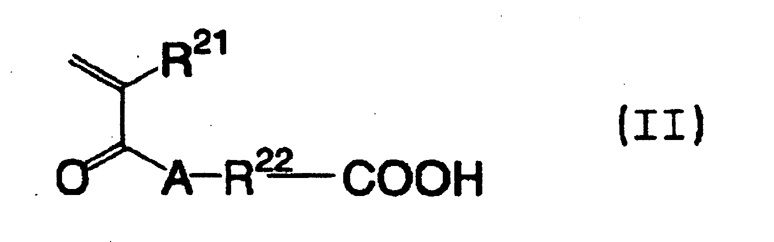
où R²¹ représente un atome d'hydrogène ou un groupe méthyle ;
R²² représente un groupe hydrocarbure bivalent ayant un nombre de carbones allant de 3 à 30 et ayant une structure aliphatique cyclique ;
A représente un atome d'oxygène ou NR²³, et
R²³ représente un atome d'hydrogène ou un groupe hydrocarbure monovalent ayant un nombre de carbones allant de 1 à 10.

2. Plaque d'impression lithographique photosensible selon la revendication 1, dans laquelle la couche photosensible polymérisable comprend en outre, un colorant de sensibilisation ayant une longueur d'onde de maximum d'absorption située dans un intervalle allant de 330 à 430 nm.

3. Plaque d'impression lithographique photosensible selon la revendication 2, dans laquelle le colorant de sensibilisation est un composé représenté par la formule (4) : 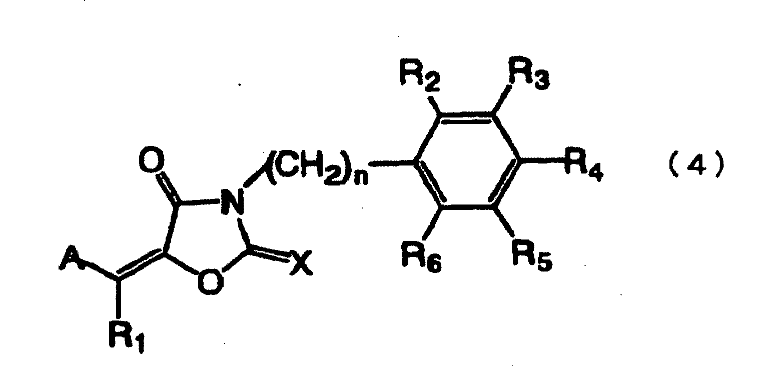 où A représente un cycle aromatique ou hétérocyclique, qui peut avoir un substituant ;
X représente un atome d'oxygène, un atome de soufre ou =NR₇ ;
R₁, R₂, R₃, R₄, R₅, R₆ et R₇ représentent chacun indépendamment, un atome d'hydrogène ou un groupe monovalent d'atomes non métalliques, pourvu qu'au moins un de R₂, R₃, R₄, R₅ et R₆ représente un substituant représenté par OR₈, où chaque R₈ représente indépendamment, un groupe monovalent d'atomes non métalliques ; et
n représente un entier allant de 1 à 6.

4. Plaque d'impression lithographique photosensible selon la revendication 3, dans laquelle le composé représenté par la formule (4) est un composé représenté par la formule (5) : 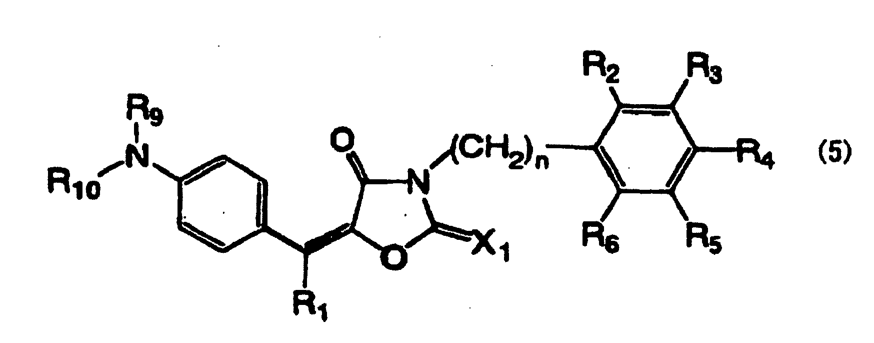 où X₁ représente un atome d'oxygène ou un atome de soufre ;
R₁, R₂, R₃, R₄, R₅ et R₆ représentent chacun indépendamment, un atome d'hydrogène ou un groupe monovalent d'atomes non métalliques,
R₉ et R₁₀ représentent chacun indépendamment, un groupe monovalent d'atomes non métalliques, pourvu qu'au moins un de R₂, R₃, R₄, R₅ et R₆ représente un substituant représenté par -OR₈, où chaque R₈ représente indépendamment, un groupe monovalent d'atomes non métalliques ; et
n représente un entier allant de 1 à 6.

5. Plaque d'impression lithographique photosensible selon la revendication 1, dans laquelle la couche photosensible polymérisable comprend en outre, un agent absorbant l'infrarouge, ayant une longueur d'onde de maximum d'absorption située dans un intervalle allant de 750 à 1400 nm.

6. Plaque d'impression lithographique photosensible selon la revendication 5, dans laquelle l'agent absorbant l'infrarouge est un colorant cyanine représenté par la formule (i) : 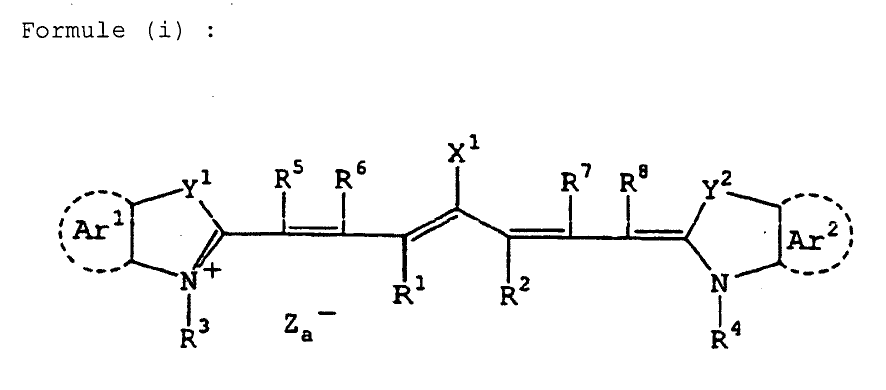 dans laquelle X¹ représente un atome d'hydrogène, un atome d'halogène, NPh₂, X²-L¹ ou un groupe représenté ci-dessous, où X² représente un atome d'oxygène, un atome d'azote ou un atome de soufre, L¹ représente un groupe hydrocarbure ayant de 1 à 12 atomes de carbone, un cycle aromatique ayant un hétéroatome, ou un groupe hydrocarbure ayant de 1 à 12 atomes de carbone et contenant un hétéroatome ; 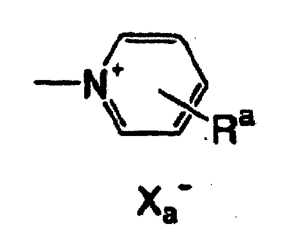
Xₐ⁻ a la même définition que Zₐ⁻ décrit ci-dessous ;
R^{a} représente un substituant, choisi parmi un atome d'hydrogène, un groupe alkyle, un groupe aryle, un groupe amino substitué ou non substitué et un atome d'halogène ;
R¹ et R² représentent chacun indépendamment, un groupe hydrocarbure ayant de 1 à 12 atomes de carbone ;
Ar¹ et Ar² représentent chacun indépendamment, un groupe hydrocarbure aromatique, qui peut avoir un substituant ;
Y¹ et Y² représentent chacun indépendamment, un atome de soufre ou un groupe dialkylméthylène ayant 12 atomes de carbone ou moins ;
R³ et R⁴ représentent chacun indépendamment, un groupe hydrocarbure ayant 20 atomes de carbone ou moins, qui peut avoir un substituant ;
R⁵, R⁶, R⁷ et R⁸ représentent chacun indépendamment, un atome d'hydrogène ou un groupe hydrocarbure ayant 12 atomes de carbone ou moins ; et
Zₐ⁻ représente un contre-ion, mais lorsqu'un colorant cyanure représenté par la formule (i) a un substituant anionique dans sa structure, une neutralisation de la charge électrique n'est pas nécessaire, Zₐ⁻ est alors absent.

7. Plaque d'impression lithographique photosensible selon la revendication 1, dans laquelle Rf de la formule (I) représente un substituant contenant un groupe fluoroalkyle ou perfluoroalkyle ayant 13 à 25 atomes de fluor.

8. Plaque d'impression lithographique photosensible selon la revendication 1, dans laquelle la couche photosensible polymérisable comprend en outre, un polymère liant, ayant un groupe de réticulation, représenté par une des formules (1) à (3) : 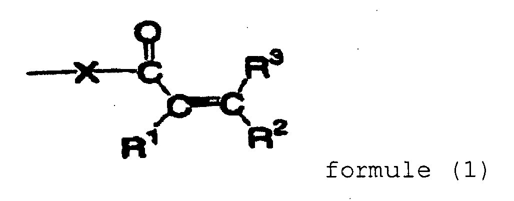 où dans la formule (1), R¹ à R³ représentent chacun indépendamment, un atome d'hydrogène ou un groupe organique monovalent ;
X représente un atome d'oxygène, un atome de soufre ou N(R¹²), et
R¹² représente un atome d'hydrogène ou un groupe organique monovalent ; 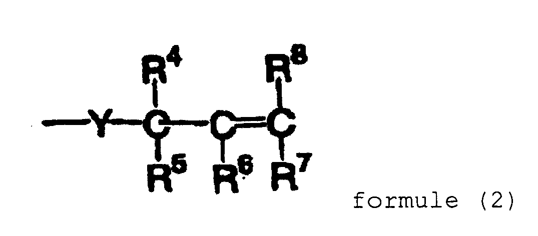
où dans la formule (2), R⁴ à R⁸ représentent chacun indépendamment, un groupe organique monovalent ;
Y représente un atome d'oxygène, un atome de soufre ou N (R¹²), et
R¹² a la même signification que R¹² dans la formule (1) ; 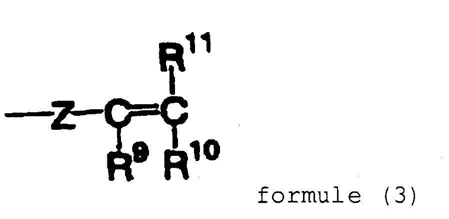 où dans la formule (3), R⁹ représente un atome d'hydrogène ou un groupe alkyle, qui peut avoir un substituant ;
R¹⁰ et R¹¹ représentent chacun indépendamment, un atome d'hydrogène, un atome d'halogène, un groupe amino, un groupe dialkylamino, un groupe carboxyle, un groupe alcoxycarbonyle, un groupe sulfo, un groupe nitro, un groupe cyano, un groupe alkyle qui peut avoir un substituant, un groupe aryle qui peut avoir un substituant, un groupe alcoxy qui peut avoir un substituant, un groupe aryloxy qui peut avoir un substituant, un groupe alkylamino qui peut avoir un substituant, un groupe arylamino qui peut avoir un substituant, un groupe alkylsulfonyle qui peut avoir un substituant, ou un groupe arylsulfonyle qui peut avoir un substituant ;
Z représente un atome d'oxygène, un atome de soufre, NR¹³ ou un groupe phénylène qui peut avoir un substituant ; et
R¹³ représente un groupe alkyle qui peut avoir un substituant.

9. Plaque d'impression lithographique photosensible selon la revendication 1, dans laquelle Rf de la formule (I) représente un des (méth)acrylates de fluoroalkyle suivants :
CH₂=CRCO₂(CH₂)ₘCₙF₂ₙ₊₁
dans laquelle m représente 1 ou 2, n représente un entier allant de 4 à 12, et R représente un groupe alkyle ayant un nombre de carbones allant de 1 à 4, et
CH₂=CRCO₂(CH₂)ₘ(CF₂)ₙH
dans laquelle m représente 1 ou 2, n représente un entier allant de 4 à 12, et R représente un groupe alkyle ayant un nombre de carbones allant de 1 à 4.

10. Plaque d'impression lithographique photosensible selon la revendication 2, dans laquelle l'initiateur de polymérisation est l'hexaarylbisimidazole.

11. Plaque d'impression lithographique photosensible selon la revendication 5, dans laquelle l'initiateur de polymérisation est un sel d'onium.
